(19) Europäisches Patentamt
European Patent Office
Office européen des brevets

(11) EP 4 163 325 A1

(12) EUROPEAN PATENT APPLICATION

(43) Date of publication:
**12.04.2023 Bulletin 2023/15**

(21) Application number: **21201355.1**

(22) Date of filing: **07.10.2021**

(51) International Patent Classification (IPC):
***C08J 7/04*** *(2006.01)* ***B29C 48/00*** *(2019.01)*
***C08J 7/048*** *(2020.01)* ***C08J 11/06*** *(2006.01)*
***C08L 23/06*** *(2006.01)* ***D06P 1/90*** *(2006.01)*
***C23C 14/00*** *(2006.01)* ***C23C 16/22*** *(2006.01)*

(52) Cooperative Patent Classification (CPC):
**C08J 7/0423; B29B 13/00; C08J 7/048; C23C 16/401; C23C 16/45542; C23C 16/45555; C23C 16/511; D06P 1/90;** B29B 2013/002; C08J 2323/06; C08J 2323/12; C08J 2423/08; C08J 2433/08; C08J 2433/10; C08J 2453/00;

(Cont.)

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Smart Coloring GmbH**
**52074 Aachen (DE)**

(72) Inventor: **ROBERTZ, Bernd**
**52074 Aachen (DE)**

(74) Representative: **Michalski Hüttermann & Partner Patentanwälte mbB**
**Kaistraße 16A**
**40221 Düsseldorf (DE)**

# (54) METHOD FOR DECOLORING A COLORED PLASTIC ARTICLE HAVING AN OUTERMOST LAYER

(57) It is an object of the invention to provide a method for decoloring a colored plastic article, wherein the plastic article comprises at least two layers, wherein a first layer of the at least two layers is an outermost layer and forms a surface of the plastic article; wherein a second layer of the at least two layers is a color layer and comprises a plastic material and a coloring agent; wherein the plastic material comprises at least 0,1 wt.-% of a polar component, based on the weight of the plastic material, wherein the polar component is a polar polymer, a polar compound and/or a blend of polar polymers and/or polar compounds, wherein the polar polymer has a molecular weight Mw ≥ 1000 g/mol and has at least 5 wt.-% of heteroatoms based on the molecular weight of the polar polymer, wherein the polar compound has a molecular weight Mw < 1000 g/mol and has at least 5 wt.-% of heteroatoms based on the molecular weight of the polar compound, and wherein heteroatoms are any atoms except C and H atoms; wherein the coloring agent comprises an organic molecule with a molecular weight Mw ≤ 800 g/mol; wherein the outermost layer comprises a crosslinked silicon compound, wherein the crosslinked silicon compound comprises at least two silicon atoms bridged by an oxygen atom; the method comprising the steps of

a) shredding the colored plastic article to a granulate and/or a powder,

b) exposing the granulate and/or powder to a decoloring bath for about ≥ 1 minute to about ≤ 240 minutes, wherein the decoloring bath has a temperature above a glass transition temperature $T_g$ of the colored plastic article and below a melting temperature $T_m$ and/or decomposition temperature of the colored plastic article and/or has a temperature ≥ 60 °C to ≤ 130°C,

wherein the decoloring bath comprises

- water,
- at least one polar solvent and/or at least one non-polar solvent, and
- an oxidizing agent or a reducing agent and/or a polar decoloring agent,

wherein the decoloring bath has a pH about ≥ 8, and wherein the pH of the decoloring bath is adjusted by adding a base, preferably NaOH or

wherein the decoloring bath has a pH about ≤ 6, and wherein the pH of the decoloring bath is adjusted by adding an acid, preferably HCl.

EP 4 163 325 A1

(52) Cooperative Patent Classification (CPC): (Cont.)
C08J 2467/04

## Description

The present invention relates to a method for decoloring a colored plastic article having an outermost layer.

## BACKGROUND OF THE INVENTION

Plastic articles, such as packaging and containers, are widely used in daily life, since they are easy to manufacture, rather inexpensive and lightweight. It is often desired that the plastic article has a specific color.

The coloring of plastics can be achieved by using color master batches, colored micro granules, so-called dry liquid colors or liquid colors. Colored plastic components can for example be produced from color master batch blended into a polymer prior to molding or extruding. The selection of the specific coloring method may vary based on economics, secondary operations and specific requirements of the end application.

The coloring of plastics and in particular of plastic articles can also be achieved by coloring the uncolored but already formed plastic article in a coloring bath. In this case the coloring of the plastic article may not be homogeneously distributed in the whole volume of the plastic but may be confined to surfaces and/or outer layers of the plastic article that have come into contact with the coloring bath.

Independent of the coloring process, the selection of the coloring agent, i.e. pigments and/or dyes, depends not only on the desired color, but also on the plastic, on application, and the associated requirements, such as the use of the plastic article. In sensitive areas, such as food packaging or packaging for medicinal applications, contamination of the filling goods by a substance in the packaging must be avoided at all efforts. Furthermore, also a contamination of a user of the plastic package by a colored outer surface of the plastic package must be avoided. Hence, it is important that the dyes and/or pigments used, are immobilized and do not migrate from the plastic into the filling good or in an outer environment of the plastic article under the conditions in which the plastic article is used. For dyes, which are organic molecules and which are predominantly present in the colored plastic in a molecularly solved state, the prevention of migration is generally achieved by using dyes with a high molecular weight.

Even though dyes with a high molecular weight help producing highly color stable plastic articles, they are a disadvantage in the recycling process of the plastic article, as they cannot be removed from the plastic during mechanical recycling. The plastic articles may only be recycled at great expense by separating the articles in an additional sorting process according to their color, after having separated the articles according to the kind of plastic/polymer, in order to achieve high quality colored recycled material. When colorful plastics are mixed during regranulation, recyclates with undesirable color tones (brown, grey, black) result, so that these recyclates can only be used to a very limited extent. Alternatively, in the recycling process the dyes within the plastic may be chemically modified for example by strong oxidation or reduction processes such that the dyes lose their chromophoric property. However, the destroyed dye compounds remain in the plastic and thus limit the use of the recylate. Furthermore, the oxidation or reduction agents are very aggressive and need to be used in high amounts, which is not environmentally friendly. Although it is possible to dissolve the plastics and dyes in chemical recycling by dissolving the colored plastic in suitable solvents, the effort involved is considerable and the use of organic solvents contradicts the idea of sustainability.

Accordingly, there is a need to provide methods for decoloring plastic articles having a high color stability.

## SUMMARY OF THE INVENTION

It is an object of the invention to provide a method for decoloring a colored plastic article, wherein the plastic article comprises at least two layers,

wherein a first layer of the at least two layers is an outermost layer and forms a surface of the plastic article;
wherein a second layer of the at least two layers is a color layer and comprises a plastic material and a coloring agent;
wherein the plastic material comprises at least 0,1 wt.-% of a polar component, based on the weight of the plastic material,
wherein the polar component is a polar polymer, a polar compound and/or a blend of polar polymers and/or polar compounds,
wherein the polar polymer has a molecular weight Mw $\geq$ 1000 g/mol and has at least 5 wt.-% of heteroatoms based on the molecular weight of the polar polymer,
wherein the polar compound has a molecular weight Mw < 1000 g/mol and has at least 5 wt.-% of heteroatoms based on the molecular weight of the polar compound,
and wherein heteroatoms are any atoms except C and H atoms;
wherein the coloring agent comprises an organic molecule with a molecular weight Mw $\leq$ 800 g/mol;
wherein the outermost layer comprises a crosslinked silicon compound, wherein the crosslinked silicon compound comprises at least two silicon atoms bridged by an oxygen atom; the method comprising the steps of

a) shredding the colored plastic article to a granulate and/or a powder,

b) exposing the granulate and/or powder to a decoloring bath for about ≥ 1 minute to about ≤ 240 minutes, wherein the decoloring bath has a temperature above a glass transition temperature $T_g$ of the colored plastic article and below a melting temperature $T_m$ and/or decomposition temperature of the colored plastic article and/or has a temperature ≥ 60 °C to ≤ 130°C,

wherein the decoloring bath comprises

- water,
- at least one polar solvent and/or at least one non-polar solvent, and
- an oxidizing agent or a reducing agent and/or a polar decoloring agent,

wherein the decoloring bath has a pH about ≥ 8, and wherein the pH of the decoloring bath is adjusted by adding a base, preferably NaOH or
wherein the decoloring bath has a pH about ≤ 6, and wherein the pH of the decoloring bath is adjusted by adding an acid, preferably HCl.

It was found that when using a combination of coloring agents comprising an organic molecule with a low molecular weight in a plastic article having an outermost layer comprising a crosslinked silicon compound, the highly color stable plastic article can be decolored in one step by a decoloring bath. The outermost layer gives the plastic article a high color stability, however does not impair the decoloring process of the plastic article. In other words, the outermost layer forms an efficient migration barrier for the organic molecule of the coloring agent and enhances the color stability of the colored plastic article.

In packaging, inorganic outermost layers sometimes serve as gas barriers, for example to preserve the freshness and/or taste of the packaged food. However, in the present case, the outermost layer provides a contamination barrier and effectively prevents the migration of the coloring agent, which can be removed from the plastic for the purpose of decolorization, into the product.

In the decoloring process the outermost layer disintegrates, detaches and/or dissolves in the decoloring bath so that the coloring agent can migrate out of the plastic article. No extra or additional step is required to remove the outermost layer. In other words, the decoloring time is not prolongated even though the color stability of the colored plastic article is enhanced.

Preferably, the method for decoloring the colored plastic article allows to recover at least 85 % of the plastic material of the plastic article and allows to reuse the plastic material for producing further plastic articles. Furthermore, the recycling does not rely on dissolving the plastic material in an organic solvent. In other words, preferably the granulate and/or powder, and more preferably the plastic material of the granulate and/or powder is solid while being exposed to the decoloring bath. The decoloring process is preferably based on a disintegration and/or dissolution process of the outermost layer and a migration process of the coloring agent out of the plastic material into the decoloring bath.

The plastic article comprises at least the two layers, i.e. the color layer and the outermost layer. In one preferred embodiment of the invention the color layer and the outermost layer are directly in contact with each other and/or the color layer directly contacts the outermost layer. In other words, in this embodiment, there is not additional layer in between the color layer and the outermost layer.

It may be possible that the plastic article has only two layers, i.e. the color layer and the outermost layer. Alternative the plastic article may have more than two layers. The additional layers may be in between the color layer and the outermost layer. Alternatively, the additional layers may be in contact to the color layer on an opposite side of the color layer to the outermost layer. In other words, the color layer may be in between the outermost layer and the additional layers. In case the plastic article comprises additional layers, the additional layers and/or the color layer are not arranged such that that the outermost layer is within the plastic article. In other words, the outermost layer is not sandwiched in between two additional layers or in between the color layer and an additional layer. Instead, the outermost layer forms the surface of the colored plastic article. Furthermore, the additional layer is preferably free of a coloring agent.

## Outermost layer

The outermost layer of the plastic article comprises the crosslinked silicon compound. The crosslinked silicon compound comprises at least two silicon atoms bridged by an oxygen atom, in other words the structure Si-O-Si. Furthermore, the crosslinked silicon compound may also comprise in addition to the Si-O-Si structure at least two silicon atoms bridged by a nitrogen atom, in other words the structure Si-N-Si. In the case of the Si-N-Si structure, the remaining valence on the nitrogen atom in the Si-N-Si structure may form a bond to another atom, e.g. a silicon atom, a hydrogen atom, an oxygen atom, a nitrogen atom, or a carbon atom. The crosslinked silicon compound is crosslinked and/or

polymerized, meaning that the atoms of the crosslinked silicon compound form a chain, a two-dimensional network and/or a three-dimensional network. The chain, the two-dimensional network and/or a three-dimensional network preferably extend throughout the entire outermost layer of the plastic article.

Preferably the outermost layer may be described by the chemical formula $SiO_x$ $SiO_xN_y$, $SiO_xC_y$, $SiO_xN_yC_z$, $SiO_xC_yH_z$, and/or $SiO_xN_yC_zH_w$, with w, x, y, and z giving the stoichiometry between the elements. In other words, the outermost layer may consist of the elements Si, O, C, H and/or N in various ratios.

According to a preferred embodiment of the invention the outermost layer is an inorganic layer, is carbon free, does not comprise carbon-hydrogen bonds, and/or the crosslinked silicon compound is not an organic compound. In the context of this invention an inorganic layer is a layer having no silicon-carbon bonds (Si-C) and/or no carbon-hydrogen bonds (C-H). In other words, there may in addition to the Si-O-Si structure in the outermost layer be an Si-N-Si structures and/or a Si-H structure. In the context of this invention being carbon free means that the amount of carbon in the outermost layer is below the detection limit of X-ray Photoelectron Spectroscopy (XPS), Fourier-transform infrared spectroscopy (FTIR), and/or Fourier transform infrared reflection-absorption spectroscopy (FT-IRRAS). An organic compound is a chemical compound that comprise carbon-hydrogen bonds. The outermost layer being an inorganic layer, being carbon free, not comprising carbon-hydrogen bonds, and/or the crosslinked silicon compound not being an organic compound has the advantage that the color stability of the plastic article is very high.

Preferably the outermost layer only consists of silicon and oxygen. Further preferably the outermost layer and/or the crosslinked silicon compound is described by the chemical formula $SiO_X$. More preferably the outermost layer and/or the crosslinked silicon compound is described by the chemical formula $SiO_x$, with x being higher than 1 more preferably with x being higher than 1,2, even more preferably with x being higher than 2. In other words, the oxygen fraction is preferably higher than 50 at.% more preferably higher than 55 at.%, even more preferably higher than 66 at.%. Furthermore, the outermost layer is preferably described by the chemical formula $SiO_x$, with x being below 4, more preferably with x being below 3,4, even more preferably with x being below 3. In other words, the oxygen fraction is preferably lower than 80 at.% more preferably lower than 77 at.%, even more preferably lower than 75 at.%. In other words, the outermost layer is preferably an inorganic layer comprising the Si-O-Si structure and preferably further Si-Si bonds and/or Si-O bonds. Preferably the outermost layer is a silicon oxide layer. The ratio of silicon to oxide can for example be determined based on relative peak areas of the XPS-spectra, taking corresponding sensitivity factors of the spectrometer for the different elements into account.

Alternatively, the outermost layer only consists of silicon, oxygen, and nitrogen. Further preferably the outermost layer and/or the crosslinked silicon compound is described by the chemical formula $SiO_xN_y$. More preferably the outermost layer and/or the crosslinked silicon compound is described by the chemical formula $SiO_xN_y$, with x being higher than 0,5, more preferably with x being higher than 1,5, even more preferably with x being higher than 2,2 and/or with y being higher than 0,1, more preferably with y being higher than 0,75, even more preferably with y being higher than 1,4. In other words, the oxygen fraction is preferably higher than 17 at.% and the nitrogen fraction is preferably higher than 42 at.% more preferably the oxygen fraction is higher than 67 at.% and the nitrogen fraction is higher than 3 at.% and even more preferably the oxygen fraction is higher than 25 at.% and the nitrogen fraction is higher than 48 at.%. Furthermore, the outermost layer is preferably described by the chemical formula $SiO_xN_y$, with x being below 3,9, more preferably with x being below 3,3, even more preferably with x being below 3,0 and/or with y being below 3,9, more preferably with y being below 3,3, even more preferably with y being below 3,0. In other words, the oxygen fraction is preferably lower than 78 at.% and the nitrogen fraction is preferably lower than 78 at.%, more preferably the oxygen fraction is lower than 75 at.% and the nitrogen fraction is lower than 75 at.%, and even more preferably the oxygen fraction is lower than 72 at.% and the nitrogen fraction is lower than 72 at.%.

Preferred compositions of the outermost layer and/or the crosslinked silicon compound having the chemical formula $SiO_xN_y$ are given in table 1:

Table 1

| x | y | at. % O | at. % N |
|---|---|---|---|
| 0,5 | 0,1 | 31% | 6% |
| 0,5 | 0,75 | 22% | 33% |
| 0,5 | 1,4 | 17% | 48% |
| 1,5 | 0,1 | 58% | 4% |
| 1,5 | 0,75 | 46% | 23% |
| 1,5 | 1,4 | 38% | 36% |
| 2,2 | 0,1 | 67% | 3% |

(continued)

| Table 1 | | | |
|---|---|---|---|
| 2,2 | 0,75 | 56% | 19% |
| 2,2 | 1,4 | 48% | 30% |

In other words, the outermost layer is preferably an inorganic layer comprising the Si-O-Si structure, and preferably further Si-N-Si structures, Si-Si bonds Si-O bonds and/or Si-N bonds.

According to another preferred embodiment of the invention the outermost layer and/or the crosslinked silicon compound comprises carbon-hydrogen bonds and/or Si-C bonds. In this context preferably a C-fraction of the outermost layer and/or the crosslinked silicon compound is below 10 at.%, more preferably below 5 at.%, even more preferably below 0,5 at.%. Further preferably the outermost layer and/or the crosslinked silicon compound is described by the chemical formula $SiO_xC_y$ and the C fraction of the outermost layer and/or the crosslinked silicon compound is below 10 at.%, more preferably below 5 at.%, even more preferably below 0,5 at.%.

In other words, in this preferred embodiment the outermost layer is not an inorganic layer. Furthermore, in this preferred embodiment the crosslinked silicon compound is an organosilicon compound comprising C-Si bonds. The crosslinked silicon compound may be described by the chemical formula $SiO_xC_y$, $SiO_xC_yH_z$, $SiO_xN_yC_z$, and/or $SiO_xN_yC_zH_w$ with w, x, y, and z giving the stoichiometry between the elements. Preferably the crosslinked silicon compound is described by the chemical formula $SiO_xC_y$. However, the amount of carbon in the outermost layer is preferably low. By measuring high resolution spectra for Si 2p, C Is and O 1s the elemental composition and chemical states of the outermost layer can be determined.

According to another preferred embodiment of the invention the outermost layer has a thickness between 0,001 μm to 1,0 μm preferably between 0,01 μm to 0,8 μm and even more preferably 0,03 μm to 0,5 μm. Excessive layer thicknesses of the outermost layer is preferably avoided, as the outermost layer may become with increasing thickness brittle and, in the event of deformation, e.g. of a squeezable container, cracks can occur in the outermost layer during application, which may have a negative effect on the barrier effect of the outermost layer.

**Producing the outermost layer of the colored plastic article**

According to a preferred embodiment of the invention the colored plastic article is provided by a method comprising the steps of

- providing an uncoated colored plastic article, wherein the uncoated colored plastic article comprises at least one color layer, wherein the color layer comprises a plastic material and a coloring agent; wherein the plastic material comprises at least 0,1 wt.-% of a polar component, based on the weight of the plastic material,

  wherein the polar component is a polar polymer, a polar compound and/or a blend of polar polymers and/or polar compounds,
  wherein the polar polymer has a molecular weight Mw ≥ 1000 g/mol and has at least 5 wt.-% of heteroatoms based on the molecular weight of the polar polymer,
  wherein the polar compound has a molecular weight Mw < 1000 g/mol and has at least 5 wt.-% of heteroatoms based on the molecular weight of the polar compound,
  and wherein heteroatoms are any atoms except C and H atoms;
  wherein the coloring agent comprises an organic molecule with a molecular weight Mw ≤ 800 g/mol;

- depositing the outermost layer on a surface of the color layer.

Preferably the coating of the surface of the color layer with the outermost layer generates the migration barrier for the coloring agent, without changing the physical and especially the thermal properties of the plastic material.

Further preferably, the deposition of the outermost layer on the surface of the color layer comprises depositing a middle layer on the surface of the color layer and subsequently depositing the outermost layer on the middle layer. Further preferably, depositing the middle layer and/or the outermost layer is a vapor deposition process, more preferably a chemical vapor deposition process and/or a plasma processing step. Further preferably depositing the outermost layer is a plasma enhanced atomic layer deposition process and/or a plasma processing step.

According to a further preferred embodiment of the invention and with regard to the plasma processing step, the middle layer and/or the outermost layer are deposited using a microwave driven low pressure plasma.

In other words, and according to a preferred embodiment of the invention, the outermost layer is obtained by

a) depositing the outermost layer by a plasma enhanced chemical vapor deposition process using an outermost layer precursor as silicon source on the color layer; or
b) depositing a middle layer by a plasma enhanced chemical vapor deposition process using a middle layer precursor as silicon and carbon source on the color layer and subsequently depositing the outermost layer by a plasma enhanced chemical vapor deposition process and/or plasma enhanced atomic layer deposition using an outermost layer precursor as silicon source on the middle layer; or
c) depositing the outermost layer by a plasma enhanced atomic layer deposition process using a middle layer precursor as silicon and carbon source and/or an outermost layer precursor as silicon source.

Furthermore, and according to a preferred embodiment of the invention, the outermost layer is obtained by the plasma enhanced chemical vapor deposition process and comprises the step of pretreating the surface of the color layer with a pretreatment plasma process, preferably with an argon or oxygen discharge prior to depositing the outermost layer and/or the middle layer. In other words, the outermost layer is preferably obtained by a pretreatment plasma process step of the surface of the color layer by an argon or oxygen discharge prior to steps a) or b).

The pretreatment step is preferably a surface pre-treatment for cleaning and activating the surface of the color layer. It is believed that free dangling bonds are generated that allow the building of covalent bonds to the outermost layer and/or to the middle layer, which enhances the adherence of the outermost layer and/or of the middle layer. The surface activation preferably takes place in the first second of the plasma treatment. With increasing pre-treatment time an etching of the surface of the color layer may reduce the barrier properties of the subsequently deposited middle layer and/or outermost layer. Thus, the pre-treatment time is preferably shorter than 10 s, more preferably shorter than 5 s, and even more preferably shorter than 1 s.

In some cases, the step of pretreating the surface of the color layer with the pretreatment plasma process, may be omitted. Preferably for a color layer, wherein the plastic material of the color layer comprises polypropylene, the step of pretreating the surface of the color layer with the pretreatment plasma process is omitted.

As already mentioned, the outermost layer is preferably an inorganic layer and/or is free of carbon. However, the deposition of an inorganic outermost layers on the color layer may be hampered by the intrinsic material properties of the inorganic outermost layer and the plastic material of the color layer, since the plastic material and the crosslinked silicon compound of the outermost layer usually exhibit low surface energies. Therefore, low wettability and adhesion of the deposited inorganic outermost layer may be an issue. The adhesion of the outermost layer, and particularly of the inorganic outermost layer is preferably enhanced by the middle layer. Therefore, the middle layer is also called adhesion-promoting layer.

Preferably the middle layer is not an inorganic layer. Preferably the middle layer is an organosilicon layer, more preferably a polysiloxane-like layer. Preferably the middle layer can be described by the chemical formula $SiO_xC_y$, $SiO_xC_yH_z$, $SiO_xN_yC_z$, and/or $SiO_xN_yC_zH_w$, with w, x, y, and z giving the stoichiometry between the elements. In other words, the middle layer may consist of the elements Si, O, C, H and/or N in various ratios. Further preferably the middle layer comprises a further crosslinked silicon compound. The further crosslinked silicon compound is preferably an organosilicon compound comprising C-Si bonds. Preferably the further crosslinked silicon compound comprises the Si-O-Si structure and C-Si bonds. Further preferably the further crosslinked silicon compound may comprise the Si-N-Si structure and C-H bonds of hydrocarbons.

According to a preferred embodiment of the invention the middle layer and/or the further crosslinked silicon compound can be described by the chemical formula $SiO_xC_y$. Further preferably, a C-fraction of the middle layer and/or the further crosslinked silicon compound is in between 43 at.% to 0,05 at.%, preferably in between 20 at.% to 1 at.%, more preferably in between 5 at.% to 1.5 at.%. Further preferably, the O-fraction in the middle layer and/or further crosslinked silicon compound is in between 71 at.% to 29 at.%, preferably in between 70 at.% to 50 at.%, more preferably in between 69 at.% to 65 at.%. The oxygen to carbon ratio is an indicator for an amount of cross-linking of the deposited middle layer.

Further preferably the middle layer and/or the further crosslinked silicon compound is described by the chemical formula $SiO_xC_y$ and the C-fraction is in between 43 at.% to 0,05 at.%, preferably in between 20 at.% to 1 at.%, more preferably in between 5 at. % to 1.5 at.%; and the O-fraction is in between 71 at.% to 29 at.%, preferably in between 70 at.% to 50 at.%, more preferably in between 69 at.% to 65 at.%.

By measuring high resolution spectra for Si 2p, C Is and O 1s the elemental composition and chemical states of the middle layer can be determined. The ratio of silicon to carbon can for example be determined based on relative peak areas of the XPS-spectra, taking corresponding sensitivity factors of the spectrometer for the different elements into account.

Preferably the middle layer constitutes the interface in which covalent bonds are built between the polymer surface of the color layer and the $SiO_xC_y$, $SiO_xC_yH_z$, $SiO_xN_yC_z$, and/or $SiO_xN_yC_zH_w$ of the middle layer. However, after

depositing the outermost layer on the middle layer, the middle layer, which is preferably an organosilicon layer, preferably converts to an inorganic layer. Or in other words, the step of subsequently depositing the outermost layer on the middle layer comprises the step of converting the organosilicon middle layer into an inorganic layer. Thus, after having deposited the outermost layer on the middle layer, the converted middle layer preferably cannot be distinguished from the inorganic outermost layer - or in other words in the colored plastic article preferably no organosilicon middle layer is found in between the color layer and the outermost layer. It is believed, that during the deposition of the outermost layer on the middle layer, the middle layer is oxidized. In the process of obtaining the outermost layer, the middle layer has the advantage that the adhesion properties are enhanced. Therefore, the middle layer is also called adhesion-promoting layer.

In this context and according to another preferred embodiment of the invention the middle layer is obtained by depositing the middle layer by a plasma enhanced chemical vapor deposition process using a middle layer precursor as silicon and carbon source. Preferably the middle layer is deposited on the color layer. Thus, the middle layer has direct contact to the color layer. Furthermore, it is possible that the middle layer precursor is only one compound acting simultaneously as silicon and carbon source. Furthermore, the middle layer precursor may be a mixture of compounds, wherein the single compounds in the mixture may not all comprise silicon and carbon, however the mixtures itself acts as silicon and carbon source, when used in the deposition process.

Preferably, the middle layer precursor is the source for the silicon and carbon atoms of the further crosslinked silicon compound of the middle layer. In this regard and according to a further preferred embodiment of the invention the middle layer precursor is selected from the group comprising hexamethyldisiloxane (HMDSO), hexamethyldisilazane (HMDSN), silicon tetrahydride, trimethylsilane, tetramethylsilane, di(sec-butylamino)silane (DSBAS), bis(dimethylamino-methylsilyl)-trimethylsilylamine (DTDN2-H2), 1,3-di-isopropylamino-2,4-dimethyl-cyclosilazane (CSN-2), bis(t-butylamino)silane (BTBAS), di-s-butylaminosilane (DSBAS), 1,3-di-isopropylamino-2,4-dimethyl-cyclosilazane (CS-2), tetraethyl orthosilicate, and mixtures thereof.

Furthermore, the middle layer precursors may also be a mixture comprising a carbon source and a silicon source, wherein the carbon source can be selected from the group comprising hydrocarbons, in particular unsaturated hydrocarbons such as ethine, and wherein the silicon source can be selected from the group comprising silicon tetrahydride, dichlorosilane, pentachlorodisilane, hexachlorodisilane (HCDS), trisilylamine, hexamethyldisiloxane (HMDSO), hexamethyldisilazane (HMDSN), tertrahydrosilane, trimethylsilane, tetramethylsilane, di(sec-butylamino)silane (DSBAS), bis(dimethylamino-methylsilyl)-trimethylsilylamine (DTDN2-H2), 1,3-di-isopropylamino-2,4-dimethyl-cyclosilazane (CSN-2), bis(t-butylamino) silane (BTBAS), di-s-butylaminosilane (DSBAS), 1,3-di-isopropylamino-2,4-dimethyl-cyclosilazane (CS-2), tetraethyl orthosilicate, silicon-hydrogen compounds, and mixtures thereof.

Hexamethyldisiloxane, and tetraethyl orthosilicate may not only be a silicon and carbon source, but also an oxygen source. Hexamethyldisilazane may not only be a silicon and carbon source, but also a nitrogen source.

According to another preferred embodiment of the invention, the outermost layer is obtained by the plasma enhanced chemical vapor deposition process and the middle layer precursor is deposited in the absence of oxygen. Preferably the middle layer precursor is deposited on the color layer in the absence of oxygen, more preferably by the plasma enhanced chemical vapor deposition process. This ensures that the middle layer is an organosilicon layer.

With regard to the outermost layer and according to a preferred embodiment of the invention, the outermost layer is obtained by depositing the outermost layer by a plasma enhanced chemical vapor deposition process using an outermost layer precursor as silicon source. The outermost layer may be deposited on the color layer. Preferably the outermost layer is deposited on the middle layer. More preferably the outermost layer is deposited on the middle layer by the plasma enhanced chemical vapor deposition process using an outermost layer precursor as silicon source. Furthermore, it is possible that the outermost layer precursor is only one compound or it may be a mixture of compounds.

According to another preferred embodiment of the invention, the outermost layer precursor is selected from the group comprising silicon tetrahydride, dichlorosilane, pentachlorodisilane, hexachlorodisilane (HCDS), trisilylamine, hexamethyldisiloxane (HMDSO), hexamethyldisilazane (HMDSN), tertrahydrosilane, trimethylsilane, tetramethylsilane, di(sec-butylamino)silane (DSBAS), bis(dimethylamino-methylsilyl)-trimethylsilylamine (DTDN2-H2), 1,3-di-isopropylamino-2,4-dimethyl-cyclosilazane (CSN-2), bis(t-butylamino) silane (BTBAS), di-s-butylaminosilane (DSBAS), 1,3-di-isopropylamino-2,4-dimethyl-cyclosilazane (CS-2), tetraethyl orthosilicate, silicon-hydrogen compounds, and mixtures thereof.

Hexamethyldisiloxane, and tetraethyl orthosilicate may not only be a silicon source, but also an oxygen source. Hexamethyldisilazane may not only be a silicon source, but also a nitrogen source.

As already mentioned, the outermost layer is preferably an inorganic layer. To this regard and according to a preferred embodiment of the invention, the outermost layer is obtained by the plasma enhanced chemical vapor deposition process and the outermost layer precursor is deposited in the presence of oxygen. This eases the production of an inorganic outermost layer. During the deposition process of the outermost layer precursor, the chemical composition of the outermost layer can be influenced by a gas composition during deposition. Preferably with increasing ratio of oxygen to the outermost layer precursor in the gas composition, a decreasing amount of carbon is incorporated in the outermost layer.

According to another preferred embodiment of the invention, a flux-ratio of oxygen to the outermost layer precursor during deposition is preferably higher than 10, more preferably higher than 50, and even more preferably higher than 200. Further preferably a flux-ratio of oxygen to the outermost layer precursor during deposition is lower than 1000, more preferably lower than 500, even more preferably lower than 250. In other words, during the deposition process of the outermost layer, the flux-ratio between oxygen present during deposition and the outermost layer precursor is preferably in between 10 and 1000, more preferably in between 50 and 500, and even more preferably in between 200 and 250. This ratio has been shown to provide a plastic article with a high color stability that can easily be decolored in the decoloring bath.

The flux of oxygen and the outermost layer precursor during deposition is described in the unit sccm. sccm stands for standard cubic centimeter per minute and describes a defined flowing quantity of gas (number of particles or gas mass) per unit of time, i.e. a particle flow or mass flow, independent of pressure and temperature.

Plasma enhanced chemical vapor deposition (PE-CVD) is a technique to deposit functional coatings on a variety of different substrates. In chemical vapor deposition (CVD), gas-phase and surface reactions are caused by thermal activation resulting in a coating. On the contrary, gas-phase and surface reactions in PE-CVD processes are triggered by electron impact causing, for example excitation, dissociation or ionization processes. This allows the deposition on substrates for which a coating by CVD is usually not attainable. In particular, thermosensitive substrates such as plastics can be coated by PE-CVD processes.

With regard for the PE-CVD process and according to another preferred embodiment of the invention, the middle layer and/or the outermost layer are obtained by a plasma enhanced chemical vapor deposition process, wherein a microwave continuous wave power is ≤ 2 kW, a microwave puls power is ≤ 4 kW, a microwave pulse duration is ≤ 24 ms, and/or a microwave pulse pause is ≤ 250 ms. Furthermore, with regard to a radiofrequency discharge a radiofrequency bias is preferably ≤ 1kW, a radiofrequency pulse duration is preferably ≤ 250 ms, a radiofrequency pulse pause is preferably ≤ 250 ms, and/or a radiofrequency temporal offset is preferably ≤ 250 ms. With regard to a pressure and a gas flux and according to another preferred embodiment of the invention, the middle layer and/or the outermost layer are obtained by a plasma enhanced chemical vapor deposition process, wherein a working pressure is ≤ 100 Pa and/or a flux of the middle layer precursor and/or outermost layer precursor is ≤ 50 sccm. Preferably the middle layer precursor and/or outermost layer precursor is Hexamethyldisiloxane and/or Hexamethyldisilazane. Further preferably a flux of hydrogen is preferably ≤ 200 sccm, a flux of nitrogen is preferably ≤ 100 sccm, a flux of argon is preferably ≤ 200 sccm, and/or a flux of oxygen is preferably ≤ 1000 sccm.

Further preferably the the middle layer and/or the outermost layer are deposited by a microwave-operated low-pressure discharge. Preferably microwaves with a frequency of 2,45 GHz are used to ignite the plasma. The microwaves propagate preferably as transversal electromagnetic surface waves along an antenna, and cause the plasma discharge to evolve around the antenna. Process gases such as oxygen, nitrogen, hydrogen, or argon are fed into a chamber through an inner quartz tube of the Plasma line antenna, as well as precursors for the outermost layer and/or middle layer.

The outermost layer may not only be obtained by the above-described plasma enhanced chemical vapor deposition process. Alternatively, the plasma enhanced atomic layer deposition process (PELAD) may be used. In this regard and according to another preferred embodiment of the invention the outermost layer is obtained by the plasma enhanced atomic layer deposition process by

a) feeding the middle layer precursor as silicon and carbon source into a vacuum chamber for chemisorption on the color layer and/or feeding the outermost layer precursor as silicon source into a vacuum chamber for chemisorption on the color layer,
b) feeding an inert gas, such as argon, into the vacuum chamber for removal of residual middle layer precursor,
c) feeding a co-reactant, preferably oxygen, into the chamber accompanied with the ignition of a plasma,
d) feeding a further inert gas into the vacuum chamber for purging, and
e) repeating steps a) to d) consecutively, preferably until a desired thickness of the outermost layer is achieved.

PELAD may have the advantage that the outermost layer comprises less defects than when using PE-CVD processes.

According to another preferred embodiment of the invention, the co-reactant is selected from oxygen, water, $N_2O$, CO, $CO_2$, and/or mixtures thereof.

**Color layer**

The color layer of the plastic comprises the plastic material and the coloring agent. In other words, the color layer is preferably a colored plastic layer.

The plastic material comprises at least 0,1 wt.-% of the polar component, based on the weight of the plastic material. The polar component is a polar polymer, a polar compound and/or a blend of polar polymers and/or polar

compounds. In other words, the polar component may be a polar polymer or of mixtures of polar polymers and/or a polar compound or mixtures of polar compounds.

The polar polymer has a molecular weight Mw ≥ 1000 g/mol and has at least 5 wt.-% of heteroatoms based on the molecular weight of the polar polymer, and wherein heteroatoms are any atoms except C and H atoms.

The polar compound has a molecular weight Mw < 1000 g/mol and has at least 5 wt.-% of heteroatoms based on the molecular weight of the polar compound and wherein heteroatoms are any atoms except C and H atoms.

Preferably the heteroatom is selected from the group comprising O, N, S, P, F, Cl, Br, and I.

The coloring agent comprises an organic molecule having a molecular weight ≤ 800 g/mol. The coloring agent may be a dye or a lake pigment. Dyes are predominantly present in the plastic material in a molecular solved state. Lake pigments are made by precipitating an organic molecule with an inert binder, usually a metallic salt, such as aluminum salts. In other words, lake pigments are the salts of organic dyes. In case the coloring agent is a lake pigment, the molecular weight of ≤ 800 g/mol is given with respect to the organic molecule - i.e. the dye - of the lake pigment. Furthermore, in case the lake pigment is a precipitate of several dye molecules, such as $M(dye)_3$ with M for example being $Al^{3+}$, the molecular weight of ≤ 800 g/mol refers to a individual dye molecule in the lake pigment and not to the sum of all molecular weights of the individual dye molecules.

For example, the color layer may consist of poly(methyl methacrylate), as the polar polymer and the coloring agent in a weight ratio of 99,9 : 0,1. Alternatively, the color layer may comprise a non-polar polymer, such as polypropylene or mixtures of non-polar polymers. For example, the color layer may consist of polypropylene as non-polar polymer, the polar polymers ethyl-methacrylat-copolymer and Polysorbat 80 and the coloring agent, in a weight ratio of 96:3,8:0,1:0,1.

The coloring agent comprises the organic molecule having a molecular weight ≤ 800 g/mol. In case a dye is used as coloring agent, the organic molecule is predominantly present in the plastic material in a molecularly solved state, preferably in the polar component of the plastic material.

According to another preferred embodiment of the invention, the color layer has a thickness between 1 μm to 500 μm, more preferably between 1 μm to 250 μm, and even more preferably between 1 μm to 100 μm. In particular when the color layer is produced by exposing an uncolored and preferably uncoated plastic article not comprising the outermost layer to a coloring bath, thicknesses of the color layer above 500 μm, may not improve the color effect of the colored plastic article.

**Producing the color layer**

With regard to the production of the color layer several methods are possible.

It is possible that the color layer is provided by dying an uncolored plastic article in a coloring bath comprising the coloring agent. The uncolored plastic article is preferably also uncoated - i.e. the uncolored plastic article does not comprise the outermost layer. The uncolored plastic article may be provided by a plastic forming process. During dying of the uncolored plastic article, the coloring agent in the coloring bath migrates into the uncolored plastic article and thus a plastic article having a color layer is provided. In this case, only the surface and/or surfaces of the uncolored article that have been exposed to the coloring bath are colored. Furthermore, since the coloring agent migrates into the plastic material of the uncolored plastic article only an outer layer of the surface exposed to the coloring bath may be colored. In this case the plastic article may comprise in addition to the color layer also additional layers, which are uncolored. Furthermore, the distribution of the coloring agent within the color layer may be inhomogeneous, e.g. showing a gradient with a higher concentration of coloring agent near the surface and a lower concentration of coloring agent farther away from the surface.

In the context of this invention providing an uncolored plastic article means that the plastic article provided has an inherent color that is only dependent on the plastic material it is made of and not dependent on the coloring agent that is used for coloring the plastic article. In other words, uncolored is the color of the plastic material when no coloring agent is added. Accordingly, being uncolored can mean that the plastic article is transparent or translucent for human perception - i.e. that light in the visible spectrum can pass through the uncolored plastic article. Alternatively, being uncolored can mean that the plastic article is opaque for human perception- i.e. that light in the visible spectrum is not transmitted or only partially transmitted. In case of opacity the uncolored plastic article may have a whitish, slight yellowish or slight greyish inherent color dependent on the plastic material it is made of.

Alternatively, the color layer may be provided by using a color masterbatch or liquid color comprising the coloring agent in a plastic forming process. Since in this case, the coloring agent is distributed in the plastic material when the plastic article is formed, a plastic article that is dyed throughout its entire volume is provided. However, it is still possible that a multilayer plastic article consisting of several individual layers is produced and only one or some of these individual layers are colored. For example, if the color masterbatch is only added to one layer, only this layer is colored. The remaining layers retain the original inherent color of the respective material. Furthermore, it is of course possible to color different layers in different colors.

With regard to the plastic forming process a variety of different processing methods may be used. According

to a preferred embodiment of the invention the plastic forming processing method is selected from:

- thermoplastic processing method;
- film extrusion processing method, blown cast processing method, calandered films processing method, thermoforming sheets processing method, foam extrusion processing method, profile extrusion processing method, injection molding processing method, injection blow molding processing method, injection stretch blow molding processing method, compression molding processing method, extruding processing method, thermoforming processing method, blow molding processing method, blowing processing method and/or 3D-printing processing method.

As already mentioned, when using the coloring bath for providing the color layer it may be possible that the thickness of the color layer is smaller than the thickness of the plastic article.

Providing the color layer by exposing the surface of the uncolored plastic article to the coloring bath has the advantage that the thickness of the colored layer is smaller than what is technically feasible by multi-layer coextrusion with only one layer, preferably the outer layer colored by using a color masterbatch or liquid color comprising the coloring agent. This in turn has the advantages that the amount of coloring agent used is smaller and the decolorization is faster. Ordinary plastic articles are often produced in a single layer - i.e. the color layer - as the process costs in particular are significantly lower than those for the production of multilayer articles. Thus, when recycling the colored plastic article less effort is necessary, and the process is more environmentally friendly. When using a coloring bath, a thickness of the color layer is preferably about $\geq 5\ \mu m$. Thus, a satisfying color quality of the colored plastic article can be achieved, with a low amount of dye in the colored plastic article.

Depending on the type of coloring agent, the coloring bath is an aqueous solution (e.g. in case the coloring agent has a high solubility in water, e.g. acid dyes) or the coloring bath is an aqueous dispersed solution (e.g. in case the coloring agent has a low solubility in water). Dyeing in organic solvents or mixtures of water and organic solvents using solvent dyes is also conceivable.

In contrast to the textile dyeing or the coloring of filaments and fibers in the non-woven area, the object of exposing the surface of the uncolored plastic article to the coloring bath is not to dye through. The object is rather to color a defined thickness - preferably $\geq 5\ \mu m$ - of the outer surface. This means the coloring agent concentration is enriched in a defined thickness of the outer surface of the plastic article until the desired color is achieved. Accordingly, a thin but deeply colored layer in the plastic article - i.e. the color layer - is obtained. Furthermore, a color change from translucent like frosted glass to a deep color may be achieved with a low amount of coloring agent.

**Coloring agent**

As already mentioned, the coloring agent is a low molecular weight dye, or a lake pigment of a low molecular weight dye, i.e. an organic molecule having a molecular weight Mw $\leq$ 800 g/mol.

An advantage of using organic molecules with low molecular weights as coloring agent for plastic articles is that the coloring agent can easily be processed, meaning that dyes and/or lake pigments are easily dispersible in fatty media or dry mixtures. Thus, these coloring agents allow for a high color homogeneity of the plastic article. Furthermore, the low molecular weight allows the coloring agent, especially the low molecular weight dye, to be introduced into the plastic article by a migration process. Furthermore, the low molecular weight also allows the coloring agent to migrate out of the plastic article in the decoloring process. Preferably the coloring agent is not covalently bond to the plastic material. Therefore, the coloring agent is preferably not a reactive dye.

Preferably the organic molecule used as coloring agent is a molecule that absorbs electromagnetic radiation in the visible spectrum, thus the coloring agent gives the plastic article a color that is visibly perceivable by humans. Preferably the coloring agent comprises an/or is an organic molecule, more preferably an organic molecule having an aromatic and/or heterocyclic aromatic structure, i.e. an organic aromatic dye and/or the lake pigment of an organic aromatic dye. According to a preferred embodiment of the invention the coloring agent comprises the organic molecule having the molecular weight Mw in the range of about $\geq$ 250 g/mol to about $\leq$ 800 g/mol, preferably about $\geq$ 270 g/mol to about $\leq$ 450 g/mol, and more preferably in the range of about $\geq$ 285 g/mol to about $\leq$ 400 g/mol.

In order to enable a migration as unhindered as possible, the coloring agent and preferably the organic molecule of the coloring agent preferably has a rather planar structure and preferably comprises at least one free rotation center outside the planar structure. Further in case of ligands and/or remnants which may be spatially or sterically demanding, the ligands and/or remnants may be as freely movable as possible around a center of rotation. This may give the organic molecule of the coloring agent the ability to adapt its shape to the environment given by the matrix of the plastic basis material. Preferably the organic molecule of the coloring agent may not comprise a spiro-center and/or the organic molecule of the coloring agent may not comprise a large moiety that is rotation-impaired. In this context a large moiety that is rotation impaired may mean that the molecular weight of this rotation impaired moiety is about 350 g/mol +/- 10%.

With regard to the coloring agent, different types of dyes and/or lake pigments can be used: The coloring agent

may be a disperse dye, a solvent dye and/or an acid dye and/or or an acid dye converted into a pigment or a so-called lake pigment, according to the name or designation according to the Color Index. Dyes are predominantly molecularly soluble in the plastic material, i.e. the polar polymer and/or the polar compound, used to produce the plastic article and produce a homogenous either colored-opaque or colored-translucent or -transparent coloration of the plastic article. Preferably, the coloring agent is selected from the group comprising phthalocyanine, polymethine, anthraquinone, indanthrone, monoazo, diazo, methine, quinophthalone, perinone, naphthalidimide, indigo, quinoline and thioindigo dyes.

More preferably the coloring agent is selected from the group comprising the following chemical formulas A1 to A58 according to table 2:

| Table 2 | |
|---|---|
| Chemical formula A1 | 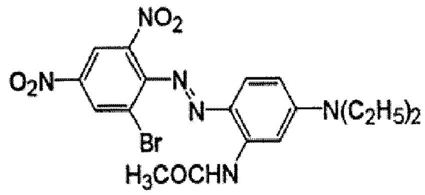 |
| Chemical formula A2 | 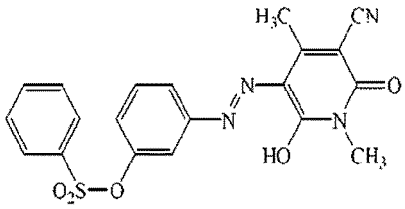 |
| Chemical formula A3 | 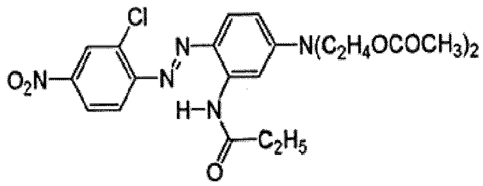 |
| Chemical formula A4 | 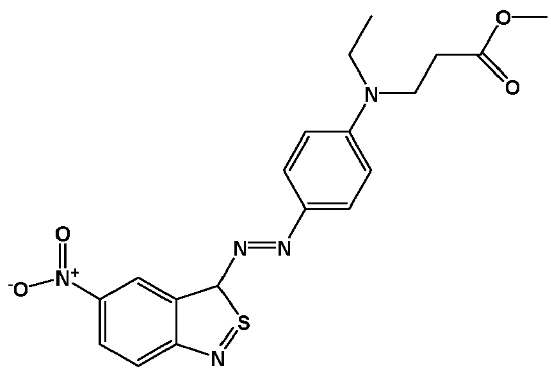 |
| Chemical formula A5:<br><br>Disperse Blue 56/ Bemacron Blau E-FBL | 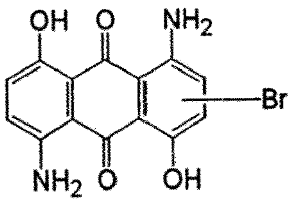 |

(continued)

| Table 2 | |
|---|---|
| Chemical formula A6<br><br>Disperse Red 60 | 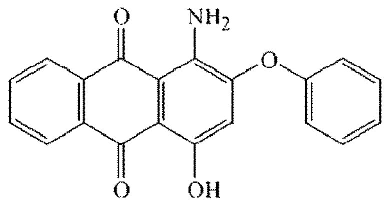 |
| Chemical formula A7 | 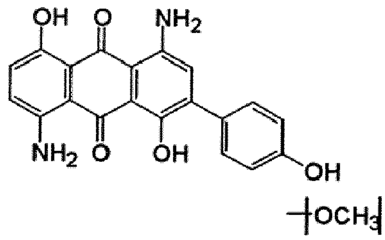 |
| Chemical formula A8 | 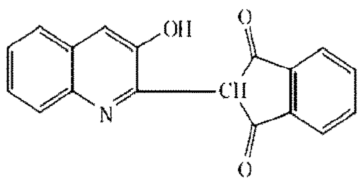 |
| Chemical formula A9 | 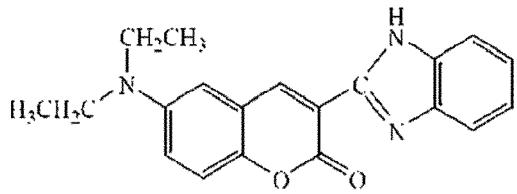 |
| Chemical formula A10 | 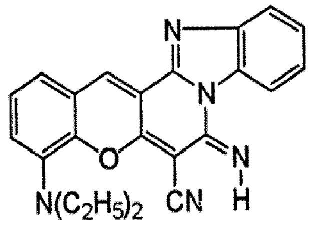 |
| Chemical formula A11:<br>Acid Red 266 | 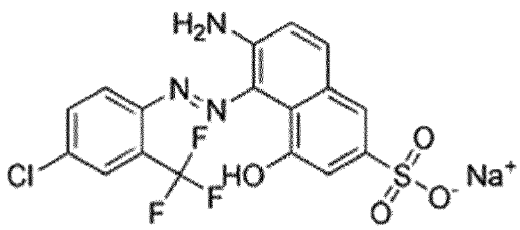 |
| Chemical formula A12:<br>Acid Blue 62 | 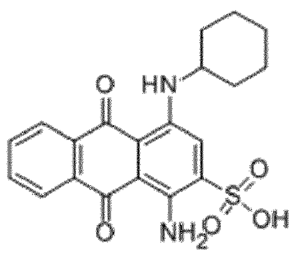 |

(continued)

| Table 2 | |
|---|---|
| Chemical formula A13: Acid Yewllow 246 | 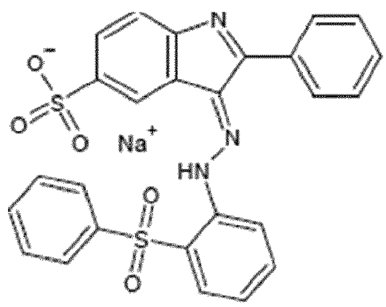 |
| Chemical formula A14 | 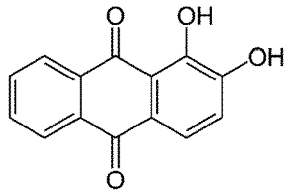 |
| Chemical formula A 15 Solvent Blue 104 | 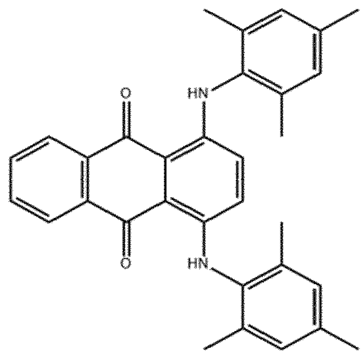 |
| Chemical formula A 16 | 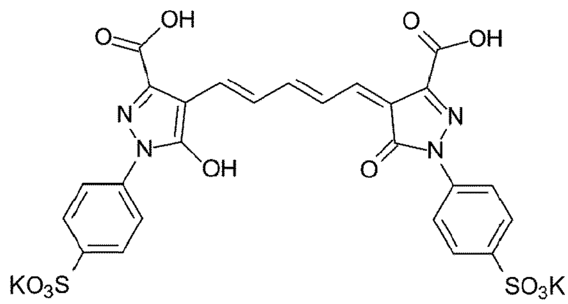 |
| Chemical formula A 17 | 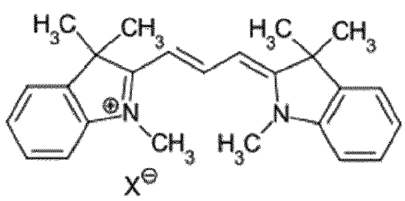 |
| Chemical formula A18: Disperse Red 278 | 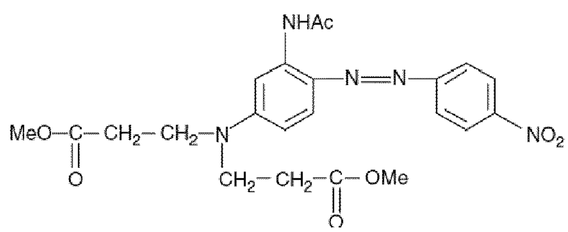 |

(continued)

| Table 2 | |
|---|---|
| Chemical formula A19:<br>Disperse Brown 19 | 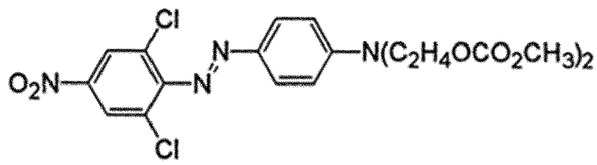 |
| Chemical formula A20:<br>Disperse Orange 30 | 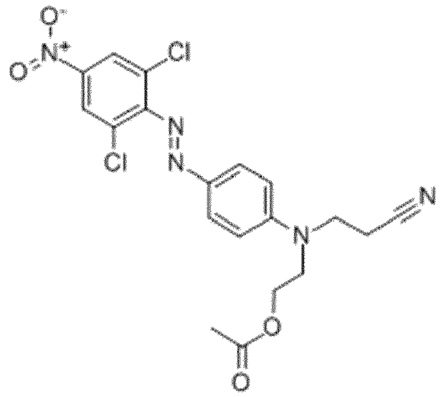 |
| Chemical formula A21:<br>Bemacron Blau HP-LTD | 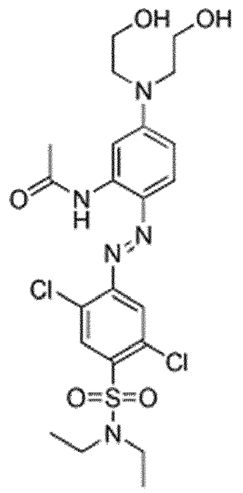 |
| Chemical formula A22:<br>Bemacron Rot HP-LTD 01 | 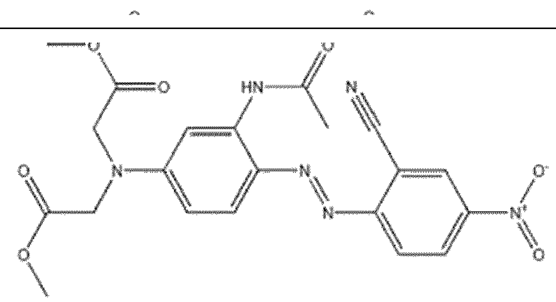 |
| Chemical formula A23:<br>Bemacron Gelb HT-LTD01 | 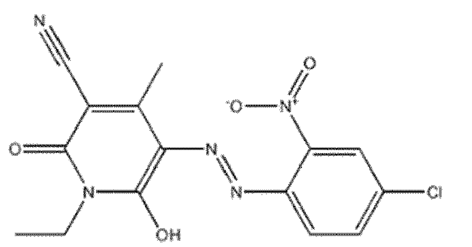 |

(continued)

| Table 2 | |
|---|---|
| Chemical formula A24 | 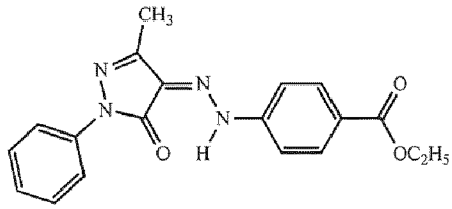 |
| Chemical formula A25:<br><br>X = {alkyl, aryl, phenyl}<br>Y = {alkyl} | 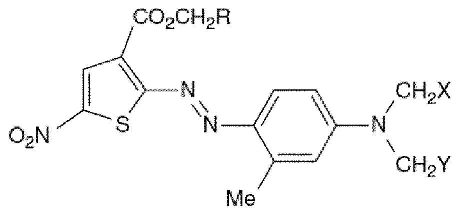 |
| Chemical formula A26 | 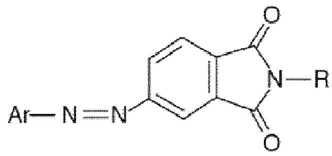 |
| Chemical formula A27<br><br>R1 to R5 = {alkyl, aryl} | 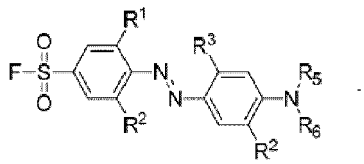 |
| Chemical formula A28<br><br>X = $SO_2F$<br><br>R= {aryl, alkyl} | 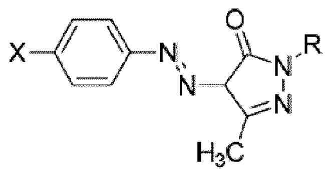 |
| Chemical formula A29 | 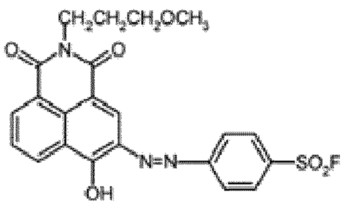 |
| Chemical formula A30 | 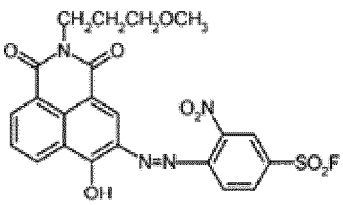 |

(continued)

| Table 2 | |
|---|---|
| Chemical formula A31 | 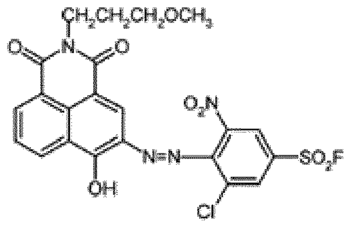 |
| Chemical formula A32: Disperse Green 9 | 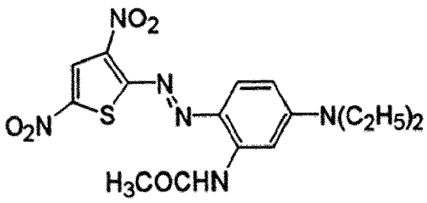 |
| Chemical formula A33<br><br>X = {$COCOCH_3$, $CO_2CH_2$}<br>Y = {H, NHAc} | 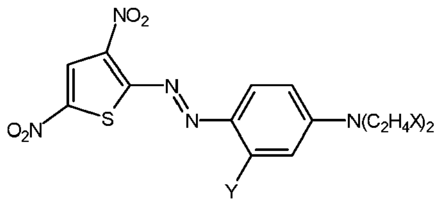 |
| Chemical formula A34<br><br>X, Y = {alkyl, aryl, phenyl, $C_2H_4Ph$}<br>R= {H, Alkyl, $CH_2OEt$} | 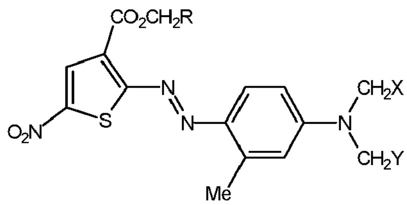 |
| Chemical formula A35<br><br>X = {$COCOCH_3$, $CO_2CH_2$} | 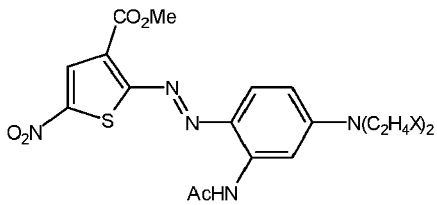 |
| Chemical formula A36<br><br>X = N; Y= H; Z = $NO_2$; or<br>X = C-$NO_2$, Y=H, Z=$NO_2$ | 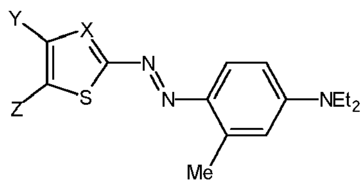 |
| Chemical formula A37 | 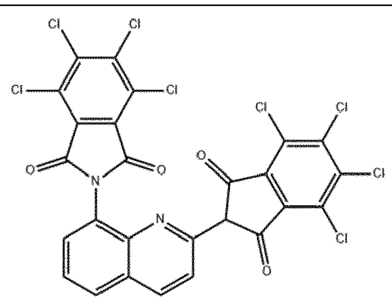 |

(continued)

| Table 2 | |
|---|---|
| Chemical formula A38:<br>Allura Red<br><br>A38 L: Lake Allura Red:<br>Precipitated as Al-salt | 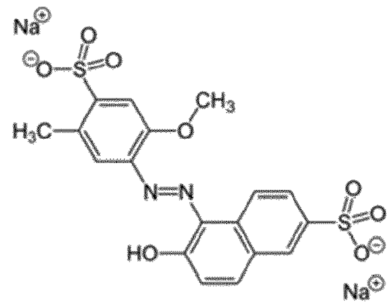 |
| Chemical formula A39:<br>Tartrazine<br><br>A39 L: Lake Tartrazine: Precipitated<br><br>as Al-salt | 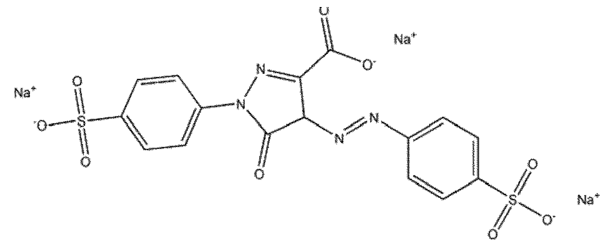 |
| Chemical formula A40:<br>Sunset Yellow<br><br>A40 L: Lake Sunset Yellow:<br><br>Precipitated as Al-salt | 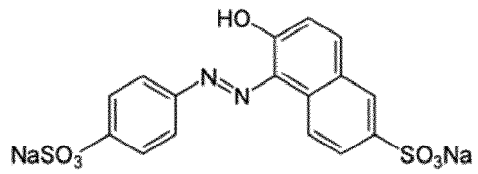 |
| Chemical formula A41:<br>Brilliant Blue FCF<br><br>A41 L: Lake Brilliant Blue FCF:<br>Precipitated as Al-salt | 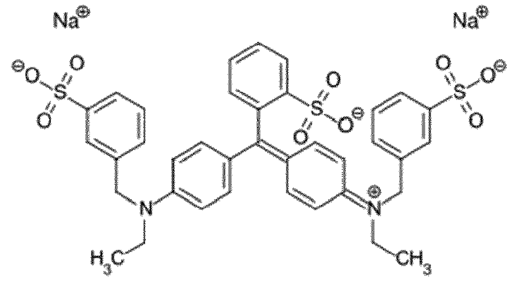 |
| Chemical formula A42:<br>Indigo Carmine<br><br>A42 L: Lake Indigo Carmine:<br>Precipitated as Al-salt | 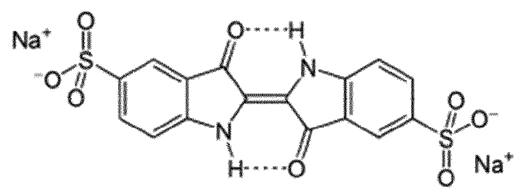 |
| Chemical formula A43:<br>Erythrosine<br><br>A43 L: Lake Erythrosine:<br><br>Precipitated as Al-salt | 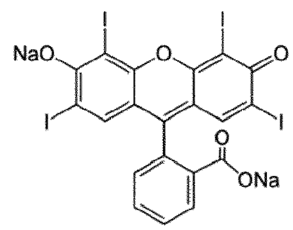 |

(continued)

| Table 2 | |
|---|---|
| Chemical formula A44: Amaranth<br><br>A44 L: Lake Amaranth: Precipitated as Al-salt | 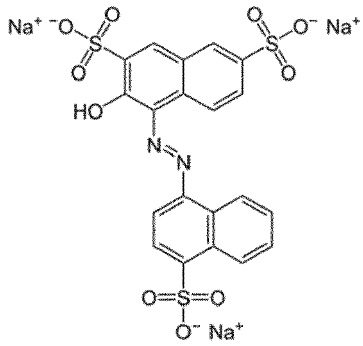 |
| Chemical formula A45: Carmoisine<br><br>A45 L: Lake Carmoisine: Precipitated as Al-salt | 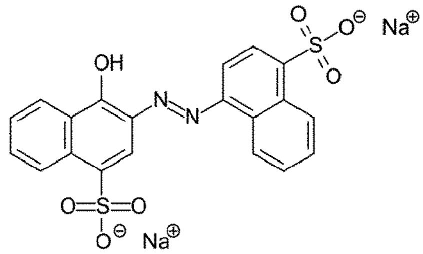 |
| Chemical formula A46: Ponceau 4R<br><br>A46 L: Lake Ponceau 4R: Precipitated as Al-salt | 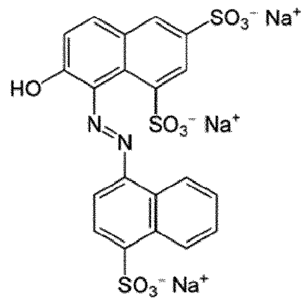 |
| Chemical formula A47: Quinoline Yellow<br><br>A47 L: Lake Quinoline Yellow: Precipitated as Al-salt | 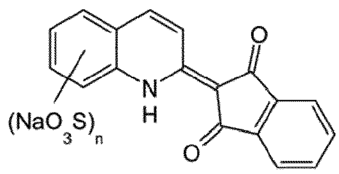 |
| Chemical formula A48: Acid Blue 27 | 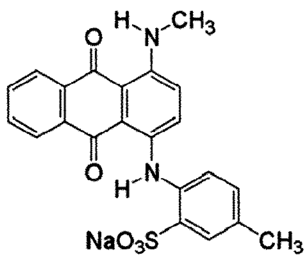 |
| Chemical formula A49: Acid Red 14 | 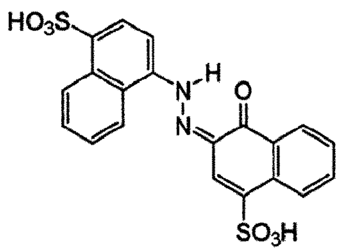 |

(continued)

| Table 2 | |
|---|---|
| Chemical formula A50:<br>Acid Blue 25 | 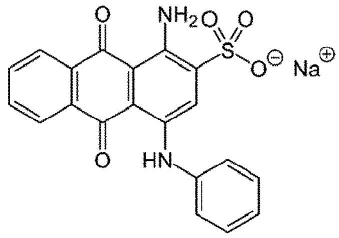 |
| Chemical formula A51:<br>Acid Red 1 | 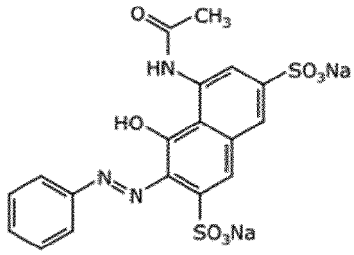 |
| Chemical formula A52:<br>Acid Yellow 11 | 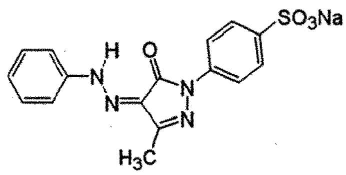 |
| Chemical formula A53:<br>Acid Yellow 23 | 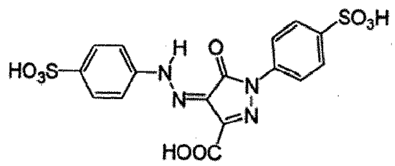 |
| Chemical formula A54:<br>Acid Yellow 36 | 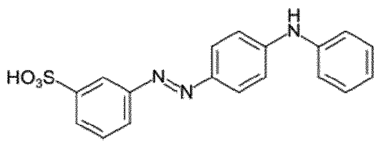 |
| Chemical formula A55:<br>Mordant Blue 9<br><br>A55 L: Lake Mordant Blue 9:<br>Precipitated as Al-salt | 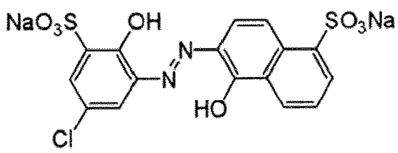 |
| Chemical formula A56 L: Pigment Red 57:1 (Litholrubin BK)<br><br>Precipitated as Ca-salt: calcium (4Z)-4-[(4-methyl-2-sulfonatophenyl)hydrazono]-3 -oxo-2-naphthalenecarboxylate | 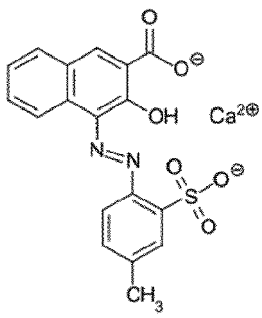 |

(continued)

| Table 2 | |
|---|---|
| Chemical formula A57:<br>Pigment Yellow 62<br><br>A57 L: Pigment Yellow 62<br>Precipitated as Ca-salt<br>calcium,4-[[4-(2-methylanilino)-2,4-dioxobutyl] diazenyl]-3-nitrobenzenesulfonate | 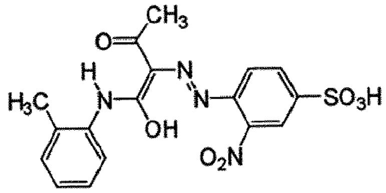 |
| Chemical formula A58:<br>Pigment Red 48:2<br><br>A58 L: Pigment Red 48:2<br>Precipitated as Ca-salt: calcium-4-[(5-chlor-4-methyl-2-sulfonatophenyl)azo] -3 -hydroxy-2-naphthoate | 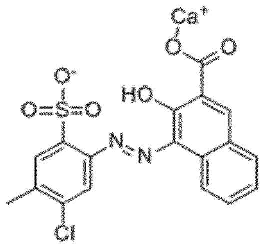 |

Regarding the chemical formula A7, the methoxy group -[OCH3] may be an alternative for the hydroxyl group -[OH] on the aromatic moiety, that is not part of the anthraquinone ring system.

Preferably the coloring agent is selected from the group comprising the coloring agents known under the trademark BEMACRON S/SE/E from CHT Germany GmbH, or from Dystar Pte Ltd.

Preferably the coloring agent is selected from the group comprising BEMACRON Yellow S-6GF, BEMACRON Yellow S-4g, BEMACRON Yellow Brown S-2RFl, BEMACRON Orange S-g, BEMACRON Scarlet S-gFl, BEMACRON Scarlet S-BWFl, BEMACRON Rubine S-2GFL, BEMACRON Violet S-3Rl, BEMACRON Violet S-BlF, BEMACRON Blue S-Bgl, BEMACRON Blue S-BB, BEMACRON Turquoise S-gF, BEMACRON Na-vy S-2gl, BEMACRON Navy S-3l, BEMACRON Black S-3l, BEMACRON Black S-T, BEMACRON Yellow SE-Rdl, BEMACRON Yellow SE-lF, BEMACRON Orange SE-Rdl, BEMACRON Red SE-4g, BEMACRON Pink SE-REl, BEMACRON Red SE-3B, BEMACRON Red SE-Rdl, BEMACRON Blue SE-lF, BEMACRON Blue SE-Rdl, BEMACRON Navy SE-RlX, BEMACRON Black SE-RlX, BEMACRON Black SE-Rd2R, BEMACRON Yellow E-3gl, BEMACRON Red E-FBl, BEMACRON Blue E-FBl, and BEMACRON Black E-R.

More preferably the coloring agent is selected from the group comprising BEMACRON Black E-R, BEMACRON Yellow S-6GF, BEMACRON Rubine S-2GFL, BEMACRON Blue RS, BEMACRON Blue E-FBL 150, BEMACRON Red E-FBL, BEMACRON Blue S-BGL, BEMACRON Yellow E-3gl, BEMACRON Lumin. Yellow SEL-8G, and BEMACRON Lumin. Red SEL-G.

Furthermore the coloring agent may be selected from the group of acid dyes comprising Bemacid Blau E-TL, Bemacid Rot E-TL or Bemacid Gelb E-TL, Bemacid Blue N-TF, Bemacid Red N-TF, Bemacid Yellow N-TF, Bemacid Leuchtgelb E-B, Bemacid Gelb E-4G, Bemacid Gelb E-T3R, Bemacid Gelb E-5R, Bemacid Leuchtrot E-B, Bemacid Rot E-KRL, Bemacid Rot E-T2B, Bemacid Rot E-3BS, Bemacid Blau E-2R, Bamacid Blau E-T4R, Bemacid Blau E-G, Bemacid Blau E-3GC, Bemacid Gelb N-2G, Bemacid Orange N-BG, Bemacid Rubin N-5B, Bemacid Bordeaux N-BL, Bemacid Blau N-5GL, Bemacid Marine N-5R, Bemacid Schwarz N-TMF, or the group of metal complex dyes Bemaplex BEMAPLEX Gelb M-T, BEMAPLEX Rot M-T and BEMAPLEX Marine M-T.

Furthermore the coloring agent may be a solvent dye such as Solvent Blue 104.

Furthermore, the coloring agent may be selected from the group comprising polymethine dyes. Preferably, the polymethine dyes from the companies BUFA GmbH & Co. KG, BÜFA Chemikalien GmbH & Co. KG, BÜFA Composite Systems GmbH & Co. KG, and/or BÜFA Reinigunssysteme GmbH & Co. KG may be used.

The coloring agent may be a ready-to-use dye, i.e. a dye comprising a dispersing agent or another additive for example to ensure sufficient solubility in a coloring bath or incorporated in the carrier of a color masterbatch. Alternatively, it may be a dye not comprising a dispersing agent or any additive.

Various acid dyes can be converted to the water-insoluble so-called lake pigments, which are usually aluminium and/or calcium salts of the corresponding acid dyes. These lake pigments usually exhibit sufficient color stability against external influences, such that the tendency for migration is strongly reduced. Furthermore, the lake pigments can be transformed back into water-soluble components, which makes a decoloring of the plastic article possible.

Nevertheless, also for plastic articles comprising lake pigments as coloring agent it is useful to provide the plastic article with the outermost layer - especially in very sensitive areas such as packaging for food, in the pharmaceutical

sector, or in case the filling good is particularly aggressive, such as strong acids or bases, or strong oxidizing or reducing agents. Furthermore, in case the filling good comprises a media with low-molecular weight the outermost layer may also decrease the risk of migration of the filling good into the plastic article. Migration of the filling good into the plastic may reduce the integrity of the plastic, which may in turn lead to a dissolution of the coloring agents - i.e. the dyes or lake pigments - out of the plastic, such that the coloring agents end up in the filling good.

**Plastic material**

As already mentioned, the plastic material comprises at least 0,1 wt.-% of the polar component, based on the weight of the plastic material.

As already mentioned, in case a dye is used as coloring agent, the coloring agent is predominantly molecularly solved in the plastic material, preferably in the polar component, i.e. the polar polymer and/or the polar compound, which means that about 80 % to 100 % of the coloring agent are molecularly solved in the plastic material. In other words, the plastic material acts as solvent for the coloring agent in the colored plastic article. This has the advantage that the plastic article has a high color homogeneity and highly transparent parts are possible.

In general, the plastic material may be any plastic or any mixture of plastics and may be selected according to the use of the plastic article. Preferably the plastic material is a thermoplastic and/or a thermoplastic elastomer. Furthermore, the coloring agent in the colored plastic article may be easily soluble in polar polymers such as co-polyester, co-polycarbonates, acrylonitrile-butadiene-styrene, polyamide, polyurethane, and/or polyalkyl(meth)acrylate. The solubility of the dye in non-polar polymers such as polyalkylenes, polyethylene (PE), polypropylene (PP), polybutylene (PB) may however not be sufficient to achieve good color homogeneities.

To this regard the plastic material comprises at least 0,1 wt.-% of the polar component. The polar component may be a polar polymer or mixtures of polar polymers, a polar compound or mixtures of polar compounds, or a mixture of polar polymers and polar compounds.

The polar polymer as well as the polar compound comprise at least 5 wt.-% of heteroatoms based on the molecular weight of the polar polymer or the polar compound, respectively. Thus, these substances have a significant dipole moment and are polar.

It is possible that the plastic material comprises up to 99,9 wt.-% of a non-polar polymer or of mixtures of non-polar polymers, such as polyethylene (PE), polypropylene (PP), polybutylene (PB). According to a preferred embodiment of the invention the plastic material comprises ≤ 99,9 wt.-%, preferably ≤ 99,5 wt.-%, more preferably ≤ 98 wt.-%, even more preferably ≤ 95 wt.% of a non-polar polymer or mixtures of non-polar polymers, based on the weight of the plastic material, wherein the non-polar polymer has a molecular weight Mw ≥ 1000 g/mol, preferably Mw ≥ 1200 g/mol, more preferably Mw ≥ 1500 g/mol and has less than 5 wt.-% of heteroatoms based on the molecular weight of the non-polar polymer, wherein heteroatoms are any atoms except C and H atoms.

Furthermore, the plastic material preferably comprises in addition to the non-polar polymer at least 0,1 wt.-%, more preferably at least 1 wt.-%, more preferably at least 2 wt.-%, even more preferably at least 3 wt.-% of the polar component, based on the weight of the plastic material.

The polar component can be the polar polymer, the polar compound or mixtures of polar polymers and/or polar compounds.

The polar polymer has a molecular weight Mw ≥ 1000 g/mol, preferably Mw ≥ 1200 g/mol, more preferably Mw ≥ 1500 g/mol and has at least 5 wt.-% of heteroatoms based on the molecular weight of the polar polymer, wherein heteroatoms are any atoms except C and H atoms. Preferably the heteroatom is selected from the group comprising O, N, S, P, F, Cl, Br, and I.

The polar compound has a molecular weight Mw < 1000 g/mol, preferably Mw < 900 g/mol, more preferably Mw < 800 g/mol and has at least 5 wt.-% of heteroatoms based on the molecular weight of the polar compound, wherein heteroatoms are any atoms except C and H atoms. Preferably the heteroatom is selected from the group comprising O, N, S, P, F, Cl, Br, and I.

In other words, a good color homogeneity of the color layer is achieved by the polar compound also when the plastic material comprises a non-polar polymer or a blend of non-polar polymers for up to 99,9 wt.-% based on the weight of the plastic material.

According to another preferred embodiment of the invention, the plastic material comprises less than 16 wt.-%, preferably less than 10 wt.-%, even more preferably less than 5 wt.-% of the polar compound, based on the weight of the plastic material. Since the polar compound having a molecular weight Mw < 1000 g/mol, preferably Mw < 900 g/mol, more preferably Mw < 800 g/mol may affect the physical properties of the plastic material when used in high amounts in the plastic material, the amount of polar compounds in the plastic material is preferably not higher than 25 wt.-%, based on the weight of the plastic material.

According to another preferred embodiment of the invention the polar polymer comprises an amorphous phase of at least about ≥ 10 vol.-%, preferably about ≥ 30 vol.-%, more preferably about ≥ 50 vol.-% and about ≤ 100 vol.-%,

wherein the volume % is calculated on the total volume of the polar polymer. This enhances the color homogeneity of the plastic article as well as the decolorability of the plastic article. It is believed that the coloring agent has a higher affinity to the amorphous phase of the plastic material and shows a higher mobility in the amorphous phase.

**Mw of polar polymer and non-polar polymer**

For polymers the individual polymer chains rarely have exactly the same degree of polymerization and molar mass, and there is a distribution around an average value (molecular weight distribution (MWD)). To this regard, the molecular weight of the polar polymer and non-polar polymer is given with respect to the Mass average molar mass or Mw (also commonly referred to as weight average or Weight Average Molecular Weight (WAMW)).

The mass average molecular mass can be determined by gel permeation chromatography, static light scattering, small angle neutron scattering, X-ray scattering, and/or sedimentation velocity. Furthermore, in case the distribution is known, the mass average molecular mass can be calculated by

$$\bar{M}_w = \frac{\sum_i N_i M_i^2}{\sum_i N_i M_i}$$

where Ni is the number of molecules of molecular mass Mi.

**Polar polymer**

The polar polymer or mixture thereof may be selected from the group comprising:

- polyacrylate with methyl (polymethylacrylate), ethyl (polyethylacrylate), propyl (polypropylacrylate), or butyl (polybutylacrylate),
- polymethacrylate with methyl (polymethylmathacrylate), ethyl (polyethylmethacrylate), propyl (polypropylmethacrylate), or butyl (polybutylmethacrylate),
- copolymers of acrylic and methacrylic esters including, among others, *tert*-Butyl (meth)acrylate, pentyl(meth)acrylate and 2-ethylhexyl(meth)acrylate; (Meth)acrylates derived from unsaturated alcohols, preferably oleyl(meth)acrylate, 2-propynyl(meth)acrylate, allyl(meth)acrylate, vinyl(meth)acrylate;
- aryl(meth)acrylates polymers, preferably benzyl(meth)acrylate polymers or phenyl(meth)acrylate polymers, the aryl radicals each being unsubstituted or up to four times substituted;
- cycloalkyl(meth)acrylates polymers, preferably 3-vinylcyclohexyl(meth)acrylate polymers, bornyl (meth)acrylate polymers;
- hydroxylalkyl (meth)acrylates polymers, preferably 3- hydroxypropyl (meth)acrylate polymers, 3,4- dihydroxybutyl(meth)acrylate polymers, 2-hydroxyethyl(meth)acrylate polymers, 2-hydroxypropyl(meth)acrylate polymers;
- glycol di(meth)acrylates polymers, preferably 1,4-butanediol (meth)acrylate polymers;
- (meth)acrylates of ether alcohols polymers, preferably tetrahydrofurfuryl (meth)acrylate polymers, vinyloxyethoxyethyl(meth)acrylate polymers;
- polymers of amides and nitriles of the (meth)acrylic acid, preferably N-(3-dimethylaminopropyl)(meth)acrylamide polymers, N-(diethylphosphono)(meth)acrylamide polymers, 1-methacryloylamido-2-methyl-2-propanol polymers;
- polymers of sulfur-containing methacrylates, preferably ethylsulfinylethyl(meth)acrylate, 4-thiocyanatobutyl(meth)acrylate polymers, ethylsulfonylethyl(meth)acrylate polymers, thiocyanatomethyl(meth)acrylate polymers, methylsulfinylmethyl(meth)acrylate polymers, bis((meth)acryloyloxyethyl)sulfide polymers;
- polyhydric (meth)acrylates, preferably trimethyloylpropanetri(meth)acrylate polymers;
- acrylonitrile polymers;
- vinyl ester polymers, preferably vinyl acetate polymers;
- styrene polymers, substituted styrenes polymers with an alkyl substituent in the side chain, preferably $\alpha$-methylstyrene and $\alpha$-ethylstyrene, substituted styrenes polymers with an alkyl substituent on the ring, preferably vinyl toluene, and *p*-methylstyrene, halogenated styrene polymers, preferably monochlorostyrene polymers, dichlorostyrene polymers, tribromostyrene polymers and tetrabromostyrene polymers;
- heterocyclic vinyl polymers, preferably 2-vinylpyridine polymers, 3-vinylpyridine polymers, 2-methyl-5-vinylpyridine polymers, 3-ethyl-4-vinylpyridine polymers, 2,3-dimethyl-5-vinylpyridine polymers, vinylpyrimidine polymers, vinylpiperidine polymers, 9-vinylcarbazole polymers, 3-vinylcarbazole polymers, 4-vinylcarbazole polymers, 1-vinylimidazole polymers, 2-methyl-1-vinylimidazole polymers, N-vinylpyrrolidone polymers, 2-vinylpyrrolidone polymers, N-vinylpyrrolidine polymers, 3-vinylpyrrolidine polymers, N-vinylcaprolactam polymers, N-vinylbutyrolactam polymers,

vinyl oxolane polymers, vinyl furan polymers, vinyl thiophene polymers, vinylthiolane polymers, vinylthiazoles and hydrogenated vinylthiazoles polymers, vinyloxazoles and hydrogenated vinyloxazoles;

- polymers of vinyl and isoprenyl ethers;
- maleic acid polymers, preferably maleic anhydride polymers, methyl maleic anhydride polymers, maleimide polymers, methyl maleimide;
- copolymers of ethylene and/or propylene with acrylic esters, preferably polyethylen-block-co-polymethylmethacrylat, polypropylen-block-co-polymethylmethacrylat, and ethylene-acrylate copolymers;
- aliphatic and/or aromatic polyesters, preferably, hydroxyl-functional dendritic polyesters, polycaprolactone, polyethylenterephthalate (PET), polyethylene naphthalate (PEN), polyethylene furanoate (PEF), polytrimethylenterephthalat (PTT), polybutylenterephthalat (PBT), glycolized polyglycolterephthaltat (G-PET), amorphous polyethylenterephthalat (A-PET), polyesters of terephthalic acid, polyspiro-diol-terephthalate, polypentaspiroglycol-terephthalate (PSG), polycyclohexylenedimethylene-terephthalate (PCT), Polyethylenfuranoate (PEF), Polyethylennaphthylat, polyester based copolymer including a dicarboxylic acid-derived residue including a residue derived from an aromatic dicarboxylic acid and a diol-derived residue including a residue derived from 4-(hydroxymethyl)cyclohexylmethyl-4'-(hydroxymethyl)cyclohexane carboxylate, polyester based copolymer including a dicarboxylic acid-derived residue including a residue derived from an aromatic dicarboxylic acid and a diol-derived residue including a residue derived from 4,4-(oxybis(methylene)bis) cyclohexane methanol;
- polycarbonate (PC), 2,2-Bis-(4-hydroxyphenyl)-propan (Bisphenol A) polycarbonate, 2,2-Bis-(4-hydroxyphenyl)-butan (Bisphenol B) polycarbonate, 1,1-Bis(4-hydroxyphenyl)cyclohexan (Bisphenol C) polycarbonate, 2,2'-Methylendiphenol (Bisphenol F) polycarbonate, 2,2-Bis(3,5-dibrom-4-hydroxyphenyl)propan (Tetrabrombisphenol A) polycarbonate und 2,2-Bis(3,5-dimethyl-4-hydroxyphenyl)propan (Tetramethylbisphenol A) polycarbonate, bisphenol S polycarbonate, dihydroxydiphenylsulfid polycarbonate, tetramethylbisphenol A polycarbonate, 1,1-Bis(4-hydroxyphenyl)-3,3,5-trimethylcyclohexane (BPTMC) polycarbonate, 1,1,1-Tris(4-hydroxyphenyl)-ethane (THPE) polycarbonate;
- aliphatic polyamide (PA), preferably PA 6 based on polycaprolactam, PA 6.6 based on 1,6-hexamethylendiamin and adipic acid, PA 6.66 based on caprolactam, co-poymer of hexamethylendiamin and adipic acid, PA 66.610 based on hexamethylendiamin, copolymer of adipic acid and sebaic acid, PA 4.6, PA10, PA 12 and PA copolymers;
- polyurethane (PU),
- polar-copolymere, maleic anhydride-olefin copolymer;
- polyalkylenoxide, polyalkylene block copolymer, propylenoxide-ethylenoxide copolymer, (m)ethylene acrylate-maleic anhydride copolymer;
- polar-terpolymere, preferably reactive terpolymers of ethylene, acrylic ester and maleic anhydride, or ethylene, methacrylic ester and maleic anhydride, or ethylene, acrylic esters and glycidyl methacrylate, or ethylene, methacrylic esters and glycidyl methacrylate, or ethylene, (meth)acrylic esters and methyl (methyl(meth)acrylate), ethyl (ethy(meth)acrylate), propyl (propyl(meth)acrylate), or butyl (butyl(meth)acrylate), polyamide, polyester-polyamides, or butyl (butyl(meth)acrylate), polyether-polyamide copolymers;
- polar polymer blends, preferably polycarbonate/polyethylenterephthalat blends (PC/PET blends), polycarbonate/polybutyleneterephthalate blends (PC/PBT blends), blends of polycyclohexylene dimethylene terephthalate copolymer, blends of poly(butylene-adipate- terephthalate);
- polyacrylnitril and polyacrylnitril-copolymers, preferably poly acrylonitrile butadiene styrene (ABS), poly styrene-acrylonitrile;
- polystyrene and polystyrene copolymers, preferably styrene/butadiene co-polymer (SBR), poly styrene-isoprene-styrene (SIS), poly(glycidyl methacrylate) grafted sulfonamide based polystyrene resin with tertiary amine;
- ethylene-vinyl acetate;
- polyether, preferably polyethyleneglycol, polyethyleneglycol with at least one fatty acid coupled to the polyethyleneglycol, terminating functional groups such $NH_2$-terminated polyethers;
- functionalized polyacrylamide polymers, copolymers and terpolymers, preferably poly(2-acrylamido-2-aminopropionicacid) (polyAMPA), poly(2-acrylamido-2-amino propane sulfonic acid), poly(N-isopropylacylamide (polyPNIPAM); poly (amidoamine-co-acrylic acid) copolymer, poly(N,N-dimethylacrylamide-co-sodium acrylate), poly(acrylamide-co-sodium acrylate)/poly(ethylene glycol) semi-IPN, poly(acrylamide-co-sodium 4-styrenesulfonate), poly(acrylamide-co-sodium 4-styrenesulfonate)/poly(ethylene glycol) semi-IPN, poly(acrylamide-co-sodium methacrylate), poly(acrylamide-co-sodium methacrylate) /poly(ethylene glycol) semi-IPN, and/or poly(N-isopropylacrylamide-co-acrylic acid) and poly(acrylamide-co-acrylic acid;
- poly(ether sulfones)/poly(ethyleneimine) (PES/PEI);
- polyvinylpyrrolidone, preferably poly(N-vinyl-2-pyrrolidone), poly(N-vinyl-2-pyrrolidone-co-acrylonitrile) treated with hydroxylamine-hydrochloride
- polyvinyl alcohol; and/or
- poly(1-naphthylamine)-camphorsulphonic acid.

Other polar polymers of amorphous co-polyester, which can be used are known under the tradename Akestra 90, 100 and 110. The above named synthetic polar-polymers may be used alone or in a mixture of two or more.

With regard to hydroxyl-functional dendritic polyesters that can be suitable used as a polar polymer, these molecules may be produced using polyalcohol cores, hydroxy acids and technology based on captive materials. The dendritic structures may be formed by polymerization of the particular core and 2,2-dimethylol propionic acid (Bis-MPA). The hydroxyl-functional dendritic polyesters may be known under the trade name Boltorn®. The following dendritic polymers may be used as non-limiting examples: Boltorn® H20 16 terminal hydroxyl groups, nominal molecular weight of 1750 g/mol, Boltorn® H2004 6 terminal hydroxyl groups, nominal molecular weight of 3100 g/mol, Boltorn® H311 23 terminal hydroxyl groups, nominal molecular weight of 5300 g/mol, Boltorn® P500 Formulated bimodal product with terminal hydroxyl groups, nominal molecular weight 1800 g/mol, Boltorn® PI 000 formulated bimodal product with terminal hydroxyl groups, nominal molecular weight 1500 g/mol, Boltorn® U3000 modified with unsaturated fatty acid, nominal molecular weight 6500 g/mol, Boltorn® W3000 modified with non-ionic groups and unsaturated fatty acid, nominal molecular weight 10000 g/mol.

With regard to the polyester based copolymers that can be suitable used as a polar polymers, these may further include but not limited to a dicarboxylic acid-derived residue including a residue derived from an aromatic dicarboxylic acid and a diol-derived residue including a residue derived from 4-(hydroxymethyl)cyclohexylmethyl-4' -(hydroxymethyl)cyclohexane carboxylate represented by the following chemical formula 1 and a residue derived from 4,4-(oxybis(methylene)bis) cyclohexane methanol represented by the following chemical formula 2.

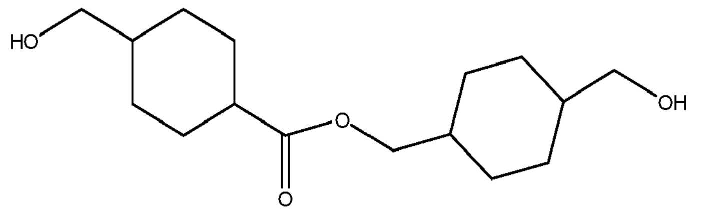

Chemical Formula 1

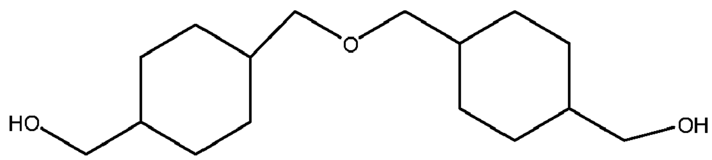

Chemical Formula 2

The compounds of chemical formula 1 and 2 can be copolymerized with aromatic dicarboxylic acid may be one or more selected from a group consisting of terephthalic acid, dimethyl terephthalate, cyclic dicarboxylic acid, isophthalic acid, adipic acid, azelaic acid, naphthalene dicarboxylic acid, and succinic acid.

The diol-derived residue of the copolymers may further include a residue derived from one or more other diols selected from a group consisting of 1,4-cyclohexane dimethanol, 1,2-propanediol, 1,3-propanediol, 1,4-butanediol, 2,2-dimethyl-1,3-propanediol, 1,6-hexanediol, 1,2-cyclohexanediol, 1,4-cyclohexanediol, 1,2-cyclohexane dimethanol, 1,3-cyclohexane dimethanol, 2,2-dimethylpropane-1,3-diol (neopentyl glycol), ethylene glycol, and diethylene glycol. A content of the diol derived residues of the residue derived from 4-(hydroxymethyl)cyclohexylmethyl 4'-(hydroxymethyl)cyclohexane carboxylate, the residue derived from 4,4-(oxybis(methylene)bis) cyclohexane methanol, and other diol-derived residues may be about 10 to 80 mol% based on 100 mol% of the dicarboxylic acid co-monomer.

The polar polymer may also comprise the polyester based copolymers used in a mixture with polyethylene terephthalate (PET). The mixture may consist of 1 to 99 wt.-% of PET and 1 to 99 wt.-% of the polyester based copolymers, in order that both components add up to 100 wt.-%. Additionally, or alternatively the compounds according to chemical formulas 1 and 2 may be used as co-monomers together with a further diol-component, e.g. ethylene glycol, in the preparation of the polyester based copolymers.

The polyester based copolymer may be prepared by reacting the dicarboxylic acid including the aromatic dicarboxylic acid with the diol including 4-(hydroxymethyl)cyclohexylmethyl 4'-(hydroxymethyl)cyclohexane carboxylate represented by chemical formula 1 and 4,4-(oxybis(methylene)bis) cyclohexane methanol represented by chemical formula 2 to perform an esterification reaction and a polycondensation reaction. In this case, other diols such as 1,4-cyclohexane dimethanol, ethylene glycol, diethylene glycol, or the like, as described above may be further reacted, such that a polyester based copolymer further including other diol-derived residues may be prepared.

With regard to the polyether, these may comprise but not limited to compounds that contain at least one polyethyleneglycol moiety and at least one fatty acid moiety coupled to the polyethyleneglycol moiety. The polyethyleneglycol moiety may contain 10 to 25 ethyleneglycol repeating units. The fatty acid moieties may be saturated or unsaturated and may contain 10 to 30 carbon atoms, preferably 16 to 22 carbon atoms. Examples of these fatty acid

moieties are oleate, laureate, stearate, palmitate and ricinoleate. A specific preferred example may be ethoxylated sorbitan ester.

The ethoxylated sorbitan ester comprises a sorbitan group which is substituted by four polyethylene glycol substituents. The ethoxylated sorbitan ester may preferably comprise 14 to 26 ethylene glycol repeating units, preferably 16 to 24 ethylene glycol repeating units, more preferably between 18 and 22 repeating units. At least one of the ethylene glycol substituents in the ethoxylated sorbitan ester is connected via an ester bond to a fatty acid moiety. Preferably, at least two of the ethylene glycol substituents in the ethoxylated sorbitan ester are connected via an ester bond to a fatty acid moiety; more preferably at least three of the ethylene glycol substituents are connected via an ester bond to a fatty acid moiety. The fatty acid moieties may be saturated or unsaturated and may contain 10 to 30 carbon atoms, preferably 16 to 22 carbon atoms.

Examples of these fatty acid moieties are oleate, laureate, stearate and palmitate. Most preferred are ethoxylated sorbitan esters comprising four polyethylene glycol substituents and wherein the ester comprises between 18 and 22 ethylene glycol repeating units and wherein three of the ethylene glycol substituents are connected to oleate, laurate or stearate groups.

Examples of ethoxylated sorbitan esters that can be used as polar-polymer are polyoxyethylene (20) sorbitane monolaurate, polyoxyethylene (20) sorbitane dilaurate, polyoxyethylene (20) sorbitane trilaurate, polyoxyethylene (20) sorbitane mono-oleate, polyoxyethylene (20) sorbitane di-oleate, polyoxyethylene (20) sorbitane tri-oleate, polyoxyethylene (20) sorbitane monostearate, polyoxyethylene (20) sorbitane distearate, polyoxyethylene (20) sorbitane tristearate, and polyoxyethylene (20) sorbitan monooleate, also known as Polysorbate 80 and E433.

Polysorbates are ethoxylated sorbitan fatty acid esters in the form of oily liquids. These non-ionic surfactants are used as wetting agents or as emulsifiers of the O/W type, for example, in cosmetics, pharmaceuticals, foods, cleaning agents and detergents. Well-known trade names include Tween, Scattics, Alkest and Canarcel. The different types of polysorbates differ in the fatty acid, the average number of polyoxyethylene units in the molecule and the degree of esterification. The two-digit number of the name of each polysorbate follows a certain scheme: The first number stands for the mainly esterified acid: 2=lauric acid, 4=palmitic acid, 6=stearic acid, 8=oleic acid, 12=isostearic acid. The second digit indicates the type of esterification: 0 for a monoester with 20 polyoxyethylene units, 1 for a monoester with 4 or 5 polyoxyethylene units and the number 5 stands for a triester with 20 polyoxyethylene units.

Polysorbate 80 is a polyoxyethylated compound derived from sorbitol and oleic acid. The hydrophilic groups of this non-ionic surfactant are polyethers, polymers of a total of 20 ethylene oxides. Other representatives from the group of polysorbates are for example: Polysorbate 20, Polysorbate 40, Polysorbate 60, and Polysorbate 65.

Preferably the polar polymer has a molecular weight $Mw \geq 1000$ g/mol, preferably $Mw \geq 1200$ g/mol, more preferably $Mw \geq 1500$ g/mol.

**Polar compound**

The polar compound or mixtures thereof may be selected from the group comprising aliphatic acids $CH_3$-$[CH_2]_n$-COOH acids (n about $\geq 3$), amino acids, carboxylic acid amide, hydroxyl acids, fatty acids, and their esters aliphatic or aliphatic/aromatic aldehydes and ketones, esters, pentaerythritol, pentaerythritol dimers, pentaerythritol trimers, pentaerythritol ester preferably carboxylic acid ester, benzoic acid esters comprising benzyl benzoat or phenyl benzoat, phenylether, alcohols and polyvalent alcohols, preferably glycerine, amines.

The carboxylic acid amide may comprise a compound according to formula $C_2H_4(NHC(O)R^3)_2$, wherein $R^3$ is a fatty acid moiety comprising 10-17 carbon atoms. The fatty acid moieties may be saturated or unsaturated. When the amount of carboxylic acid amide is too high the colored plastic article may show blooming. Blooming i.e. discolorations may be caused by phase separation of the plastic material’s components. It may be caused by incompatibilities of the polar compound with the plastic basis material.

Pentaerythritol may comprise a compound according to formula $C(CH_2OR)_4$, wherein R may be H, or wherein R may be a fatty acid moiety comprising 5-8 carbon atoms. The fatty acid moieties can be saturated or unsaturated. R may be also another moiety like ether, amide and/or urethane. As Pentaerythritol Perstorp Charmor PM 40 may be used.

Furthermore, the polar compound may be an ether. The ether may comprise but not limited to compounds that contains at least one ethyleneglycol moiety and at least one fatty acid moiety coupled to the ethyleneglycol moiety.

Examples of compound that contains at least one ethyleneglycol moiety and at least one fatty acid moiety coupled to the polyethyleneglycol moiety include PEG 300-monostearate, PEG 400 monolaurate.

The carboxylic acid ester may comprise a compound according to the following chemical formula 3:

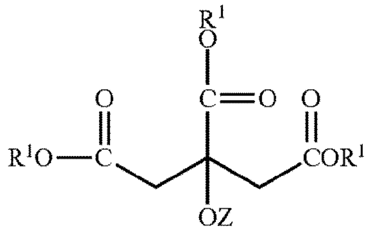

Chemical Formula 3

wherein $R^1$ is an alkyl group comprising 1-20 carbon atoms and Z is hydrogen or a group according to the formula $C(O)R^2$, wherein $R^2$ is an alkyl group comprising 1-20 carbon atoms. $R^1$ may be the same or different and is an alkyl group comprising 1-20 carbon atoms, preferably 1-15 carbon atoms, more preferably 1-10 carbon atoms. $R^2$ is an alkyl group comprising 1-20 carbon atoms, preferably 1-10 carbon atoms, more preferably 1-5 carbon atoms. Non-limiting examples of the carboxylic acid ester are triethylcitrate, tributylcitrate, trihexylcitrate, acetyltributylcitrate (ATBC; $R^1$ = $C_4H_9$, Z = $CH_3CO$), propanoyltributylcitrate, acetyltrihexylcitrate and butanoyltriethylcitrate.

Furthermore, as polar compound 4-(hydroxymethyl)cyclohexylmethyl-4'-(hydroxymethyl)cyclohexane carboxylate represented by the chemical formula 1, 4,4-(oxybis(methylene)bis) cyclohexane methanol represented by the chemical formula 2, and mixtures thereof may be used:

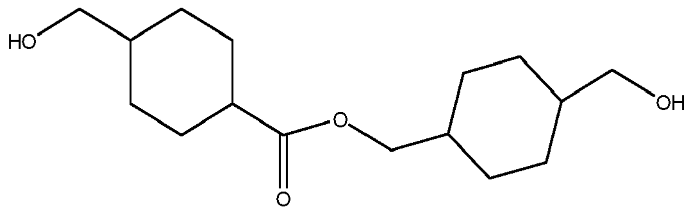

Chemical Formula 1

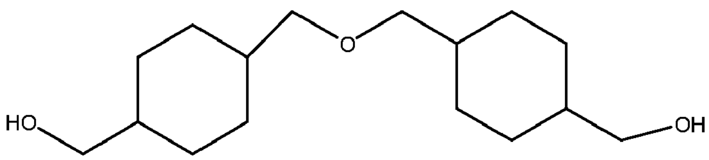

Chemical Formula 2

**Non-polar polymer**

As already mentioned above, the plastic material may comprise a non-polar-polymer or mixtures of non-polar polymers. In connection to this non-polar-polymer the non-polar-polymer may be selected from the group of polyalkylene polymers, polyalkylene copolymers, polyakylene block copolymers. The non-polar-polymer may be preferably selected from polymeric aliphatic or aromatic hydrocarbons, preferably polyalkylene polymers, polyalkylene co- and terpolymer with random or block-structure; and more preferred from polyethylen (PE), polypropylene (PP), polybutene (PB), polystyrene, polyisobutylene, polybutadiene, polyisoprene. Preferably the non-polar-polymer has a wt.-% of heteroatoms below 5 wt.-% with respect to the mass of the non-polar-polymer. Preferably the non-polar polymer has a molecular weight Mw $\geq$ 1000 g/mol, preferably Mw $\geq$ 1200 g/mol, more preferably Mw $\geq$ 1500 g/mol.

**Further components**

The plastic material may comprise further components, e.g. to improve the processing behaviour of the plastic material when producing the plastic article, or in order to enhance the accessibility of the decoloring bath to the coloring agent, and thus improve the decolorability of the colored plastic article.

**Water-soluble or water-swellable component**

As already mentioned, the plastic material may comprise further components in order to enhance decolorability of the colored plastic article. To this regard and according to a preferred embodiment of the invention the plastic material comprises a water-soluble and/or water-swellable component in an amount of $\geq$ 0.01 wt% to $\leq$ 10 wt%, based on the weight of the plastic material.

The water-soluble or water-swellable component is preferably a compound that dissolves, disperses, and/or swells in water and/or under the conditions present in the decoloring bath. Thus, the decoloring bath can access the

coloring agent within the color layer of the plastic article.

To this regard, the water-soluble or water-swellable component is preferably a water-soluble polymer, a water-swellable compound, a disintegrating agent, or mixtures thereof.

Water-soluble polymer

According to a preferred embodiment of the invention the water-soluble polymer has a molecular weight Mw ≥ 1000 g/mol, preferably Mw ≥ 1200 g/mol, more preferably Mw ≥ 1500 g/mol.

In the context of this application, a polymer is considered water soluble if the weight loss of a sample of the water-soluble polymer according to ISO 294-3 (cavity dimensions: W x L x T = 62 x 62 x 1.1 $mm^2$) is more than 2 wt% when stored or treated according to either of the following method 1 or method 2. The weight loss in % is calculated according to:

$$weight\ loss\ in\ \% = \frac{conditioned\ weight\ after\ test - conditioned\ weight\ before\ test}{conditioned\ weight\ before\ test}\ x\ 100$$

Before testing the specimens are dried in an oven at 60°C for 48h and then placed in a desiccator to cool. Immediately upon cooling the specimens are weighed.

For method 1 the specimens are then emerged in 500 mL of water at 23°C for 24 hours. Specimens are removed, patted dry with a lint free cloth, and weighed.

For method 2 the specimens are then emerged in 500 mL of boiling water (100 °C) for 30 min. Specimens are removed, patted dry with a lint free cloth, and weighed.

Water-soluble polymers usually have hydrophilic groups as substituents and/or incorporated into the backbone of the polymer. The hydrophilic groups may be nonionic, anionic, cationic or amphoteric. In other words, the monomer units of water-soluble polymers have a significantly higher number of heteroatoms such as nitrogen (N), oxygen (O), sulfur (S) or halogens (esp. F, Cl, Br) compared to water insoluble polymers. This results in a higher polarity and thus better solubility compared to insoluble polymers.

According to a preferred embodiment of the invention the water-soluble polymer is selected from the group comprising polyelectrolytes, non-ionic polymers, hydrophobic-associating polymers, and water soluble polysiloxanes.

a) Polyelectrolytes

Polyelectrolytes are polymers that have charged groups. They can be divided into polycations (positively charged), polyanions (negatively charged) or amphoteres (zwitterions, positively and negatively charged). Polyelectrolytes include proteins, but also numerous synthetically produced polymers.

Useful polyelectrolytes include but are not limited to poly carboxylic acids (collective term), poly acrylic acid (carbomer), poly methacrylic acids, poly maleic acid, maleic acid co- and terpolymers, poly sulfonic acids such as sodium poly styrene sulfonat, acrylic ester-acrylic acid copolymers as available from Belland Technology, sulfonated acrylic copolymers, poly vinyl sulphuric acid, phosphino poly carboxylates, poly phosphoric acids, alginates, ligno sulphonates, naphtyl sulphonates, Pectins, quaternary polyamines (collective term), partially hydrolyzed polyacrylamide (HPAM), acrylamide copolymers, poly vinyl amines, poly ethylene imines, polyquaternium especially Polyquaternium 6 (pDADMAC), dicyandiamide resins, cationic starch, poly vinyl pyridine, poly vinyl ammonium chloride, poly saccharides, acrylamide-acrylic acid-DMAEA-MeCl or DADMAC-acrylic acid, polybetaines in which the charges are paired.

b) Water-soluble non-ionic polymers

Preferably the group of water-soluble non-ionic polymers include but are not limited to polyethylene oxides, polyethylene oxide-polypropylene oxide copolymers, poly amide, poly-N-vinyl pyrrolidone, (N)-vinyl pyrrolidone-vinyl imidazole-copolymers, poly vinyl alcohol (PVAL or PVOH), polyacrylamide (PAM), acrylamide copolymers or poly (vinylmethyl ether) (PVME).

c) Water-soluble hydrophobically associating polymers

Water-soluble hydrophobically associating polymers (AP) are water-soluble polymers that contain a small number i.e. < 1 mol% of hydrophobic groups attached directly to the polymer backbone.

d) Water soluble polysiloxanes

Water soluble polysiloxanes are polymerised siloxanes or polysiloxanes, which are inorganic-organic polymers with a silicon-oxygen backbone.
Useful water-soluble polymers are available under the tradename Mowiflex from Kuraray Europe GmbH, or Sokalan from BASF SE. Kuraray Europe GmbH defines certain temperatures (30, 50 or 70°C) for their polyvinyl alcohols at which the polymers first become water-soluble (Mowiflex).

Water-swellable compound

According to a preferred embodiment of the invention, the water-swellable compound is an inorganic compound or is a polymer having a molecular weight Mw ≥ 1000 g/mol, preferably Mw ≥ 1200 g/mol, more preferably Mw ≥ 1500 g/mol, wherein the water-swellable compound has a swelling capacity of ≥ 25 wt%, preferably ≥ 100 wt%, more preferably ≥ 200 wt%.
The swelling capacity of the water-swellable compound is determined according to ASTM D570 or ISO 62. Water-swellable compound are usually crosslinked polymer networks that have hydrophilic groups as substituents and/or incorporated into the backbone of the polymer. Because of the inherent cross-links, the water-swellable compound preferably does not dissolve in water.
Furthermore, instead of polymers inorganic compounds that show a high swelling capacity can be used as water-swellable compounds, especially phyllosilicates such as bentonite, preferably montmorillonite.
In principle, all the above-mentioned water-soluble polymers that can be covalently or ionically crosslinked are swellable in their crosslinked form. The swelling capacity in a solvent or swelling agent such as water is determined, among other things, by their degree of cross-linking.
According to a preferred embodiment of the invention the water-swellable compound is selected from the group comprising bentonite, preferrebly montmorillonite; cross-linked poly acrylamide and its copolymers, starch, cellulose, cellulose derivatives such methyl cellulose (MC), microcrystalline cellulose (MCC), hydroxypropylmethyl cellulose (HPMC), ethylhydroxyethyl cellulose (MHEC), hydroxypropyl cellulose (HPC), hydroxyethyl cellulose (HEC), sodium carboxymethyl cellulose (NaCMC) and carboxymethylcellulose; crosscarmellose, sodium croscarmellose, crospovidone, sodium starch glycolate. alginic acids, dextrans and cross-linked polyvinylpyrrolidones, cross-linked poly(vinyl alcohol) and copolymers such as Ethylene-vinyl alcohol copolymers with different degrees of saponification, cross-linked polyethylene oxide and starch grafted copolymer of polyacrylonitrile.
Useful water-swellable compounds are available under the tradenames Ac-Di-Sol from DuPont de Nemours, Disolcel from chemopharma Chemikalien- und Pharmazeutika Handelsges.m.b.H., Solutab from Roquette Frères, Vivasol from JRS PHARMA GmbH & Co. KG.

Disintegrating agent

Furthermore, there are compounds whose solubility is dependent on the conditions of the solvent e.g. its pH or the solubility is produced by a chemical reaction between the component and the solvent, since only a chemical reaction between the compound and the solvent leads to the dissolution of the compound. For example, some manufacturers specify specific pH values for their polymers at which the polymers first become water-soluble (e.g. various BellandPolymers types from Belland Technology: Belland Polymer 88410; soluble at pH > 10 or alkali-solulable-resins (ASR) from Hanwah: Soluryl 840).
Accordingly, the disintegrating agent can be a polymer having a molecular weight Mw ≥ 1000 g/mol, preferably Mw ≥ 1200 g/mol, more preferably Mw ≥ 1500 g/mol, that is only soluble in water below or above a specific pH values e.g. through the conversion of acids to the corresponding salts in an alkaline environment or the conversion of amines into ammonium groups in an acidic environment.
In the context of this application, a polymer is considered a disintegrating agent, when the weight loss of a sample of the disintegrating agent according to ISO 294-3 (cavity dimensions: W x L x T = 62 x 62 x 1.1 $mm^2$) is more than 2 wt% when treated according to the following method 3. The weight loss in % is calculated according to:

$$weight\ loss\ in\ \% = \frac{conditioned\ weight\ after\ test - conditioned\ weight\ before\ test}{conditioned\ weight\ before\ test}\ x\ 100$$

Method 3: Before testing the specimens are dried in an oven at 60°C for 48h and then placed in a desiccator to cool. Immediately upon cooling the specimens are weighed. Afterwards the specimens are emerged in 500 mL of water having a pH ≥ 10 or a pH ≤ 4 for 24 hours at 80°C. Specimens are removed, patted dry with a lint free cloth, and

weighed.

According to a preferred embodiment of the invention, the disintegrating agent is selected from the group comprising poly glycolide, polylactide, poly hydroxy propionate, poly hydroxy butyrate, poly ε-caprolactone, glycolized or amorphous aliphatic-aromatic polyesters, glycolized or amorphous polyethylene terephthalate (PET-G or A-PET), polytrimethylenterephthalte (PTT) polybutylenterephthalate (PBT), poly acrylate-acrylic acid copolymers soluble at a pH ≥ 10, and blends of poly acrylate-acrylic acid copolymers with poly ethylene acrylic acids soluble at a pH ≥ 10.

Useful disintegration agents are also available under the tradename Belland Polymers from Belland Technology or under the tradename Soluryl from Hanwah.

In the case of saponification of esters, further additives can be added to the decoloring bath that accelerate the saponification of the esters, such as quaternary ammonium compounds like Peristal PEA available from Textilchemie Dr. Petry GmbH.

According to another preferred embodiment of the invention, the color layer comprises the plastic material and the coloring agent, wherein the plastic material comprises at least 0,1 wt.-% of the polar component, based on the weight of the plastic material and the water-soluble and/or water-swellable component in an amount of ≥ 0.01 wt% to ≤ 10 wt%, based on the weight of the plastic material, and wherein the coloring agent comprises an organic molecule with a molecular weight Mw ≥ 300 g/mol, preferably Mw ≥ 400 g/mol.

Especially when using coloring agents with molecular weights above 400 g/mol, the water-soluble and/or water-swellable component enhanced decolorability of the plastic article.

## Plastic article and color stability of plastic article

Not only different polymer processing technique can be used in order to provide the uncolored and uncoated plastic article or the colored and uncoated plastic article, but also different types of colored plastic articles and in particular colored plastic articles comprising the outermost layer may be produced.

According to preferred embodiments of the invention, the colored plastic article is selected from the group comprising a sheet, a foil, a container, a part, a tube, a profile, a non-woven fabric, and preferably the article is selected from the group comprising rigid packaging such as bottles, jars, caps and closures, color coded packaging and containers of all types, including ones for industrial components, computer face-plates, keyboards, bezels and cellular phones, residential and commercial lighting fixtures and components therefor, such as sheets, used in building and in construction, tableware, including plates, cups and eating utensils, small appliances and their components, optical and sun-wear lenses.

According to another preferred embodiment of the invention, the colored plastic article is a container, preferably a container suitable for containing a liquid, wherein the container comprises a body defining an interior chamber and at least one wall, wherein the wall comprises at least the outermost layer and the color layer, and wherein the outermost layer is arranged such that it faces the interior chamber of the container. In other words, the plastic article is preferably a container for a liquid, such as a bottle. However, the outermost layer of the bottle does not face the exterior of the bottle, but the interior - or in other words the inner side of the wall of the plastic bottle is coated with the outermost layer. This allows that the product within the container is effectively protected from contaminations of the color layer, and in particular of the coloring agent.

In addition, it would also be possible to provide the outer side of the container or the colored layer with a barrier layer. This protects, for example, the consumer or user, or also an outer packaging, from the coloring agent in the color layer or the colored container from rub-off or fading.

As already mentioned, due to the outermost layer, the colored plastic article has an enhanced color stability. In this regard and according to a preferred embodiment of the invention, the plastic article comprising the outermost layer is color stable under any or any combination of the following conditions:

exposure to water for 10 d at 60 °C;
exposure to ethanol 95 % for 10 h at 60 °C;
exposure to a 0,1% alkaline solution of $NaHCO_3$ for 2 h at 60 °C
exposure to a 3% acetic acid solution in water for 10 h at 60 °C;
exposure to a solution of 20 % ethanol and 3 % acetic acid in water for 10 h at 60°C;
exposure to sun flower oil for 10 d at 60°C;
fastness to washing according to DIN EN ISO 105-C06 C2S;
fastness to perspiration according to DIN EN ISO 105-E04.

To this regard and according to another preferred embodiment the colored plastic article comprising the outermost layer is color stable under the food safety requirements defined by any or any combination of the following norms: DIN 16524-2, CEI 05-59; DIN 16524-1 to DIN 16524-3, JN 16-80; DIN 10955; DIN 16524-3, CEI 11-60; DIN 16524-3,

CEI 08-60; CEI 20-80; JN 17-80; DIN 16525, CEI 19-79; DIN 16524-1; DIN 53415; DIN 16524-3, CEI 10-60; DIN 53375; CEI 18-77; DIN 16524-2, CEI 06-59; DIN 16524-3, CEI 09-60; DIN 53415; DIN 16524-2, CEI 07-59; and DIN 16524-1, CEI 03-59.

In the context of this invention being color stable preferably means, that the remaining color strength after being exposed to one of the above conditions and/or norms is ≥ 75%, preferably ≥ 85%, more preferably ≥ 95%. The remaining color strength is the color strength K/S of the plastic article before migration test minus the loss of color strength K/S during the migration test in % with color strength K/S according to Kubelca-Munk. Color strength according to Kubelca-Munk can be determined by the spectrophotometer Konica-Minolta 3600A at maximum absorbance. In addition, or alternatively to detecting the color change of the plastic article, the color stability of the plastic article can be determined by detecting the color change of the extraction medium of the extraction test and/or the color change of a polar decoloring agent as dye absorbing agent that is added to the extraction medium prior to the test. In this regard the color change of the extraction medium and/or the polar decoloring agent is determined by visual inspection based on DIN ISO 105 A03 and A02. Preferably with regard to this assessment, the plastic article is considered color stable when 2 or less points are assigned in the visual inspection (see table 5). The polar decoloring agent as dye absorbing agent preferably is a poly amide (PA6, melting point 220°C, viscosity number (acc. to ISO307; 96% sulfuric acid) 187 -203 g/cm$^3$; spherical granulate with diameter 2.0 - 2.5mm).

**Decoloring the plastic article**

As already mentioned, it is an object of the invention to provide a method for decoloring the above-described colored plastic article, wherein the method comprises the steps of

a) shredding the colored plastic article to a granulate and/or a powder,
b) exposing the granulate and/or powder to a decoloring bath for about ≥ 1 minute to about ≤ 240 minutes, wherein the decoloring bath has a temperature above a glass transition temperature $T_g$ of the colored plastic article and below a melting temperature $T_m$ and/or decomposition temperature of the colored plastic article and/or has a temperature ≥ 60 °C to ≤ 130 °C,

wherein the decoloring bath comprises

- water,
- at least one polar solvent and/or at least one non-polar solvent, and
- an oxidizing agent or a reducing agent and/or a polar decoloring agent,

wherein the decoloring bath has a pH about ≥ 8, and wherein the pH of the decoloring bath is adjusted by adding a base, preferably NaOH or
wherein the decoloring bath has a pH about ≤ 6, and wherein the pH of the decoloring bath is adjusted by adding an acid, preferably HCl.

Preferably step b) i.e. exposing the granulate and/or powder to a decoloring bath for about ≥ 1 minute to about ≤ 240 minutes, wherein the decoloring bath has a temperature above the glass transition temperature $T_g$ of the colored plastic article and below a melting temperature $T_m$ and/or decomposition temperature of the colored plastic article and/or has a temperature ≥ 60 °C to ≤ 130 °C, comprises exposing the granulate and/or powder to a decoloring bath for about ≥ 1 minute to about ≤ 240 minutes, wherein the decoloring bath has a temperature above the glass transition temperature $T_g$ of the plastic material and below a melting temperature $T_m$ and/or decomposition temperature of the plastic material and/or has a temperature ≥ 60 °C to ≤ 130 °C.

In case the plastic article is a plastic article comprising in addition to the color layer and the outermost layer, an additional layer or additional layers, it may be possible that a material of the additional layer is not the same as the plastic material. However, since the additional layers are preferably free of a coloring agent, the temperature of the decoloring bath is preferably adjusted according to the glass transition temperature $T_g$, the melting temperature $T_m$ and/or the decomposition temperature of the plastic material.

Surprisingly the recycling process of the colored plastic article is not impaired by the outermost layer of the plastic article. Instead, the outermost layer, which survives everyday use of the plastic article undamaged, was found to be sensitive to the recycling process, such the outermost layer detaches and/or dissolves from the color layer within short time/within seconds. It is believed that mechanical stress, such as shredding of the colored plastic article, chemicals such as the composition of the decoloring bath and/or the physical parameters of the recycling process, such as the elevated temperature, contribute to the finding, that the colored plastic article comprising the outermost layer can be easily decolored. Furthermore, since the outermost layer detaches and/or dissolves, the decoloring bath can access the

plastic material, into which the coloring agent is integrated, and effectively decolor the plastic material. During the decoloring process, the coloring agent preferably migrates out of the plastic material and into the decoloring bath.

As already mentioned, the combination of the outermost layer and low molecular weight organic molecules as coloring agents for the colored plastic article has the advantage that the colored plastic article has a high color stability and environmentally friendly recycling of the colored plastic article possible. Further acceleration of the decolorization process is possible by using water- or alkali-soluble and/or swellable further components in the plastic material. Preferably, the outermost layer of the colored plastic article has no effect on the physical and in particular on the thermal properties of the plastic material. Preferably, the method for decoloring allows to reuse at least 85 %, of the plastic material after the decoloring process.

In a first step of the decoloring process, the colored plastic article is shredded to a granulate and/or a powder. In this regard and according to a preferred embodiment of the invention the colored plastic article is shredded to a granulate or powder having a mean particle size of 0,1 mm to 40 mm, further preferred 0,2 mm to 20 mm and most preferred 0,25 mm to 15 mm. A low particle size enables for a fast decoloring in the decoloring bath.

Furthermore, and according to another preferred embodiment of the invention the weight ratio of the granulate and/or powder to the decoloring bath is 1:2 to 1:50, preferably 1:10 to 1:40, more preferably 1:20 to 1:30 (granulate and/or powder : decoloring bath). This enables a fast decoloration without excess waste.

**Temperature**

It may be preferred that the decoloring bath has a temperature adjusted according to specific properties of the colored plastic article and/or the plastic material. Preferably, the decoloring bath has a temperature selected ≥ a glass-transition temperature $T_g$ and below a decomposition temperature of the colored plastic article and preferably the plastic material. This may have the advantages that the decoloring of the granulate and/or power is speeded up. Furthermore, in case a solid polar decoloring agent is used, the temperature of the decoloring bath may be selected ≥ the glass-transition temperature $T_g$ and below the decomposition temperature of the solid decoloring agent.

The glass transition temperature $T_g$ may be the gradual and reversible transition in amorphous regions of the plastic material and/or the solid polar decoloring agent from a hard and relatively brittle state into a viscous or rubbery state as the temperature is increased. The glass transition temperature $T_g$ of the colored plastic article, plastic material, and/or the solid polar decoloring agent may be determined by differential scanning calorimetry (DSC), which is a thermoanalytical technique in which the difference in the amount of heat required to increase the temperature of a sample and reference is measured as a function of temperature.

The glass transition temperature $T_g$ may be determined according to the following standards: DIN 51007 (Thermal Analysis - Differential Thermal Analysis and Differential Scanning Calorimetry - General Principles), ASTM E 474, ASTM D 3418, DIN EN ISO 11357-1 (Plastics - Differential Scanning Thermal Analysis Part 1: General principles. (2008)), ISO 11357-2 (Plastics - Differential Scanning Calorimetry Part 2: Determination of the glass transition temperature. (1999)), ISO / DIS 11357-3 (Plastics - Differential Scanning Calorimetry Part 3: Determination of the melting and crystallization temperature and the melting and crystallization enthalpy. (2009)), ISO 11357-4(Plastics - Differential Scanning Thermal Analysis (DSC) Part 4: Determination of specific heat capacity. (2005)).

The glass transition temperature $T_g$ may be determined using a Mettler Toledo DSC 3+ differential calorimeter, a sample amount of 10 +/- 1 mg, nitrogen as purge gas, and the following settings: 1. Heating: -40 °C to 280 °C with 20 °C/min, Hold: 3 minutes at 200 °C, Cooling: 280 °C to -40 °C at 10 °C/min, Hold: 5 minutes at -20 °C, 2. Heating: -40 °C to 300 °C at 20 °C/min.

The melting temperature $T_m$ and/or decomposition temperature of the colored plastic article and/or the plastic material may be determined according to the same standards and procedures as used for determining the glass transition temperature $T_g$ of the colored plastic article and/or plastic material. Not all polymers can be molten, e.g. elastomers unlike thermoplastics cannot be molten. Heating only leads to decomposition, where the chemical structure of the polymer decomposes. Preferably the decomposition temperature refers to the temperature were thermal degradation takes place, i.e. where damaging chemical changes take place, without the simultaneous involvement of other compounds such as oxygen. The decomposition temperature of the plastic article and/or the plastic material may also be determined by thermogravimetric analysis (TGA).

**Time**

According to another embodiment the granulates of the colored plastic article are exposed to the decoloring for about ≥ 1 minute to about ≤ 240 minutes, preferably about ≥ 1 minute to about ≤ 180 minutes, further preferred for about ≥ 5 minutes to about ≤ 60 minutes, and also preferred for about ≥ 10 minutes to about ≤ 20 minutes.

**Decoloring bath**

The decoloring bath used for decoloring the colored plastic article comprises

- water,
- at least one polar solvent and/or at least one non-polar solvent, and
- an oxidizing agent or a reducing agent and/or a polar decoloring agent,

wherein the decoloring bath has a pH about ≥ 8, and wherein the pH of the decoloring bath is adjusted by adding a base, preferably NaOH or
wherein the decoloring bath has a pH about ≤ 6, and wherein the pH of the decoloring bath is adjusted by adding an acid, preferably HCl.

In other words, the decoloring bath is an acidic or basic aqueous decoloring bath. In addition to the water, the decoloring bath comprises the polar solvent or the non-polar solvent, or both, i.e. the polar solvent and the non-polar solvent. Furthermore, the decoloring bath comprises either an oxidizing agent or a reducing agent. Alternatively to the oxidizing agent or the reducing agent, or in addition to the oxidizing agent or the reducing agent, the decoloring bath comprises the polar decoloring agent.

According to another preferred embodiment of the invention the decoloring bath further comprises

- an aromatic ester, such as benzyl benzoate;
- a surfactant selected from non-ionic and/or anionic surfactants such as isotridecanolethoxylat and/or sodium salts of $C_9$ to $C_{13}$ - alkyl substituted benzene sulfonic acid;
- a levelling agent;
- a solvent additive, such as camphor oil; and/or
- a dispersing agent.

These additives may improve the decoloring by softening the plastic material and/or by improving the affinity of the coloring agent to the decoloring bath. Thus, the time for decoloring may be shortened and/or the decoloring may be improved.

According to another preferred embodiment of the invention the total amount of theses additives - i.e. the sum of the aromatic ester, the surfactant, the levelling agent, the solvent additive and/or the dispersing agent - in the decoloring bath is preferably less than 30 g/L, more preferably less than 10g/L, even more preferably less than 5 g/L, based on the volume of the decoloring bath.

**Polar solvent**

The polar solvent enhances the decolorization process. According to a preferred embodiment the polar solvent is liquid at about 23 °C. Preferably the polar solvent comprises at least one polar solvent or a mixture of polar solvents, wherein the polar solvent is a solvent or solvent mixture having a dipole. Further preferably the polar solvent is selected from the group comprising polar organic solvent. In particular the polar solvent is selected from the group is comprising

C1 to C15 - alcohol, preferably ethanol, isopropanol, propanol, butanol, pentanol, hexanol, heptanol, octanol, nonanol, decanol, undecanol, dodecanol, tridecanol, tetradecanol, pentadecanol and its isomeres, glycols, glycols such as diethylene glycol and its oligomers, further C3 to C15 diols such as propanediol, butanediol or pentanediol or triols such as glycerol, more preferred C3 to C15 - alcohols, and furthermore preferred C9 to C12 - alcohols.

Further preferred the polar solvent forms a homogenous mixture with water and further preferred the polar solvent is a mixture of liquids forming a homogeneous mixture when added together and when added to water. In the decoloring process the coloring agent enriches in the water phase and/or polar phase and can be separated therefrom by known techniques. Using a polar solvent that is liquid at about 23 °C in the decolorization process may facilitate decolorization since liquid solvents may be easy to handle.

The polar solvent preferably has a dipole moment, more preferably an electric dipole moment. The dipole moments may be due to a non-uniform distribution of positive and negative charges on the various atoms. The polar solvent may have a permanent dipole, an instantaneous dipole and/or an induced dipole. More preferably it may have a permanent dipole.

It may be advantageous to use a mixture of polar solvents. It may be also possible to use different polar solvents including organic polar solvents that may not form a homogenous mixture. The mixture of solvents can be a homogenous mixture, an emulsion or showing phase separation.

## Non-polar solvent

According to a preferred embodiment of the invention the decoloring bath comprises a nonpolar solvent. The nonpolar solvent may enhance the decolorization process, especially for plastic material comprising a non-polar polymer.

According to a preferred embodiment the nonpolar solvent may be liquid at about 23 °C. Preferably the nonpolar solvent comprises at least one nonpolar solvent or a mixture of nonpolar solvents, wherein the nonpolar solvent is a solvent or solvent mixture not having a dipole, and is preferably selected from the group comprising nonpolar organic solvents. The mixture of solvents can be a homogenous mixture, an emulsion or showing phase separation. The nonpolar solvent may not form a homogenous mixture with water.

According to the above and according to a preferred embodiment the nonpolar organic solvent is selected from the group comprising straight, branched, saturated, unsaturated, and/or cyclic aliphatic C1 to C12 hydrocarbons, aromatic hydrocarbons; wherein the aromatic hydrocarbon is preferably selected from C1 to C5 - alkyl substituted benzene, C2 - alkyl substituted benzene such as Xylol, C3 - alkyl substituted benzene, 1,3,5-trimethylbenzene, 1-ethyl-4-methylbenzene, prop-1-en-2-ylbenzene, propan-2-ylbenzene, propyl benzene, and more preferred C3 - alkyl substituted benzene. Further preferred the nonpolar solvent may be selected from the group comprising straight, branched, saturated, unsaturated, and/or cyclic aliphatic C5 to C12 hydrocarbons, and aromatic C6 to C12 hydrocarbons. A preferred nonpolar solvent is a C8- and/or a C9-aromatic hydrocarbon.

## Amount of polar and/or nonpolar solvent

According to another preferred embodiment of the invention the amount of polar solvent and/or non-polar solvent in the decoloring bath is preferably at least 1 g/L, more preferably at least 5 g/L, even more preferably at least 15 g/L, based on the volume of the decoloring bath. In case the decoloring bath comprises the polar solvent, the amount of polar solvent is at least 1 g/L, more preferably at least 5 g/L, even more preferably at least 15 g/L, based on the volume of the decoloring bath. In case the decoloring bath comprises the non-polar solvent, the amount of non-polar solvent is at least 1 g/L, more preferably at least 2 g/L, even more preferably at least 5g/L, based on the volume of the decoloring bath.

## Oxidizing agent, reducing agents and/or polar decoloring agent

As already mentioned, the decoloring process is based on the migration of the coloring agent out of the plastic material. In order to enhance the decoloring process, the decoloring bath comprise the oxidizing agent, or the reducing agent and/or polar decoloring agent. The oxidizing agent as well as the reducing agent may destroy the coloring agent. The destruction of the coloring agent can be accelerated or simplified by catalysts, e.g. applied to nanostructured fibers over a large area. Such catalysts are available, for example, from Nanofique Ltd.. The polar decoloring agent may adsorb and/or absorb the coloring agent.

The oxidizing agent, the reducing agent and the polar decoloring agent shift the equilibrium of the decoloring reaction towards the decolored plastic article by attacking the coloring agent or by adsorption and/or absorption of the coloring agent, from the decoloring bath. Depending on the composition of the decoloring bath, the decoloring is facilitated by the oxidizing agent or by the reducing agent, which attacks the coloring agent. Alternatively to the oxidizing or reducing agent, or in addition to the oxidizing or reducing agent, the polar decoloring agent for adsorption and/or absorption of the coloring agent can be use. Since the coloring agent is an organic molecule with low molecular weight, the coloring agent can migrate into the polar decoloring agent and thus facilitate decoloring of the plastic article.

## Oxidizing and reducing agents

According to an embodiment, the coloring agent can be destroyed by a chemical oxidation or reduction reaction. This shifts the equilibrium in the decolorization process and enhances decoloring.

Preferred oxidizing agents are selected from the group comprising a peroxide, peroxyacetic acid, hydrogen peroxide, peroxodisulfate, ozone, sodium percarbonate, sodium perborate, sodium percarbonate, m-nitrobenzolsulfonat, $H_2SO_4$, $HNO_3$, oxygen-containing anions (oxo anions) of transition metals in high oxidation states such as permanganate $MnO4^-$, $KMnO_4$, phosphate, oxygen difluoride fluorine, cryptone difluoride, dichromate $Cr_2O_7^{2-}$, metal ions such as $Ce_4^+$, noble metal ions such as those of silver and copper, anions of halo-oxygen acids such bromate $BrO3^-$, halogens, such as fluorine, chlorine, bromine and iodine, hypochlorite, sodium hypochlorite, sodium peroxodisulfate and/or potassium hypochlorite.

Preferred reduction agents are selected from the groups comprising

- hydrogen in combination with precious metal catalyst, preferably H2/Ni, H2/Pd, H2/Pt, hydrides;
- complex hydrides, preferably sodium hydride NaH, lithium aluminum hydride LiAlH4, borohydride salts NaBH4;

- base metals, preferably Li, Na, Mg, Zn; low-valent nitrogen;
- phosphorus and sulphur compounds, preferably amidine sulfonic acid, formamidine sulphinic acid, hydrogen sulfide, sodium sulfide, S2-, Na2S, sulfites, SO2-3, sodium sulfite, sulfurous acid, sulfur dioxide, thiosulphate, sodium dithionite, sodium bisulfite, NaHSO3, formamidine sulfonic acid, zinc hydroxylmethansulfinate, sodium hydroxy methane sulfinate also known as rongalite, thiourea dioxide also known as thiox, sulfonic acid and its derivatives, borohydride salts, sodium hydroxide, sodium carbonate, sodium bicarbonate, sodium oxide, and mixtures of sodium hydroxide and calcium oxide, sulfinic acid derivatives, borohydrides and/or REDULIT GIN;
- sulfinic acid and sulfinic acid derivates, preferably aminoimino methansulfinsaure;
- glucose mixtures with dispersants; and
- formamidine sulphinic acid and zinc hydroxymethanesulfinate.

According to another preferred embodiment of the invention the amount of oxidizing agent or reducing agent in the decoloring bath is preferably at least 1 g/L, more preferably at least 5 g/L, even more preferably at least 10 g/L, based on the volume of the decoloring bath. Further preferably the amount of oxidizing agent or reducing agent in the decoloring bath is preferably less than 25 g/L, more preferably less than 20 g/L, even more preferably less than 15 g/L, based on the volume of the decoloring bath. Further preferably, either the oxidizing agent or the reducing agent are present in the decoloring bath - or in other words, the oxidizing agent and the reducing agent are not present in the decoloring bath at the same time.

**Polar decoloring agent**

The decolorization of the plastic article can be improved by using the polar decoloring agent in the decoloring bath. The polar decoloring agent adsorbs and/or absorbs the coloring agent, i.e. the organic molecule having a molecular weight Mw < 800 g/mol, or in other words the dye, that is present in the decoloring bath.
With respect to the polar decoloring agent, it may be advantageous to select the polar decoloring agent from the group comprising:

- at least one polar-polymer having a Mw of about ≥ 1000 g/mol, and/or
- at least one polar compound having a Mw of about < 1000 g/mol,

wherein the polar decoloring agent before used in the decolorization process is preferably free of a dye.
In the context of this invention the polar-polymer is an organic polymer that comprise at least ≥ 5 wt.-% of heteroatoms, wherein the weight % is calculated based on the weights of the polar-polymer. In this context a heteroatom may be any atom excluding C-atoms and H-atoms. Preferably, the heteroatom may be selected from the group comprising: N, O, F, Cl, Br, I, S, and P. Furthermore, preferably the polar-polymer having a Mw ≥ 1000 g/mol, may each comprise at least ≥ 5 wt.-% and preferably < 70 wt.-% of O-atoms.
In the context of this invention the polar compound is an organic compound that comprise at least ≥ 5 wt.-% of heteroatoms, wherein the weight % is calculated based on the weights of the organic compound. In this context a heteroatom may be any atom excluding C-atoms and H-atoms. Preferably, the heteroatom may be selected from the group comprising: N, O, F, Cl, Br, I, S, and P. Furthermore, preferably the polar compound having a Mw < 1000 g/mol, may each comprise at least ≥ 5 wt.-% and preferably < 70 wt.-% of O-atoms.
In other words, the polar decoloring agent may comprise the same substances as the plastic material, in particular preferably the polar polymer and/or the polar compound. The decolorization of the colored plastic material may be based on a shift of the dynamic equilibrium, due to a higher concentration of polar polymer and/or polar compound in the polar decoloring agent than in the colored plastic material of the plastic article.
With regard to the concentration of the decoloring agent in the decoloring bath and according to another preferred embodiment of the invention, the decoloring bath comprises the polar decoloring agent and the decoloring bath contains 0,1 to 100 g/L polar decoloring agent, preferably 1 to 50 g/L, more preferably 5 to 25 g/L with respect to the volume of the decoloring bath. This ensures that the dynamic equilibrium of the migration process of the coloring agent is shifted to the polar decoloring agent.
The molecular weight of the polar decoloring agent for the adsorption and/or absorption of the dye from the decoloring bath is preferably lower than the molecular weight of the polar polymer and/or non-polar of the plastic material. This further eases the decoloring process. Furthermore, preferably the polar decoloring agent is more polar than the plastic material, preferably more polar than the polar component of the plastic material, preferably more polar than the polar polymer of the plastic material, and preferably more polar than the polar compound of the plastic material. This means in the context of this invention, that the percentage by weight of heteroatoms is higher in the polar decoloring agent than in the plastic material and preferably in the polar component of the plastic material.
The adsorption and/or absorption of the dye to the polar decoloring agent may be enforced by increasing the

amount of electrostatic interaction between dye and the polar decoloring agent. According to a preferred embodiment the polar decoloring agent may comprise polar, acidic, and/or basic groups, wherein polar groups for electrostatic interaction are preferred. More preferred the polar decoloring agent may comprise polar groups selected from the group comprising sulfonyl group, such as tosyl-, brosyl-, nosyl-, mesyl-, trifyl-, tresyl-, and dansyl-, hydroxyl group, amine groups including primary-, secondary-, and tertiary amines, carboxylic groups, imine and enamine groups, ketone groups, carbonyl groups, aldehyde groups, organic amide groups such as sulfone amides and phosphor amides, organic halide groups, and/or carbamate groups.

In case the polar decoloring agent is solid, the particle size of the polar decoloring agent is preferably different than the particle size of the granulate and/or powder generated from the colored plastic article. Preferably the particles size of the granulate and/or powder of the colored plastic article differs from the particle size of the solid polar decoloring agent such that a separation of the granulate generated from the colored plastic article from the solid decoloring agent is possible using a sieve.

Preferably the polar decoloring agent is solid at the temperature of the decolorizing process. According to a preferred embodiment the polar decoloring agent may have the form of flakes, particles, granulates. Preferably the particles, granulates, flakes of the polar decoloring agent may have a mean particle size diameter of 0,01 mm to 100 mm, further preferred 1 mm to 8 mm and also preferred 2 mm to 5 mm. Further preferred the polar decoloring agents are nano-particles, preferably with a mean particle size of about ≥ 1 nm to about ≤ 100 nm. With regard to the form the particles, granulates, flakes of the polar decoloring agent may preferably not have a round shape (worst ratio surface to volume). However, in case nano-particles are used, round shapes may be possible. The design of the polar decoloring agent may have cylindrical form or any other design. Furthermore, it is preferred that the particles, granulates, flakes and/or nano-particles are arranged on or in a surface of a solid substrate. It seems to be important that the shape should be selected such that the ratio surface:volume may be as large as possible.

Having a solid polar decoloring agent in the form of flakes, particles and/or granulates has the advantage that it is possible to filter off the polar decoloring agent. Furthermore, the size of the solid polar decoloring agent is different from the size of the granulates of the colored plastic article to be decolored, such that a separation of the polar decoloring agent from the granulates of the colored plastic article by sieve is possible

However, separation of the polar decoloring agent may also be possible by arranging the polar decoloring agent on or in the surface of a solid substrate. In order to exploit a high surface to volume ratio, it may be preferred to have the polar decoloring agent as nano-particles arranged on the surface of a solid substrate.

In the context of separating the polar decoloring agent from the liquid components of the decoloring bath i.e. from the water, polar solvent and/or the nonpolar solvent, and for separating the polar decoloring agent from the granulates and/or powder of the colored plastic article, and according to a preferred embodiment the polar decoloring agent may get a density below the density of the liquid components of the decoloring bath, due to the absorption and/or adsorption of the dye. Thus, the colored polar decoloring agent may be separated from the liquid components of the decoloring bath. It may be possible that the density of the polar decoloring agent changes by absorbing and/or adsorbing of the dye. The density of the polar decoloring agent may increase above the density of at least one of the liquid components of the decoloring bath. Therefore, due to absorption and/or adsorption of the dye the polar decoloring agent may sink onto the bottom of a reaction vessel and may be easily separated from the liquid components of the decoloring bath, while the granulates generated from the colored plastic article stay in the decoloring bath.

As already mentioned, the polar decoloring agent is preferably select from the group comprising:

- at least one polar-polymer having a Mw of about ≥ 1000 g/mol, and/or
- at least one polar compound having a Mw of about < 1000 g/mol.

The polar decolor agent can be selected from the group of polar polymers described in the context of the plastic material. Furthermore, the polar decolor agent can be selected from the group of polar compounds described in the context of the plastic material.

**pH**

To enable the decolorization process, the pH of the decoloring bath is alkaline or acidic. In a first alternative the decoloring bath has a pH about ≥ 8, more preferably ≥ 10, more preferably about ≥ 11, and wherein the pH of the decoloring bath is adjusted by adding a base, preferably NaOH.

The use of organic bases such as ammonia in order to adjust the pH is also possible.

Alternatively, the decoloring bath has a pH about ≤ 6, more preferably ≤ 4, more preferably about ≤ 3, and wherein the pH of the decoloring bath is adjusted by adding an acid, preferably HCl. The use of organic acids such as formic acid in order to adjust the pH is also possible.

Preferably the pH of the decoloring bath is pH ≥ 8 - or in other words, the decoloring bath is preferably an

alkaline aqueous decoloring bath. This may help to dissolve the outermost layer and thus shortens the time of decoloring.

In case the decoloring bath comprises the polar decoloring agent, one important factors affecting the absorption capacity of the polar decoloring agent for the coloring agent (coloring agent absorption capacity in % = [g of coloring agent to be absorbed]/[g of polar decoloring agent] * 100) is the pH of the decoloring bath. The efficiency of adsorption is dependent on pH, since variation in pH leads to the variation in the degree of ionisation of the coloring agent to be absorbed and the surface properties of the polar decoloring agent.

Therefore, when the polar decoloring agent is used, either in addition to the oxidizing or reducing agent or alternative to the oxidizing or reducing agent, the pH of the decoloring bath is preferably acidic to increase the absorption capacity of the polar decoloring agent.

The amount of polar decoloring agent required depends on the amount of coloring agent in the plastic article and the weight ratio of the granulate and/or powder of the plastic article to the decoloring bath. To this regard, when using the polar decoloring agent, the decoloring bath preferably has a pH about $\leq 6$, more preferably $\leq 4$, more preferably about $\leq 3$, and wherein the pH of the decoloring bath is adjusted by adding an acid, preferably HCl, wherein the decoloring bath preferably contains 0,1 to 100 g/L polar decoloring agent, preferably 1 to 50 g/L, more preferably 5 to 25 g/L with respect to the volume of the decoloring bath.

**Additives**

As already mentioned, the decoloring bath may further comprise additives up 55 g/L, based on the volume of the decoloring bath, such as

- aromatic esters,
- surfactants selected from non-ionic and/or anionic surfactants,
- levelling agents,
- solvent additives and/or
- dispersing agents,

in order to improve the decoloring process.

**Aromatic ester**

According to the above and according to a preferred embodiment of the invention the decoloring bath further comprises an aromatic ester or mixtures of aromatic esters. Further preferably the aromatic ester is selected from the group comprising benzoic acid benzyl esters, naphthalic acid benzyl esters, phthalic acid benzyl esters and/or isophthalic acid benzyl esters, mixed aromatic aliphatic esters comprising benzyl butyl phthalates, and aliphatic esters comprising benzoic acid butyl esters, phthalic acid dibutyl esters, and/or isophthalic acid dibutyl esters; and preferably benzoic acid benzyl ester, benzoic acid esters such as benzyl benzoate, alkyl benzoates such as methyl or ethyl benzoate, naphthalic acid esters, phthalic acid esters. The presence of the aromatic ester in the decoloring bath has shown to improve the decoloring process significantly.

Preferably the amount of the aromatic ester in the decoloring bath is preferably at least 0,5 g/L, more preferably at least 1,5 g/L, even more preferably at least 3 g/L, based on the volume of the decoloring bath. Further preferably the amount of aromatic ester is less than 10 g/L, more preferably less than 7,5 g/L, even more preferably less than 5 g/L, based on the volume of the decoloring bath.

**Surfactants**

According to the above and according to a preferred embodiment of the invention the decoloring bath further comprises a surfactant or mixtures of surfactants. The surfactant is preferably a non-ionic surfactant and/or an anionic surfactant.

Further preferably the non-ionic surfactant is selected from the group of aromatic esters and hydrocarbons, aromatic and non-aromatic carboxylic acid esters, ethyl acrylate, fatty acid esters, alkoxylated, preferably ethoxylated or ethoxylated and propoxylated fatty acid esters, alkoxylated, preferably ethoxylated or ethoxylated and propoxylated fatty acids, poly oxyethylated compounds derived from sorbitol and oleic acid, polysorbate 20, polysorbate 40, polysorbate 60, polysorbate 65, polysorbate 80, polymers that are fatty acid-based with a non-ionic group per molecule, acrylate-copolymers, acrylate/styrene copolymers, fatty acid derivatives, polyalkoxylate, and preferably 2-(2-butoxy-ethoxy)ethanol and in particular preferred isotridecanolethoxylate;

Further preferably the anionic surfactant is preferably selected from the group comprising alkaline salts of a sulfonic acid, wherein the sulfonic acid is preferably selected form the group comprising alkyl benzenesulfonic acid, alkyl

naphtalenesulfonic acid, alkyl phthalic sulfonic acid, isophthalic sulfonic acid benzyl, and a C9-C13-alkyl benzenesulfonic acid.

Preferably the amount of non-ionic and/or anionic surfactants in the decoloring bath is preferably at least 0,1 g/L, more preferably at least 0,5 g/L, even more preferably at least 1,0 g/L, based on the volume of the decoloring bath. Further preferably the amount of non-ionic and/or anionic surfactants is less than 5,0 g/L, more preferably less than 3,0 g/L, even more preferably less than 2,0 g/L, based on the volume of the decoloring bath.

**Levelling agent**

With respect to result of the decoloration process it may be advantageous when the decoloring bath further comprises the levelling agent. The levelling agent may decrease the time that is used for decoloring the granulate and/or powder.

The levelling agent may be an aromatic ester. According to another preferred embodiment the decoloring bath comprises a levelling agent, wherein the levelling agent is preferably selected from the group comprising aromatic esters such as benzoic acid esters such as benzyl benzoate, alkyl benzoates such as methyl or ethyl benzoates, phthalic acid esters, naphthalic acid ester, polyphenylether, phenoles, aromatic alcohols, aromatic ketones, aryl halides, such as halogenized benzene, halogenzide toluene; N-alkylphthalimide, methylnaphthaline, diphenyle, diphenylether, naphtholether, and oxybiphenyle. Levelling agents may also be of natural origin such as coumarin or vanillin. Preferably the levelling agent does not form a homogenous solution with water.

Preferably the amount of levelling agent in the decoloring bath is preferably at least 0,5 g/L, more preferably at least 1,5 g/L, even more preferably at least 3,0 g/L, based on the volume of the decoloring bath. Further preferably the amount of levelling agent is less than 10,0 g/L, more preferably less than 7,5 g/L, even more preferably less than 5,0 g/L, based on the volume of the decoloring bath.

**Solvent additives**

According to the above and according to a preferred embodiment of the invention the decoloring bath may comprise the solvent additive. The solvent additive is preferably selected from the group of organic acids, preferably sulfonic acid, C3 to C6 - ketone, preferably acetone, C2 to C6 - aldehyde, C1 to C6 - carboxylic acid and their derivatives such as formic acid, acid chlorides or acid amides; non-aromatic carboxylic acid esters, such as acetyltributylcitrate (ATBC) and glycerol triacetate (Triacetin), polar aromatic solvents liquid at 23 °C, phenoles, aromatic alcohols, aromatic ketones, N-alkylphthalimide, methylnaphthalene, diphenyle, oxybiphenyle DMSO, DMF, benzylic alcohols, linear or cyclic ethers, diethyl ether, diiso propyl ether, dibutyl ether, diphenylether, naphtholether, tetrahydrofuran; polyphenylether, aliphatic esters, such as methyl acetate, ethyl acetate, butyl acetate, halogenated solvents such as dichloromethane, trichloromethane, benzyl chloride, aryl halides, such as halogenized benzene, halogenzide toluene; oils like anise oil, camphor oil, essential oils and fragrance oils, spindle oil, cedarwood oil, cinnamon oil, citronella oil, peppermint oil, pine oil, lemon oil, fuel oil, mineral oil, polyester resins and polyester softeners.

Preferably the amount of solvent additive in the decoloring bath is preferably at least 2,5 g/L, more preferably at least 5 g/L, even more preferably at least 10 g/L, based on the volume of the decoloring bath. Further preferably the amount of solvent additive is less than 50,0 g/L, more preferably less than 40,0 g/L, even more preferably less than 25 g/L, based on the volume of the decoloring bath.

**Dispersing agent**

The decoloring bath may further comprise a dispersing agent. The dispersing agent may enhance the solubility of the coloring agent in the decoloring bath. Thus, the affinity of the decoloring bath to the coloring agent is enhanced. Preferably the amount of dispersing agent in the decoloring bath is preferably at least 0,5 g/L, more preferably at least 1,5 g/L, even more preferably at least 3,0 g/L, based on the volume of the decoloring bath. Further preferably the amount of dispersing agent is less than 10,0 g/L, more preferably less than 7,5 g/L, even more preferably less than 5,0 g/L, based on the volume of the decoloring bath. Further preferably the dispersing agent is selected form the polar compounds described in the context of the plastic material.

DETAILED DESCRIPTION OF THE EXAMPLES

The invention will be described in the following with reference to the exemplary examples 1a to 10a and 1b to 10b and the comparative examples C1 to C10. Table 3 specifies the process parameters used for generating the outermost layer on the plastic article.

For all examples a colored plastic article is produced. For the exemplary examples a barrier coating is applied

on the surface of the produced colored plastic article, according to the procedure described below. In case the plastic article has the form of a plate (see examples 1 to 8) both sides of the colored plate are coated with the barrier layer. In case the plastic article has the form of a bottle (see examples 9 and 10), the inner side of the bottle is coated with the barrier layer. The comparative examples were left uncoated. The color of the plastic articles with the barrier coating and of the comparative plastic articles without the barrier coating was determined by a photospectrometer.

The color stability of the plastic articles was determined by extraction and migration test. The conditions for the extraction and migration test are given in table 4, the results for the color stability in table 6.

The decoloring of the plastic articles was performed according to the described preferred embodiments of the invention. The conditions of the decoloring bath are given in table 7. Afterwards the decolored plastic granulates were used to produce plastic plates. The colors of the plates produced were measured. These results are given in Table 8.

Colors can be described in the RGB or in the Lab color space. In the examples the coloration of the samples is determined in the Lab color space and measured with a Spectrometer Konika-Minolta CM-3600A - according to the guideline of the INSTRUCTION MANUAL CM-3600A (©2011-2013 KONICA MINOLTA, INC.). The Lab color can be converted into the RGB color.

**The principle of the RGB color space**

This principle is based on the three-color theory. The RGB color space works on the principle of the additive color space. This means that it reproduces the entire color range by mixing the basic colors red, green and blue.

The RGB color space can be found in all self-illuminating systems, such as monitors or television screens. All possible colors are defined by their red, green and blue components and mapped accordingly by the overlay of colored light.

**The principle of the Lab color space**

Unlike the RGB color space, the Lab color space is based on counter-color theory. This is based on the assumption that three separate chemical processes take place in the human retina, which always contain two opposite colors, the two opposite colors striving for balance with one another. An example pair would be the combination of blue and yellow. Lab is used, for example, for photo editing software. While the RGB color space is device-dependent, it is not the Lab color space. RGB includes - regardless of the device - all potentially possible colors, which above all enables the conversion of color definitions from one device to the other.

**Convert RGB to Lab**

It is important for the conversion that Lab coordinates separate brightness information L from the rest of the color information. RGB images do not have such a separation - a change in brightness therefore changes the entire color information. Convert sRGB to Lab: http://colormine.org/convert/rgb-to-lab Conversion Lab to sRGB: http://colormine.org/convert/lab-to-rgb

**The Lab - measuring device**

The Lab is measured with a - Spectrometer Konika-Minolta CM-3600A - according to the guideline of the INSTRUCTION MANUAL CM-3600A (©2011-2013 KONICA MINOLTA, INC.).

**Setup for depositing of inorganic barrier layers:**

Figure 1 shows a schematic drawing of an experimental setup 10 used for depositing the outermost layer on colored and uncoated plastic articles 12. With the shown setup 10, the outermost layer can be depostited on the color layer of the plastic article 12 by means of a microwave driven low pressure plasma

The vacuum chamber 14 is cylindrical and has a volume of $6 \cdot 10^{-3}$ $m^{-3}$. The pumping system consists of a dry compressing screw fore and a roots pump resulting in a base pressure of _≤ $1 \cdot 10^{-2}$ Pa. The pumping system is not shown in figure 1, however the arrow 16 indicates the gas flow to the pumping system. The pressure is controlled by a control valve via a feedback control loop. Based on the measured pressure, the controller regulates the position of the control valve to reach the set pressure of typically 25 Pa.

Microwaves with a frequency of 2.45 GHz are generated by a microwave generator 18, comprising a circulator and a magnetron. The generated microwaves are guided through a rectangular waveguide and are coaxially applied to a Plasmaline antenna 20 in a central axis of the chamber 14.

The Plasmaline antenna 20 is composed of an inner quartz tube 22 for gas feeding, which is surrounded by a

copper tube 24 and itself again surrounded by an outer quartz tube 26. The outer quartz tube 26 is connected to the inner one at the top (see inlet in figure 1).

The microwaves propagate as transversal electromagnetic surface waves along the antenna, and cause the plasma discharge to evolve around the antenna. The copper tube functions as an inner conductor, the outer quartz tube as a dielectric and the plasma as an outer conductor

Different process gases 28, such as argon, hydrogen, nitrogen and oxygen, can be applied via mass flow controllers. Two evaporation systems 30, 32, one for hexamethyldisiloxane 30 and one for hexamethyldisilazane 32, are connected to the gas inlet. All gases 28, 30, 32 are fed into the chamber 14 through the inner quartz tube 22 of the Plasmaline antenna 20.

A metallic bottle shaped substrate holder 34 with open ends is positioned concentrically around the Plasmaline antenna 20. As shown in figure 1, the substrate holder 34 has a simplified bottle shape with open ends for the introduction of bottles with a volume of 1 litre or for the introduction of varying samples, such as the uncoated plastic article, in a cylindrical sample holder 35 made of PET. The substrate holder 34 is placed on a glass cylinder 36 insulating it from ground potential. A voltage signal can be applied to the substrate holder via an electrical vacuum feed-through. This results in a bias potential and a capacitively coupled discharge. If a bias application is not requested, the substrate holder 34 is set to ground potential at the vacuum feed-through.

For such bias applications, the substrate holder 34 was connected to a RF power generator 38 via a vacuum feed through and a matching network 40. An automatic controller 42 was adjusting the matching. The voltage signal ensuing at the substrate holder 34 was tracked at the vacuum feed through by a high voltage probe 44 connected to an oscilloscope 46.

Under normal conditions, hexamethyldisiloxane 30 is a colorless liquid and has a vapour pressure of 56 hPa at a temperature of 25°C. Using it as feed gas in deposition processes, requires a vaporization. Therefore, hexamethyldisiloxane 30 was vaporized in an evacuated (≤ 70 Pa) evaporator by heating it to 53°C. Hexamethyldisiloxane 30 vapour was buffered in a reservoir 48 ensuing a steady state vapour pressure (approx. 70 hPa). Hexamethyldisilazane 32 exhibits a vapour pressure of 18 hPa at a temperature of 25°C. Vaporization is also required to use hexamethyldisilazane 32 as feed gas in deposition processes. Comparable to hexamethyldisiloxane 30, hexamethyldisilazane 32 was vaporized in an evacuated evaporator by heating to 50°C and the flux of hexamethyldisilazane 32 vapour was also controlled by a mass flow controller 50 comprising a valve 52.

The deposition of the outermost layer on the color layer was accomplished by the application of three consecutive plasma processes:

- a pretreatment of the color layer by a pure argon or oxygen discharge for cleaning and activation of polymeric substrates;
- an organosilicon middle layer deposited by processes solely fed with hexamethyldisiloxane 30 and/or hexamethyldisilazane 32;
- the deposition of the outermost layer with a composition ranging from organic silicon based $SiO_xC_yH_z$ layers to inorganic SiOx layers by feeding an oxygen / hexamethyldisiloxane 30 mixture or of an outermost layer with a composition ranging from organic silicon based $SiO_xN_yC_zH_w$ layers to inorganic $SiO_xN_y$ and/or SixOy by feeding an oxygen / hexamethyldisilazane 32 mixture.

A pulse pause between the three consecutive plasma processes allows a complete gas exchange in the plasma chamber 14 before re-ignition.

For the deposition of the outermost layer on an inner side of a bottle the process was as follows:
An Argon pre-treatment for 3 s was performed similar to the above-described process, however, feeding 200 sccm Argon into the chamber 14 instead of the precursor gas 30, 32 and oxygen.

The middle layer was deposited at a pressure of 25 Pa with a precursor flux of 2 sccm of the middle layer precursor hexamethyldisiloxane 30, a MW pulse on time of 1 ms, an off time of 160 ms, and an applied pulse power of 3000W in the absence of oxygen. The middle layer with the middle layer precursor hexamethyldisilazane 32 was deposited under the same conditions. For both precursors 30, 32 the middle layer had a thickness of 8 nm on polypropylene and/or polyethylene.

The outermost layers were deposited at a pressure of 25 Pa with a precursor flux of 2 sccm of the outermost layer precursor hexamethyldisiloxane 30, an oxygen flux of 400 sccm, a MW pulse on time of 4 ms, an off time of 40 ms, and an applied power of 1500W. The outermost layer for the outermost layer precursor hexamethyldisilazane 32 was deposited under the same conditions. For both precursors 30, 32 the outermost layer had thickness of 17nm on polypropylene and/or polyethylene.

The middle layer deposited by one precursor was always combined with the outermost layer of the same precursor, respectively.

**Barrier Coating of samples 1a and 1b to 10a and 10b**

For the coating of examples 1a and 1b to 10a and 10b, the process and the coating parameters I and II were used as in table 3:

Table 3

| Process | Process stage | Time [s] | $\Phi_{Ar}$ [sccm] | $\Phi_{O2}$ [sccm] | $\Phi_{HMDSO}$ [sccm] | $\Phi_{HMDS}$ N [sccm] | $P_{MW}$ [kW ] | $t_{on}$ [ms] | $t_{off}$ [ms] |
|---|---|---|---|---|---|---|---|---|---|
| I | pre-treatment | -- | -- | -- | -- | -- | -- | -- | -- |
| 1a to 5a | middle layer | 50 | 0 | 0 | 50 | -- | 3.0 | 1 | 160 |
| 7a to 10a | outermost layer | 33 | 0 | 400 | 2 | -- | 1.5 | 4 | 40 |
| II | pre-treatment | 5 | 200 | 0 | 0 | -- | 1.5 | 4 | 40 |
| 1b to 5b | middle layer | 5 | 0 | 0 | 50 | -- | 3.0 | 1 | 160 |
| 7b to 10b | outermost layer | 5 | 0 | 400 | 2 | -- | 1.5 | 4 | 40 |
| III | pre-treatment | -- | -- | -- | -- | -- | -- | -- | -- |
| 6a | middle layer | 50 | 0 | 0 | -- | 50 | 3.0 | 1 | 160 |
| | outermost layer | 33 | 0 | 400 | -- | 2 | 1.5 | 4 | 40 |
| IV | pre-treatment | 5 | 200 | 0 | -- | 0 | 1.5 | 4 | 40 |
| 6b | middle layer | 5 | 0 | 0 | -- | 50 | 3.0 | 1 | 160 |
| | outermost layer | 5 | 0 | 400 | -- | 2 | 1.5 | 4 | 40 |

Time: duration of each step;

$\Phi$ = gas flux;
$P_{MW}$: microwave pulse power;
ton: microwave pulse duration;
$t_{off}$: microwave pulse pause;

In processes I the substrate is biased (radio wave substrate bias voltage; $U_{DC}$, self bias = 36V) and in processes II the substrate holder is grounded.

$RF_{power}$: 60W,
$RF_{pulse}$ duration: 4ms,
$RF_{pulse\ pause}$: 40ms,
$RF_{temporal}$ offset: 0

Parameter of processes I and II were used for the deposition of the outermost layer on Polypropylene and Polyethylene platelets and bottles at p = 25Pa

List of Reference signs

10 setup
12 plastic article

14 vacuum chamber
16 arrow depicting gas flow
18 microwave generator
20 Plasmaline antenna
22 inner quartz tube
24 coper tube
26 outer quartz tube
28 process gas
30 evaporation system for hexamethyldisiloxane
32 evaporation system for hexamethyldisilazane
34 substrate holder
35 sample holder
36 glass cylinder
38 RF power generator
40 matching network
42 automatic controller
44 hight voltage probe
46 oscilloscope
48 reservoir
50 mass flow controller
52 valve

**Example 1a**

A colored plastic article in the form of a plate W x H x T = 30 x 50 x 1 $mm^3$ is produced by submerging a translucent white (like frosted glass) plate into a coloring bath comprising Bemacron Blau E-FBL corresponding to a dye having the formula A5.

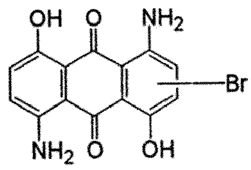

(A5).

A plastic material of the translucent plate is a blend of 92 wt.-% high density polyethylene, HDPE (MFI 20 g/10min @ 190°C, 21.6kg) and 8 wt.-% of poly ε-Caprolactone (MFI 2-4 g/10 min (@160°C, 5kg and MW about 80.000). The colored plate is provided by exposing the uncolored plate of the plastic material into 800 ml of the coloring bath. The coloring bath is an aqueous solution comprising 8 g of Bemacron Blau E-FBL and 160 ml of Ethanol as solubilizer. The plate is submerged into to the coloring bath for about 60 minutes at a temperature of 80° C and at a pH of 2.9. Thereafter the plate - which is now colored - is removed from the coloring bath and rinsed with water of 30° C at least 3 times to remove color residuals on the surface of the plate. The colored plate comprises in a colored surface a colored layer having a thickness of > 50 μm. In other words, the penetration depth of the dye in the plate is at least 50 μm. The achieved coloration is determined to Lab: 13.3/15.7/-37.2 or converted to RGB: 0/30/87.

Subsequent, the colored surfaces of both sides of the colored plate are coated with a barrier layer under the conditions I as described in table 3. The narrow edges (thickness 1 mm) are not coated separately and are completely covered with an epoxy resin that is insoluble in the extraction medium of the respective Extraction Migration Test to avoid falsification of the result.

**Example 1b**

To determine the effectiveness of the barrier coating with regard to the prevention of migration in the stability tests as well as the decolorability, an identical colored plate as in example 1a is provided. Subsequently, the colored surfaces of both sides of the colored plate are coated with a barrier layer under the conditions II as described in table 3. The narrow edges (thickness 1 mm) are not coated separately and are completely covered with an epoxy resin that is insoluble in the extraction medium of the respective Extraction Migration Test to avoid falsification of the result.

**Comparative Example C1 to Example 1a and 1b**

To determine the effectiveness of the barrier coating with regard to the prevention of migration in the stability tests as well as the decolorability, identical reference samples as in example 1a and 1b are left uncoated.

**Example 2a**

A colored plastic article in the form of a plate W x H x T = 30 x 50 x 1 $mm^3$ is produced by submerging the translucent white (like frosted glass) plate into a coloring bath comprising a dye having the formula A8.

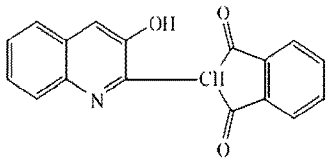

(A8)

The plastic material of the plate is a blend of 85 wt.-% HDPE (MFI 20 g/10min @ 190°C, 21.6kg) and 15 wt.-% of a random copolymer of Ethylene and Methyl Acrylate (MA content 19 - 22%, MFI 8 g/10min @ 190°C, 2.16kg). The colored plate is provided by submerging the uncolored plate of the plastic material into 800 ml of a coloring bath. The coloring bath is an aqueous solution comprising 8 g of an organic aromatic dye having formula A8, a dispersing agent of 30 g Efka® 4300 (an acrylic block-copolymer) obtainable by BASF SE and 200 ml of a solubilizer of Ethanol. The plate is submerged into to the coloring bath for about 45 minutes at a temperature of 90° C and at a pH of 3.0. Thereafter the plate - which is now colored - is removed from the coloring bath and rinsed with water of 30° C at least 3 times to remove color residuals of the surface of the plate. The colored plate comprises in a colored surface a colored layer having a thickness of > 50 μm. In other words, the penetration depth of the dye in the plate is at least 50 μm. The achieved coloration is determined to Lab: 84.7/-3.8/77.6 or converted to RGB: 243/210/46.

Subsequently, the colored surfaces of both sides of the colored plate are coated with a barrier layer under the conditions I as described in table 3. The narrow edges (thickness 1 mm) are not coated separately and are completely covered with an epoxy resin that is insoluble in the extraction medium of the respective Extraction Migration Test to avoid falsification of the result.

**Example 2b**

To determine the effectiveness of the barrier coating with regard to the prevention of migration in the stability tests as well as the decolorability, an identical colored plate as in example 2a is provided. In a subsequent step, the colored surfaces of both sides of the colored plate are coated with a barrier layer under the conditions II as described in table 3. The narrow edges (thickness 1 mm) are not coated separately and are completely covered with an epoxy resin that is insoluble in the extraction medium of the respective Extraction Migration Test to avoid falsification of the result.

**Comparative Example C2 to Example 2a and 2b**

To determine the effectiveness of the barrier coating with regard to the prevention of migration in the stability tests as well as the decolorability, identical reference samples as in example 2a and 2b are left uncoated.

**Example 3a**

A colored plastic article in the form of a plate W x H x T = 30 x 50 x 1 $mm^3$ is produced by submerging the translucent white (like frosted glass) plate into a coloring bath comprising a dye having the formula A6 (Disperse Red 60).

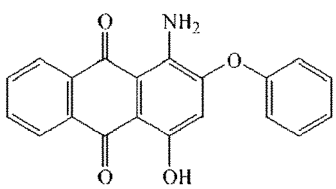

(A6)

The plastic material of the plate is a blend of 90 wt.-% HDPE (MFI 20 g/10min @ 190°C, 21.6kg) and 10 wt.-% of a random copolymer of Ethylene and Acrylic Acid (AA content 11%, MFI 1. 5g/10min, 190°C, 2.16kg). The colored plate is provided by submerging the uncolored plate of the plastic material into 800 ml of a coloring bath. The coloring bath is an aqueous solution comprising 8 g of an organic aromatic dye having formula A6, a dispersing agent of 29 g Ffka® PU 4050 (is a modified polyurethane) obtainable by BASF SE and 200 ml of a solubilizer of Ethanol. The plate is submerged into to the coloring bath for about 50 minutes at a temperature of 93 °C and at a pH of 3.8. Thereafter the plate - which is now colored - is removed from the coloring bath and rinsed with water of 30 °C at least 3 times to remove color residuals of the surface of the plate. The colored plate comprises in a colored surface a colored layer having a thickness of > 50 μm. In other words, the penetration depth of the dye in the plate is at least 50 μm. The achieved coloration is determined to Lab: 54.9/68.4/6.7 or converted to RGB: 235/65/123.

Subsequent to the first step, the colored surfaces of both sides of the colored plate are coated with a barrier layer under the conditions I as described in table 3. The narrow edges (thickness 2 mm) are not coated separately and are completely covered with an epoxy resin that is insoluble in the extraction medium of the respective Extraction Migration Test to avoid falsification of the result.

**Example 3b**

To determine the effectiveness of the barrier coating with regard to the prevention of migration in the stability tests as well as the decolorability, an identical colored plate as in example 3a is provided. In a subsequent step, the colored surfaces of both sides of the colored plate are coated with a barrier layer under the conditions II as described in table 3. The narrow edges (thickness 1 mm) are not coated separately and are completely covered with an epoxy resin that is insoluble in the extraction medium of the respective Extraction Migration Test to avoid falsification of the result.

**Comparative Example C3 to Example 3a and 3b**

To determine the effectiveness of the barrier coating with regard to the prevention of migration in the stability tests as well as the decolorability, identical reference samples as in example 3a and 3b are left uncoated.

**Example 4**

A colored plastic article in the form of a plate W x H x T = 30 x 50 x 1 $mm^3$ is produced in an extruder by an injection molding process by:
mixing a plastic material with a color masterbatch, in a weight ratio of 96:4 (plastic material: color masterbatch)

- wherein the plastic material is PE (Lyondell Basell Hostalen ACP 5831 D)
- wherein the color masterbatch comprises a mixture of the plastic material, ethyl-methacrylat-copolymer (Lotryl 18MA02), acetyltributylcitrate (ATBC) and as dye Disperse Blue 56 (corresponding to the formula A5) in a weight ratio of 35:60:2.5:2.5.

The achieved coloration is determined to Lab: 32/10/-36 or converted to RGB: 49/74/133.

Subsequent to the first step, the colored surfaces of both sides of the colored plate are coated with a barrier layer under the conditions I as described in table 3. The narrow edges (thickness 1 mm) are not coated separately and are completely covered with an epoxy resin that is insoluble in the extraction medium of the respective Extraction Migration Test to avoid falsification of the result.

**Example 4b**

To determine the effectiveness of the barrier coating with regard to the prevention of migration in the stability tests as well as the decolorability, an identical colored plate as in example 4a is provided. In a subsequent step, the colored surfaces of both sides of the colored plate are coated with a barrier layer under the conditions II as described in table 3. The narrow edges (thickness 1 mm) are not coated separately and are completely covered with an epoxy resin that is insoluble in the extraction medium of the respective Extraction Migration Test to avoid falsification of the result.

**Comparative Example C4 to Example 4a and 4b**

To determine the effectiveness of the barrier coating with regard to the prevention of migration in the stability tests as well as the decolorability, identical reference samples as in example 4a and 4b are left uncoated.

**Example 5**

A colored plastic article in the form of a plate W x H x T = 30 x 50 x 1 $mm^3$ is produced in an extruder by an injection molding process by:
mixing a plastic material with a color masterbatch, in a weight ratio of 95:5 (plastic material: color masterbatch)

- wherein the plastic material is PE (Lyondell Basell Hostalen ACP 5831 D),
- wherein the color masterbatch comprises a mixture of the plastic material, ethyl-methacrylat-copolymer (Lotryl 18MA02), Polysorbat 80 and as dye Bemacron Gelb E-3GL (dye corresponding to formula A8) in a weight ratio of 35:60:2.5:2.5.

The achieved coloration is determined to Lab: 80/7/81 or converted to RGB: 245/190/3.
Subsequent to the first step, the colored surfaces of both sides of the colored plate are coated with a barrier layer under the conditions I as described in table 3. The narrow edges (thickness 1 mm) are not coated separately and are completely covered with an epoxy resin that is insoluble in the extraction medium of the respective Extraction Migration Test to avoid falsification of the result.

**Example 5b**

To determine the effectiveness of the barrier coating with regard to the prevention of migration in the stability tests as well as the decolorability, an identical colored plate as in example 5a is provided in the first step. In a subsequent step, the colored surfaces of both sides of the colored plate are coated with a barrier layer under the conditions II as described in table 3. The narrow edges (thickness 1 mm) are not coated separately and are completely covered with an epoxy resin that is insoluble in the extraction medium of the respective Extraction Migration Test to avoid falsification of the result.

**Comparative Example C5 to Example 5a and 5b**

To determine the effectiveness of the barrier coating with regard to the prevention of migration in the stability tests as well as the decolorability, identical reference samples as in example 5a and 5b are left uncoated.

**Example 6a**

A colored plastic article in the form of a plate W x H x T = 30 x 50 x 1 $mm^3$ is produced in an extruder by an injection molding process by:
mixing a plastic material with a color masterbatch, in a weight ratio of 96:4 (plastic material: color masterbatch)

- wherein the plastic material is PE (Lyondell Basell Hostalen ACP 5831 D),
- wherein the color masterbatch comprises a mixture of the plastic material, ethyl-methacrylat-copolymer (Lotryl 18MA02), Polysorbat 80 and as dye Disperse Red 60 (corresponding to the formula A6) in a weight ratio of 35:60:2.5:2.5.

The achieved coloration is determined to Lab: 44/66/48 or converted to RGB: 206/25/27.
Subsequent to the first step, the colored surfaces of both sides of the colored plate are coated with a barrier layer under the conditions III as described in table 3. The narrow edges (thickness 1 mm) are not coated separately and are completely covered with an epoxy resin that is insoluble in the extraction medium of the respective Extraction Migration Test to avoid falsification of the result.

**Example 6b**

To determine the effectiveness of the barrier coating with regard to the prevention of migration in the stability tests as well as the decolorability, an identical colored plate as in example 6a is provided in the first step. In a subsequent step, the colored surfaces of both sides of the colored plate are coated with a barrier layer under the conditions IV as described in table 3. The narrow edges (thickness 1 mm) are not coated separately and are completely covered with an epoxy resin that is insoluble in the extraction medium of the respective Extraction Migration Test to avoid falsification of the result.

**Comparative Example C6 to Example to 6a and 6b**

To determine the effectiveness of the barrier coating with regard to the prevention of migration in the stability tests as well as the perfect decolorability, identical reference samples as in examples 6a and 6bare left uncoated.

**Example 7a**

In a first step of the method a colored plastic article in the form of a plate W x H x T = 30 x 50 x 1 $mm^3$ is produced by submerging a translucent white (like frosted glass) plate into a coloring bath comprising Bemacron Blau E-FBL corresponding to a dye having the formula A5.

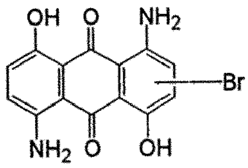

(A5).

A plastic material of the translucent plate is a blend of 92 wt.-% polypropylene, PP (Ineos 240-HP80, MFI 80 g/10min @ 230°C, 2.16kg) and 8 wt.-% of a mixture of an ethylene-methylacrylate-MSA-terpolymer (29%, MSA-content 3%), ethylene-methylacrylate-glycidylacrylat-terpolymer (29%; glycidylcontent 9%) and an amin-terminated polyetheramid (42%; MFI 15g/10min @ 190°C, 2.16kg). The colored plate is provided by exposing the uncolored plate of the plastic material into 800 ml of the coloring bath. The coloring bath is an aqueous solution comprising 8 g of Bemacron Blau E-FBL and 200 ml of Ethanol as solubilizer. The plate is submerged into to the coloring bath for about 60 minutes at a temperature of 85° C and at a pH of 2.9. Thereafter the plate - which is now colored - is removed from the coloring bath and rinsed with water of 30° C at least 3 times to remove color residuals on the surface of the plate. The colored plate comprises in a colored surface a colored layer having a thickness of > 50 μm. In other words, the penetration depth of the dye in the plate is at least 50 μm. The achieved coloration is determined to Lab: 50/5/-45 or converted to RGB: 58/120/195.

Subsequent to the first step, the colored surfaces of both sides of the colored plate are coated with a barrier layer under the conditions I as described in table 3. The narrow edges (thickness 1 mm) are not coated separately and are completely covered with an epoxy resin that is insoluble in the extraction medium of the respective Extraction Migration Test to avoid falsification of the result.

**Example 7b**

To determine the effectiveness of the barrier coating with regard to the prevention of migration in the stability tests as well as the decolorability, an identical colored plate as in example 7a is provided in the first step. In a subsequent step, the colored surfaces of both sides of the colored plate are coated with a barrier layer under the conditions II as described in table 3. The narrow edges (thickness 1 mm) are not coated separately and are completely covered with an epoxy resin that is insoluble in the extraction medium of the respective Extraction Migration Test to avoid falsification of the result.

**Comparative Example C7 to Example 7a and 7b**

To determine the effectiveness of the barrier coating with regard to the prevention of migration in the stability tests as well as the decolorability, identical reference samples as in example 7a and 7b are left uncoated.

**Example 8**

A colored plastic article in the form of a plate W x H x T = 30 x 50 x 1 $mm^3$ is produced in an extruder by an injection molding process by:
mixing a plastic material with a color masterbatch, in a weight ratio of 96:4 (plastic material: color masterbatch)

- wherein the plastic material is PP (Ineos 240-HP80, MFI 80 g/10min @ 230°C, 2.16kg)
- wherein the color masterbatch comprises a mixture of the plastic material, ethyl-methacrylat-copolymer (Lotryl 18MA02), acetyltributylcitrate (ATBC) and as dye Disperse Blue 56 (A5) in a weight ratio of 35:60:2.5:2.5.

The achieved coloration is determined to Lab: 39/10/-40 or converted to RGB: 57/90/157.

Subsequent to the first step, the colored surfaces of both sides of the colored plate are coated with a barrier layer under the conditions I as described in table 3. The narrow edges (thickness 1 mm) are not coated separately and are completely covered with an epoxy resin that is insoluble in the extraction medium of the respective Extraction Migration Test to avoid falsification of the result.

**Example 8b**

To determine the effectiveness of the barrier coating with regard to the prevention of migration in the stability tests as well as the decolorability, an identical colored plate as in example 8a is provided in the first step. In a subsequent step, the colored surfaces of both sides of the colored plate are coated with a barrier layer under the conditions II as described in table 3. The narrow edges (thickness 1 mm) are not coated separately and are completely covered with an epoxy resin that is insoluble in the extraction medium of the respective Extraction Migration Test to avoid falsification of the result.

**Comparative Example C8 to Example 8a and 8b**

To determine the effectiveness of the barrier coating with regard to the prevention of migration in the stability tests as well as the decolorability, identical reference samples as in example 8a and 8b are left uncoated.

**Example 9a**

A colored plastic article in the form of a 200 mL bottle (approx.: W x H x T = 55 x 145 x 30 $mm^3$) is produced by a blow molding process by:
mixing a plastic material with a color masterbatch, in a weight ratio of 96:4 (plastic material: color masterbatch)

- wherein the plastic material is PE (Lyondell Basell Hostalen ACP 5831 D)
- wherein the color masterbatch comprises a mixture of the plastic material, ethyl-methacrylat-copolymer (Lotryl 18MA02), acetyltributylcitrate (ATBC) and as dye Disperse Blue 56 (A5) in a weight ratio of 35:60:2.5:2.5.

The achieved coloration is determined to Lab: 35/12/-35 or converted to RGB: 61/79/140.

Subsequent to the first step, the inner surface of the colored bottle is coated with a barrier layer under the conditions I as described in table 3.

**Example 9b**

To determine the effectiveness of the barrier coating with regard to the prevention of migration in the stability tests as well as the decolorability, an identical colored bottle as in example 9a is provided in the first step. In a subsequent step, the inner surface of the colored bottle is coated with a barrier layer under the conditions II as described in table 3.

**Comparative Example C9 to Example 9a and 9b**

To determine the effectiveness of the barrier coating with regard to the prevention of migration in the stability tests as well as the decolorability, identical reference samples as in example 9a and 9b are left uncoated.

**Example 10a**

A colored plastic article in the form of a 200 mL bottle (approx.: W x H x T = 55 x 145 x 30 $mm^3$; thickness at neck and bottom approx. 1,3 mm and in the belly area approx. 0,6 mm) is produced by a multi-layer blow molding process with a colored outer layer (40% of total wall thickness) and a plain white inner layer (60% of total thickness) by:
for the outer layer mixing a plastic material with a color masterbatch, in a weight ratio of 95:5 (plastic material: color masterbatch)

- wherein the plastic material is PE (Lyondell Basell Hostalen ACP 5831 D)
- wherein the color masterbatch comprises a mixture of the plastic material, ethyl-methacrylat-copolymer (Lotryl 18MA02), an alkaline-soluble resin (Soluryl 840), acetyltributylcitrate (ATBC) and as dye Solvent Blue 104 (A15) in a weight ratio of 35:30:30:2.5:2.5.

for the inner layer using the plastic material, only (100%)

- wherein the plastic material is PE (Lyondell Basell Hostalen ACP 5831 D)

The achieved coloration is determined to Lab: 43/10/-54 or converted to RGB: 0/102/192.

Subsequent to the first step, the inner surface of the colored bottle is coated with a barrier layer under the conditions I as described in table 3.

**Example 10b**

To determine the effectiveness of the barrier coating with regard to the prevention of migration in the stability tests as well as the decolorability, an identical colored bottle as in example 10a is provided in the first step. In a subsequent step, the inner surface of the colored bottle is coated with a barrier layer under the conditions II as described in table 3.

**Comparative Example C10 to Example 10a and 10b**

To determine the effectiveness of the barrier coating with regard to the prevention of migration in the stability tests as well as the decolorability, identical reference samples as in example 10a and 10b are left uncoated.

**Color stability**

The color stability of the plastic articles produced according to the above exemplary examples 1a and 1b to 10a and 10b and comparative examples (C1 to C10) was evaluated by different dye migration tests. The following table 4 summarizes the migration tests (MT) that have been carried out:

Table 4: Migration Tests

| | | Medium/regulation | Temperature | Duration |
|---|---|---|---|---|
| Contact Migration Test | MT 1.1 | PVC | 50°C | 5 h |
| | MT 1.2 | According to DIN EN ISO 105-E04 | | |
| Extraction Migration Tests | MT 2.1 | Water | 60°C | 10 d |
| | MT 2.2 | Ethanol 95% | 60°C | 10 h |
| | MT 2.3 | $NaHCO_3$ 0,1% | 60 °C | 2 h |
| | MT 2.4 | Acetic Acid 3% | 60 °C | 10 h |
| | MT 2.5 | Ethanol 20% and Acetic acid 3% | 60 °C | 10 h |
| | MT 2.6 | Sun flower oil | 60 °C | 10 d |
| | MT 2.7 | According to DIN EN ISO 105-C06 C2S | | |

**Contact Migration Test MT 1.1 and MT 1.2**

The contact migration test MT 1.1 is performed by means of a perspirometer. The individual test specimens are covered on both sides with monomer-softened white PVC and clamped into the perspirometer separated by acrylic plates. The perspirometer remains in a heating cabinet at 50 °C for 5 hours. After taking out the samples, the evaluation is carried out by visual assessment of the change in color of the soft PVC. The contact migration test MT 1.2 was carried out according to DIN EN ISO 105-E04.

For the examples 9a, 9b, 10a and 10b a flat surface of about the same size as the plates (Example 1 to 8) is cut out of the bottle and tested in the same way.

**Extraction Migration Test MT 2.1 to 2.7**

As described above, the platelets 1a to 8a and 1b to 8b are coated with the barrier layer on both sides successively under the same conditions. The narrow edges (thickness 1 mm) are not coated separately and are completely covered with an epoxy resin that is insoluble in the extraction medium of the respective Extraction Migration Test to avoid

falsification of the result.

For the Extraction Migration Tests MT 2.1 to 2.6 the plastic article was extracted in a round bottom flask with reflux condenser under stirring in 25 g the specified medium containing the polar decoloring agent and for the specified time. The plastic article and the polar decoloring agent was then removed from the extraction medium, separated and rinsed under warm water. The extraction medium, the polar decoloring agent and the plastic article are evaluated visually and/or by measuring the color intensity in comparison before and after. The polar decoloring agent is a poly amide (PA6, melting point 220°C, viscosity number (acc. to ISO307; 96% sulfuric acid) 187 -203 g/cm$^3$; spherical granulate with diameter 2.0 - 2.5mm). The Extraction Migration Test MT 2.7 was carried out according to DIN EN ISO 105-C06 C2S.

In the case of the bottle (Examples 9a, 9b and C9, and 10a, 10b, C10), 100 g of the test substance and the polar decoloring agent is filled into the bottle, the bottle is closed and tempered in a climatic cabinet.

The color stability of the plastics articles within the migration tests was assessed by visually comparing the color of the extraction medium and the polar decoloring agent before and after the migration test based on DIN ISO 105 A03 and A02 and/or the percentage loss of color strength K/S according to Kubelca-Munk of the plastic article before and after the migration test.

Color strength according to Kubelca-Munk was measured and calculated by the spectrophotometer Konica-Minolta 3600A at max. absorbance. The remaining color strength is calculated as follows:

$$reamining\ color\ strength = 1 - \frac{(color\ strength\ before - color\ strength\ after)}{color\ strength\ before}\ in\ \%$$

*(before = before decoloring; after = after decoloring and regranulation)*

Visual inspection was performed in a color matching booth under standardized light conditions using a series of platelets, each of which is assigned a level of color.

The assessment of the migration tests was rated by points according to the following Table 5:

Table 5

| Points | Visual inspection of medium | Visual inspection of polar decoloring agent | Remaining color strength of plastic article |
|---|---|---|---|
| 1 | Medium unchanged clear, transparent | Polar decoloring agent unchanged clear, transparent | Plastic article not decolored, remaining color intensity ≥ 90% |
| 2 | Medium weakly colored and color only visible against white background | Polar decoloring agent weakly colored and color only visible against white background | Plastic article decolored, remaining color intensity ≥ 75% and < 90% |
| 3 | Medium recognizable colored | Polar decoloring agent recognizable colored | Plastic article well decolored, remaining colour intensity ≥ 50% and < 75% |
| 4 | Medium well recognizable colored | Polar decoloring agent well recognizable colored | Plastic article very well decolored, remaining colour intensity ≥ 30% and < 50% |
| 5 | Medium heavily colored | Polar decoloring agent heavily colored | Plastic article highly decolored, remaining colour strength < 30% |

The numbers in the left column are counted as points in the evaluation. The lower the total number of points, the higher the overall color stability.

As shown in table 6 the following results for the color stability of the plastic article have been found:

| | | Table 6 | | | | | | | | | |
|---|---|---|---|---|---|---|---|---|---|---|---|
| | | Color Stability | | | | | | | | | |
| | | Contact | | Extraction | | | | | | | |
| # | barrier coating | MT 1.1 | MT 1.2 | MT 2.1 | MT 2.2 | MT 2.3 | MT 2.4 | MT 2.5 | MT 2.6 | MT 2.7 | Total |
| 1a | I | 2 | 2 | 1 | 1 | 1 | 1 | 1 | 1 | 1 | 11 |
| 1b | II | 2 | 2 | 1 | 1 | 1 | 2 | 1 | 1 | 2 | 13 |
| C1 | without | 3 | 3 | 3 | 4 | 2 | 3 | 4 | 3 | 3 | 28 |
| 2a | I | 2 | 2 | 1 | 1 | 2 | 1 | 1 | 1 | 1 | 12 |
| 2b | II | 1 | 1 | 1 | 2 | 2 | 1 | 1 | 1 | 1 | 11 |
| C2 | without | 3 | 3 | 2 | 3 | 1 | 4 | 3 | 3 | 3 | 25 |
| 3a | I | 2 | 2 | 1 | 1 | 1 | 1 | 1 | 1 | 1 | 11 |
| 3b | II | 2 | 2 | 1 | 1 | 1 | 2 | 1 | 2 | 1 | 13 |
| C3 | without | 3 | 3 | 3 | 4 | 2 | 4 | 3 | 3 | 3 | 28 |
| 4a | I | 2 | 1 | 1 | 1 | 1 | 1 | 1 | 1 | 1 | 10 |
| 4b | II | 2 | 2 | 2 | 1 | 2 | 1 | 1 | 2 | 1 | 14 |
| C4 | without | 3 | 3 | 2 | 3 | 2 | 4 | 3 | 3 | 3 | 26 |
| 5a | I | 1 | 1 | 1 | 1 | 1 | 1 | 1 | 1 | 1 | 9 |
| 5b | II | 1 | 2 | 1 | 1 | 1 | 1 | 2 | 2 | 1 | 12 |
| C5 | without | 3 | 4 | 2 | 3 | 2 | 3 | 3 | 2 | 3 | 25 |
| 6a | III | 2 | 2 | 1 | 1 | 1 | 1 | 1 | 2 | 1 | 12 |
| 6b | IV | 2 | 1 | 2 | 1 | 1 | 1 | 1 | 2 | 1 | 12 |
| C6 | without | 3 | 3 | 2 | 3 | 2 | 3 | 3 | 3 | 3 | 25 |
| 7a | I | 2 | 1 | 1 | 1 | 1 | 1 | 1 | 1 | 1 | 10 |
| 7b | II | 2 | 2 | 1 | 1 | 1 | 1 | 1 | 2 | 1 | 12 |
| C7 | without | 3 | 3 | 2 | 3 | 2 | 3 | 3 | 3 | 3 | 25 |
| 8a | I | 1 | 1 | 1 | 1 | 1 | 1 | 1 | 1 | 1 | 9 |
| 8b | II | 2 | 1 | 1 | 1 | 1 | 1 | 1 | 2 | 1 | 11 |
| C8 | without | 3 | 3 | 3 | 3 | 2 | 3 | 3 | 3 | 2 | 25 |
| 9a | I | 2 | 1 | 1 | 2 | 1 | 2 | 2 | 2 | 1 | 14 |
| 9b | II | 2 | 2 | 1 | 3 | 1 | 3 | 3 | 3 | 1 | 19 |
| C9 | without | 3 | 3 | 3 | 4 | 2 | 3 | 4 | 4 | 3 | 29 |
| 10a | I | 1 | 1 | 1 | 1 | 1 | 1 | 1 | 1 | 1 | 9 |
| 10b | II | 1 | 1 | 1 | 1 | 2 | 1 | 1 | 1 | 1 | 10 |
| C10 | without | 2 | 1 | 1 | 2 | 2 | 1 | 2 | 2 | 1 | 14 |

MT 1.1 - MT 2.7: Assessment of the coloring of the extraction medium and the polar decoloring agent (see table 4 and 5). The numbers in the column are counted as points in the evaluation. The lower the total number of points (column TOTAL), the higher the overall color stability (see table 6).

**Decoloring of the plastic articles**

The plastic articles produced according to the above exemplary examples 1a and 1b to 10a and 10b and

comparative examples C1 to C10 have been decolored according to the following procedure:
For the decoloring of the plastic article, the plastic article is shredded to a fine granulate having a mean particles size of approximately 2 mm. The granulate is exposed to a decoloring bath. The composition of the decoloring bath is given in table 7. The concentrations in table 7 are given with respect to the volume of the decoloring bath.

When using one of the decoloring baths 1 to 3, the granulate is exposed to the decoloring bath for 60 min at 125 °C. When using the decoloring bath 4 the granulate is exposed to the decoloring bath for 240 min at 125 °C. The ratio of granulate to the amount of decoloring bath is 10g granulates per 250g decoloring bath.

After the above exposure time of the granulate in the decoloring bath and after rapid cooling, the granulates are filtered off with a coarse sieve and thoroughly rinsed with running water and dried at 80 °C for 6h. Again, plastic articles in the form of a plates W x H x T = 30 x 50 x 1 $mm^3$ are produced from the decolorized granulate by injection molding. This also applies to the decolourised granules of samples 9a, 9b and C9 and 10a, 10b, and C10.

After the above decoloring process, the color and the remaining color strength is determined by spectrophotometer (for detailed description of the color strength, see section color stability of plastic article).

The decolorability of the plastic articles was determined by measuring the percentage loss of color strength K/S according to Kubelca-Munk of the colored plates before decoloring comparing this value with the color strength of the plastic articles produced from the decolorized granulates. Color strength according to Kubelca-Munk was measured and calculated by the spectrophotometer Konica-Minolta 3600A at max. adsorbance. The remaining color strength is calculated as follows:

$$reamining\ color\ strength = 1 - \frac{(color\ strength\ before - color\ strength\ after)}{color\ strength\ before}\ in\ \%$$

*(before = before decoloring; after = after decoloring and regranulation)*

According to Kubelka-Munk, there is a linear relationship between the color strength and the color content or concentration in a plastic. Therefore, a remaining color strength in percent after decolorisation corresponds to the remaining coloring agent content or the coloring agent concentration after decolorisation.

Table 7: Composition of decoloring bath 1 to 4

| Nr. | Polar solvents, nonpolar solvents, and levelling agent in water | Reducing agent | Oxidizing agent | Polar decoloring agent | pH, adjusted by |
|---|---|---|---|---|---|
| 1 | 4 mL/L mixture of C9-aromatic hydrocarbons (70%), Benzyl benzoate (20%), Na-alkyl benzenesulfonate (C10-C13) (8%), Isotridecanolethoxylate (2%)<br>100 mL/L caustic soda lye (NaOH) 38 °Bé in water; concentration of NaOH: 1,1 mol/L | 5 g/L formamidine sulfinic acid | | | > 10, adjusted by NaOH, |

(continued)

| Nr. | Polar solvents, nonpolar solvents, and levelling agent in water | Reducing agent | Oxidizing agent | Polar decoloring agent | pH, adjusted by |
|---|---|---|---|---|---|
| 2 | 4 mL/L mixture of C9-aromatic hydrocarbons (70%), Benzyl benzoate (20%), Na-alkyl benzenesulfonate (C10-C13) (8%), Isotridecanolethoxylate (2%)<br>25m/L of n-Butyl acetate and Glycerol triacetate<br>100 mL/L formic acid 85% in water, concentration of formic acid in the water: 2,2 mol/L | 7,5 g/L zinc hydroxymethanesulfinate | | | < 4, adjusted by HCl |
| 3 | 4 mL/L mixture of C9-aromatic hydrocarbons (70%), Benzyl benzoate (20%), Na-alkyl benzenesulfonate (C10-C13) (8%), Isotridecanolethoxylate (2%) | | 10 g/L Peroxidisulfate 10g/L Tetraacetylethylenediamine (TAED) | | > 10, adjusted by NaOH |
| 4 | 4 mL/L mixture of C9-aromatic hydrocarbons (70%), Benzyl benzoate (20%), Na-alkyl benzenesulfonate (C10-C13) (8%), Isotridecanolethoxylate (2%)<br>100 mL/L formic acid 85% in water, concentration of formic acid in the water: 2,2 mol/L | | | 20g/L of poly (amidoamine-co-acrylic acid) copolymer in form of particles having a mean particle size diameter of 1 mm | < 4, adjusted by HCl |

Examples 1a to 10a and 10a to 10b and C1 to C10 were decolorized as described above under the conditions with the following results according to Table 8.

Table 8

| Example | Decoloring Bath | | | | Color values after decolorisation | | | | | | remainin color strength = residual color content |
|---|---|---|---|---|---|---|---|---|---|---|---|
| | 1 | 2 | 3 | 4 | L | a | b | R | G | B | % |
| 1a | X | | | | 87 | -6 | 1 | 206 | 221 | 216 | <5 |
| C1 | X | | | | 87 | -5 | 1 | 208 | 220 | 216 | <5 |
| 1b | | X | | | 80 | -11 | -9 | 165 | 205 | 215 | < 10 |
| C1 | | X | | | 80 | -14 | -8 | 161 | 209 | 214 | < 10 |

(continued)

Table 8

| Example | Decoloring Bath | | | | Color values after decolorisation | | | | | | remainin color strength = residual color content |
|---|---|---|---|---|---|---|---|---|---|---|---|
| 2a | | | | X | 88 | -12 | 58 | 233 | 226 | 108 | < 10 |
| C2 | | | | X | 87 | -14 | 58 | 229 | 224 | 105 | < 10 |
| 2b | | | X | | 91 | -11 | 45 | 238 | 233 | 142 | <5 |
| C2 | | | X | | 90 | -11 | 44 | 233 | 229 | 140 | <5 |
| 3a | X | | | | 86 | 14 | -5 | 247 | 207 | 207 | <5 |
| 3b | X | | | | 85 | 9 | 3 | 234 | 207 | 207 | < 5 |
| C3 | X | | | | 86 | 9 | 5 | 236 | 208 | 205 | <5 |
| 4a | X | | | | 82 | -5 | 7 | 168 | 207 | 216 | < 10 |
| 4b | X | | | | 87 | -8 | -6 | 194 | 222 | 228 | < 10 |
| C4 | X | | | | 81 | -8 | -9 | 175 | 205 | 216 | < 10 |
| 5a | | | X | | 91 | -11 | 45 | 238 | 233 | 142 | <5 |
| 5b | | | X | | 93 | -9 | 35 | 241 | 237 | 165 | <5 |
| C5 | | | X | | 91 | -12 | 40 | 233 | 233 | 151 | <5 |
| 6a | X | | | | 86 | 17 | 6 | 251 | 203 | 203 | <5 |
| 6b | X | | | | 89 | 12 | 5 | 252 | 216 | 216 | <5 |
| C6 | X | | | | 87 | 16 | 4 | 252 | 208 | 212 | <5 |
| 7a | | X | | | 75 | -8 | -14 | 151 | 189 | 209 | < 10 |
| 7b | | X | | | 75 | -9 | -12 | 153 | 190 | 206 | < 10 |
| C7 | | X | | | 75 | -9 | -12 | 153 | 190 | 206 | < 10 |
| 8a | X | | | | 88 | -6 | 0 | 209 | 224 | 220 | < 5 |
| 8b | X | | | | 88 | -7 | 3 | 208 | 224 | 215 | <5 |
| C8 | X | | | | 89 | -6 | 2 | 213 | 227 | 219 | <5 |
| 9a | X | | | | 82 | -16 | -5 | 163 | 212 | 211 | < 10 |
| 9b | X | | | | 81 | -12 | -8 | 167 | 209 | 215 | < 10 |
| C9 | X | | | | 85 | -10 | -6 | 186 | 219 | 224 | < 10 |
| 10a | | X | | | 85 | 0 | -12 | 200 | 213 | 235 | < 10 |
| 10b | | X | | | 86 | 2 | -10 | 210 | 215 | 234 | < 10 |
| C10 | | X | | | 88 | 1 | -7 | 216 | 221 | 234 | < 10 |

As the results clearly show, that also the plastic articles having the barrier coating and thus a high color stability, can easily be decolored by the decoloring bath.

## Claims

1. Method for decoloring a colored plastic article, wherein the plastic article comprises at least two layers,

   wherein a first layer of the at least two layers is an outermost layer and forms a surface of the plastic article;
   wherein a second layer of the at least two layers is a color layer and comprises a plastic material and a coloring agent;

wherein the plastic material comprises at least 0,1 wt.-% of a polar component, based on the weight of the plastic material,
wherein the polar component is a polar polymer, a polar compound and/or a blend of polar polymers and/or polar compounds,
wherein the polar polymer has a molecular weight Mw ≥ 1000 g/mol and has at least 5 wt.-% of heteroatoms based on the molecular weight of the polar polymer,
wherein the polar compound has a molecular weight Mw ≤ 1000 g/mol and has at least 5 wt.-% of heteroatoms based on the molecular weight of the polar compound,
and wherein heteroatoms are any atoms except C and H atoms;
wherein the coloring agent comprises an organic molecule with a molecular weight Mw ≤ 800 g/mol;
wherein the outermost layer comprises a crosslinked silicon compound, wherein the crosslinked silicon compound comprises at least two silicon atoms bridged by an oxygen atom;
the method comprising the steps of

a) shredding the colored plastic article to a granulate and/or a powder,
b) exposing the granulate and/or powder to a decoloring bath for about ≥ 1 minute to about ≤ 240 minutes, wherein the decoloring bath has a temperature above a glass transition temperature $T_g$ of the colored plastic article and below a melting temperature $T_m$ and/or decomposition temperature of the colored plastic article and/or has a temperature ≥ 60 °C to ≤ 130 °C,

wherein the decoloring bath comprises

- water,
- at least one polar solvent and/or at least one non-polar solvent, and
- an oxidizing agent or a reducing agent and/or a polar decoloring agent,

wherein the decoloring bath has a pH about ≥ 8, and wherein the pH of the decoloring bath is adjusted by adding a base, preferably NaOH, or
wherein the decoloring bath has a pH about ≤ 6, and wherein the pH of the decoloring bath is adjusted by adding an acid, preferably HCl.

**2.** The method according to claim 1, wherein the outermost layer is an inorganic layer, is carbon free, does not comprise carbon-hydrogen bonds, and/or the crosslinked silicon compound is not an organic compound.

**3.** The method according to claim 1 or 2, wherein the outermost layer and/or the crosslinked silicon compound is described by the chemical formula $SiO_x$, with x being higher than 1, more preferably with x being higher than 1,2, even more preferably with x being higher than 2.

**4.** The method according to claim 1, wherein the outermost layer and/or the crosslinked silicon compound comprises carbon-hydrogen bonds and/or Si-C bonds and/or a C fraction of the outermost layer and/or the crosslinked silicon compound is below 10 at.%, more preferably below 5 at.%, even more preferably below 0,5 at.%, and/or the outermost layer and/or the crosslinked silicon compound is described by the chemical formula $SiO_xC_y$ and the C fraction of the outermost layer and/or the crosslinked silicon compound is below 10 at.%, more preferably below 5 at.%, even more preferably below 0,5 at.%.

**5.** The method according to any of the previous claims, wherein the color layer directly contacts the outermost layer.

**6.** The method according to any of the previous claims, wherein the outermost layer has a thickness between 0,001 µm to 1,0 µm and/or wherein the color layer has a thickness between 1 µm to 500 µm.

**7.** The method according to any of the previous claims, wherein the outermost layer is obtained by

a) depositing the outermost layer by a plasma enhanced chemical vapor deposition process using an outermost layer precursor as silicon source on the color layer; or
b) depositing a middle layer by a plasma enhanced chemical vapor deposition process using a middle layer precursor as silicon and carbon source on the color layer and subsequently depositing the outermost layer by a plasma enhanced chemical vapor deposition process and/or plasma enhanced atomic layer deposition using an outermost layer precursor as silicon source on the middle layer; or

c) depositing the outermost layer by a plasma enhanced atomic layer deposition process using a middle layer precursor as silicon and carbon source and/or an outermost layer precursor as silicon source.

**8.** The method according to the previous claim, wherein the outermost layer is obtained by the plasma enhanced chemical vapor deposition process and comprises a pretreatment plasma process step of a surface of the color layer by an argon or oxygen discharge prior to steps a) or b).

**9.** The method according to claim 7, wherein the outermost layer is obtained by the plasma enhanced atomic layer deposition process by

a) feeding the middle layer precursor as silicon and carbon source into a vacuum chamber for chemisorption on the color layer and/or feeding the outermost layer precursor as silicon source into a vacuum chamber for chemisorption on the color layer,
b) feeding an inert gas, such as argon, into the vacuum chamber for removal of residual middle layer precursor,
c) feeding a co-reactant, preferably oxygen, into the chamber accompanied with the ignition of a plasma,
d) feeding a further inert gas into the vacuum chamber for purging, and
e) repeating steps a) to d) consecutively, preferably until a desired thickness of the outermost layer is achieved.

**10.** The method according to any of claims 7 to 9, wherein the middle layer and/or the outermost layer are obtained by a microwave driven low pressure plasma.

**11.** The method according to any of claims 7 to 10, wherein the middle layer precursor is selected from the group comprising hexamethyldisiloxane (HMDSO), hexamethyldisilazane (HMDSN), silicon tetrahydride, trimethylsilane, tetramethylsilane, di(sec-butylamino)silane (DSBAS), bis(dimethylamino-methylsilyl)-trimethylsilylamine (DTDN2-H2), 1,3-di-isopropylamino-2,4-dimethyl-cyclosilazane (CSN-2), bis(t-butylamino)silane (BTBAS), di-s-butylaminosilane (DSBAS), 1,3-di-isopropylamino-2,4-dimethyl-cyclosilazane (CS-2), tetraethyl orthosilicate, and mixtures thereof and/or

the middle layer precursor is a mixture comprising a carbon source and a silicon source, wherein the carbon source is selected from the group comprising hydrocarbons, in particular unsaturated hydrocarbons such as ethine, and
wherein the silicon source is selected from the group comprising silicon tetrahydride, dichlorosilane, pentachlorodisilane, hexachlorodisilane (HCDS), trisilylamine, hexamethyldisiloxane (HMDSO), hexamethyldisilazane (HMDSN), tertrahydrosilane, trimethylsilane, tetramethylsilane, di(sec-butylamino)silane (DSBAS), bis(dimethylamino-methylsilyl)-trimethylsilylamine (DTDN2-H2), 1,3-di-isopropylamino-2,4-dimethyl-cyclosilazane (CSN-2), bis(t-butylamino) silane (BTBAS), di-s-butylaminosilane (DSBAS), 1,3-di-isopropylamino-2,4-dimethyl-cyclosilazane (CS-2), tetraethyl orthosilicate, silicon-hydrogen compounds, and mixtures thereof.

**12.** The method according to any of claims 7 to 11, wherein the outermost layer is obtained by the plasma enhanced chemical vapor deposition process and wherein the middle layer precursor is deposited in the absence of oxygen.

**13.** The method according to any of claims 7 to 12, wherein the outermost layer precursor is selected from the group comprising silicon tetrahydride, dichlorosilane, pentachlorodisilane, hexachlorodisilane (HCDS), trisilylamine, hexamethyldisiloxane (HMDSO), hexamethyldisilazane (HMDSN), tertrahydrosilane, trimethylsilane, tetramethylsilane, di(sec-butylamino)silane (DSBAS), bis(dimethylamino-methylsilyl)-trimethylsilylamine (DTDN2-H2), 1,3-di-isopropylamino-2,4-dimethyl-cyclosilazane (CSN-2), bis(t-butylamino) silane (BTBAS), di-s-butylaminosilane (DSBAS), 1,3-di-isopropylamino-2,4-dimethyl-cyclosilazane (CS-2), tetraethyl orthosilicate, silicon-hydrogen compounds, and mixtures thereof.

**14.** The method according to any of claims 7 to 13, wherein the outermost layer is obtained by the plasma enhanced chemical vapor deposition process and wherein the outermost layer precursor is deposited in the presence of oxygen.

**15.** The method according to the previous claim, wherein a flux-ratio of oxygen to the outermost layer precursor during deposition is in between 10 and 1000, preferably in between 50 and 500, more preferably in between 200 and 250.

**16.** The method according to any of the previous claims, wherein the plastic material comprises less than 16 wt.-%, preferably less than 10 wt.-% , even more preferably less than 5 wt.-% of the polar compound, based on the weight of the plastic material.

**17.** The method according to any of the previous claims, wherein the polar polymer comprises an amorphous phase of at least about ≥ 10 vol.-%, preferably about ≥ 30 vol.-%, more preferably about ≥ 50 vol.-% and about ≤ 100 vol.-%, wherein the volume % is calculated on the total volume of the synthetic polar polymer.

**18.** The method according to any of the previous claims, wherein the plastic material comprises a water-soluble and/or water-swellable component in an amount of ≥ 0,01 wt% to ≤ 10 wt%, based on the weight of the plastic material.

**19.** The method according to the previous claim, wherein the water-soluble or water-swellable component is a water-soluble polymer, a water-swellable compound, a disintegrating agent, or a mixture thereof, wherein

- the water-soluble polymer has a molecular weight Mw ≥ 1000 g/mol, wherein the water-soluble polymer has a weight loss of more than 2 wt% when stored in water at 23 °C for 24 hours or when emerged in boiling water for 30 min; and/or the water-soluble polymer has a molecular weight Mw ≥ 1000 g/mol and is selected from the group comprising polyelectrolytes, non-ionic homopolymers, hydrophobic-associating polymers, and water soluble polysiloxanes;
- the water-swellable compound is an inorganic compound or is a polymer having a molecular weight Mw ≥ 1000 g/mol and wherein the water swellable compound has a swelling capacity of ≥ 25 wt%, according to ASTM D570 and/or ISO 62; and/or the water-swellable compound is selected from the group comprising bentonite, preferably montmorillonite; cross-linked poly acrylamide and its copolymers, starch, cellulose, cellulose derivatives, crosscarmellose, sodium croscarmellose, crospovidone, sodium starch glycolate, alginic acids, dextrans and cross-linked polyvinylpyrrolidones, cross-linked poly(vinyl alcohol) and copolymers, cross-linked polyethylene oxide and starch grafted copolymer of polyacrylonitrile;
- the disintegrating agent has a molecular weight Mw≥ 1000 g/mol, wherein the disintegrating agent has a weight loss of more than 2 wt% when stored in water having a pH ≥ 10 or a pH ≤ 4 for 24 hours at 80°C; and/or the disintegrating agent is selected from the group comprising poly glycolide, polylactide, poly hydroxy propionate, poly hydroxy butyrate, poly ε-caprolactone, glycolized or amorphous aliphatic-aromatic polyesters, glycolized or amorphous polyethylene terephthalate (PET-G or A-PET), polytrimethylenterephthalte (PTT), polybutylenterephthalate (PBT), poly acrylate-acrylic acid copolymers soluble at a pH ≥ 10, and blends of poly acrylate-acrylic acid copolymers with poly ethylene acrylic acids soluble at a pH ≥ 10.

**20.** The method according to any of the previous claims, wherein the colored plastic article is selected from the group comprising a sheet, a foil, a container, a part, a tube, a profile, a nonwoven fabric, and preferably the article is selected from the group comprising rigid packaging such as bottles, jars, caps and closures, color coded packaging and containers of all types, including ones for industrial components, computer face-plates, keyboards, bezels and cellular phones, residential and commercial lighting fixtures and components therefor, such as sheets, used in building and in construction, tableware, including plates, cups and eating utensils, small appliances and their components, optical and sun-wear lenses.

**21.** The method according to any of the previous claims, wherein the colored plastic article is a container, wherein the container comprises a body defining an interior chamber and at least one wall, wherein the wall comprises at least the outermost layer and the color layer, and wherein the outermost layer is arranged such that it faces the interior chamber of the container.

**22.** Method according to any of the previous claims, wherein the colored plastic article is shredded to a granulate and/or powder having a mean particle size of 0,1 mm to 20 mm.

**23.** Method according to any of the previous claims, wherein a weight ratio of the granulate and/or powder to the decoloring bath is 1:2 to 1:50 (granulate and/or powder : decoloring bath).

**24.** The method according to any of the previous claims, wherein the decoloring bath comprises the polar solvent, and/or wherein the polar solvent is liquid at about 23 °C and/or is selected from the group comprising $C_1$ to $C_{15}$ - alcohol, preferably ethanol, isopropanol, propanol, butanol, pentanol, hexanol, heptanol, octanol, nonanol, decanol, undecanol, dodecanol, tridecanol, tetradecanol, pentadecanol and its isomeres, glycols, glycols such as diethylene glycol and its oligomers, further C3 to C15 diols such as propanediol, butanediol or pentanediol or triols such as glycerol, more preferred $C_3$ to $C_{15}$ - alcohols, and furthermore preferred $C_9$ to $C_{12}$ - alcohols.

**25.** The method according to any of the previous claims, wherein the decoloring bath comprises the nonpolar solvent, and/or wherein the nonpolar solvent is liquid at about 23 °C and/or is selected from the group comprising straight,

branched, saturated, unsaturated, and/or cyclic aliphatic $C_1$ to $C_{12}$ hydrocarbons, aromatic hydrocarbons; wherein the aromatic hydrocarbon is preferably selected from $C_1$ to $C_5$ - alkyl substituted benzene, $C_2$ - alkyl substituted benzene, Xylol, $C_3$ - alkyl substituted benzene, 1,3,5-trimethylbenzene, 1-ethyl-4-methylbenzene, prop-1-en-2-ylbenzene, propan-2-ylbenzene, propyl benzene, and more preferred $C_3$ -alkyl substituted benzene.

**26.** The method according to any of the previous claims, wherein the decoloring bath further comprises an aromatic ester, wherein the aromatic ester is selected from the group comprising benzoic acid benzyl esters, naphthalic acid benzyl esters, phthalic acid benzyl esters and/or isophthalic acid benzyl esters, mixed aromatic aliphatic esters comprising benzyl butyl phthalates, and aliphatic esters comprising benzoic acid butyl esters, phthalic acid dibutyl esters, and/or isophthalic acid dibutyl esters; and preferably benzoic acid benzyl ester, benzoic acid esters such as benzyl benzoate, alkyl benzoates such as methyl or ethyl benzoate, naphthalic acid esters, phthalic acid esters.

**27.** The method according to any of the previous claims, wherein the decoloring bath comprises in addition at least one surfactant, selected from non-ionic and/or anionic surfactant,

- wherein the non-ionic surfactant is preferably selected from the group of aromatic esters and hydrocarbons, aromatic and non-aromatic carboxylic acid esters, ethyl acrylate, fatty acid esters, alkoxylated, preferably ethoxylated or ethoxylated and propoxylated fatty acid esters, alkoxylated, preferably ethoxylated or ethoxylated and propoxylated fatty acids, poly oxyethylated compounds derived from sorbitol and oleic acid, polysorbate 20, polysorbate 40, polysorbate 60, polysorbate 65, polysorbate 80, polymers that are fatty acid-based with a non-ionic group per molecule, acrylate-copolymers, acrylate/styrene copolymers, fatty acid derivatives, polyalkoxylate, and preferably 2-(2-butoxy-ethoxy)ethanol and in particular preferred isotridecanolethoxylate;
- wherein the anionic surfactant is preferably selected form the group comprising alkaline salts of a sulfonic acid, wherein the sulfonic acid is preferably selected form the group comprising alkyl benzenesulfonic acid, alkyl naphtalenesulfonic acid, alkyl phthalic sulfonic acid, isophthalic sulfonic acid benzyl, and a $C_9$-$C_{13}$-alkyl benzenesulfonic acid.

**28.** The method according to any of the previous claims, wherein the decoloring bath comprises in addition at least one solvent additive selected from the group of organic acids, preferably sulfonic acid, $C_3$ to $C_6$ - ketone, preferably acetone, $C_2$ to $C_6$ - aldehyde, $C_1$ to $C_6$ - carboxylic acid and their derivatives such as formic acid, acid chlorides or acid amides; non-aromatic carboxylic acid esters, such as acetyltributylcitrate (ATBC), polar aromatic solvents liquid at 23 °C, phenoles, aromatic alcohols, aromatic ketones, N-alkylphthalimide, methylnaphthalene, diphenyle, oxybiphenyle DMSO, DMF, benzylic alcohols, linear or cyclic ethers, diethyl ether, diiso propyl ether, dibutyl ether, diphenylether, naphtholether, tetrahydrofuran; polyphenylether, aliphatic esters, such as methyl acetate, ethyl acetate, butyl acetate, glycerol triacetate, halogenated solvents such as dichloromethane, trichloromethane, benzyl chloride, aryl halides, such as halogenized benzene, halogenzide toluene; oils like anise oil, camphor oil, essential oils and fragrance oils, spindle oil, cedarwood oil, cinnamon oil, citronella oil, peppermint oil, pine oil, lemon oil, fuel oil, mineral oil, polyester resins and polyester softeners.

**29.** Method according to any of the previous claims, wherein the decoloring bath comprises the polar decoloring agent and/or wherein the polar decoloring agent is selected from the group comprising

- at least one polar polymer having a Mw of about ≥ 1000 g/mol, and/or
- at least one polar compound having a Mw of about ≤ 1000 g/mol,

wherein the polar-polymer comprises at least ≥ 5 wt.-% of heteroatoms, based on the weights of the polar-polymer, and wherein the polar compound comprises at least ≥ 5 wt.-% of heteroatoms, based on the weight of the polar compound,
wherein heteroatoms are any atom excluding C-atoms and H-atoms.

**30.** Method according to any of the previous claims, wherein the decoloring bath comprises the polar decoloring agent and wherein the decoloring bath contains 0.1 to 100 g/L polar decoloring agent, preferably 1 to 50 g/L, more preferably 5 to 25 g/L with respect to the volume of the decoloring bath.

**31.** Method according to any of the previous claims, wherein the decoloring bath comprises the polar decoloring agent and has a pH about ≤ 6 and wherein the pH of the decoloring bath is adjusted by adding an acid, preferably HCl.

**32.** Method according to any of the previous claims, wherein the decoloring bath comprises the oxidizing agent and/or

wherein the oxidizing agent is selected from the group comprising a peroxide, peroxyacetic acid, hydrogen peroxide, peroxodisulfate, ozone, sodium percarbonate, sodium perborate, sodium percarbonate, m-nitrobenzolsulfonat, $H_2SO_4$, $HNO_3$, oxygen-containing anions (oxo anions) of transition metals in high oxidation states such as permanganate $MnO_4^-$, $KMnO_4$, phosphate, oxygen difluoride fluorine, cryptone difluoride, dichromate $Cr_2O_7^{2-}$, metal ions such as $Ce_4^+$, noble metal ions such as those of silver and copper, anions of halo-oxygen acids such bromate $BrO_3^-$ , halogens, such as fluorine, chlorine, bromine and iodine, hypochlorite, sodium hypochlorite, sodium peroxodisulfate and/or potassium hypochlorite.

**33.** Method according to any of the previous claims, wherein the decoloring bath comprises the reducing agent and/or wherein the reducing agent is selected from the group comprising

- hydrogen in combination with precious metal catalyst, preferably H2/Ni, H2/Pd, H2/Pt, hydrides;
- complex hydrides, preferably sodium hydride NaH, lithium aluminum hydride LiAlH4, borohydride salts NaBH4;
- base metals, preferably Li, Na, Mg, Zn; low-valent nitrogen;
- phosphorus and sulphur compounds, preferably amidine sulfonic acid, formamidine sulphinic acid, hydrogen sulfide, sodium sulfide, S2-, Na2S, sulfites, SO2-3, sodium sulfite, sulfurous acid, sulfur dioxide, thiosulphate, sodium dithionite, sodium bisulfite, NaHSO3, formamidine sulfonic acid, zinc hydroxylmethansulfinate, sodium hydroxy methane sulfinate also known as rongalite, thiourea dioxide also known as thiox, sulfonic acid and its derivatives, borohydride salts, sodium hydroxide, sodium carbonate, sodium bicarbonate, sodium oxide, and mixtures of sodium hydroxide and calcium oxide, sulfinic acid derivatives, borohydrides and/or REDULIT GIN;
- sulfinic acid and sulfinic acid derivates, preferably aminoimino methansulfinsaure;
- glucose mixtures with dispersants; and
- formamidine sulphinic acid and zinc hydroxymethanesulfinate.

Europäisches Patentamt
European Patent Office
Office européen des brevets

# EUROPEAN SEARCH REPORT

Application Number
EP 21 20 1355

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>Y | WO 2021/013842 A1 (SMART COLORING GMBH [DE]) 28 January 2021 (2021-01-28)<br>* abstract *<br>* first sentence;<br>page 1 *<br>* first paragraph;<br>page 2 *<br>* page 49 - page 66; examples 1-28 *<br>* page 66 - page 80; examples 29-56 *<br>* claims 1-28 *<br>----- | 1<br>1-33 | INV.<br>C08J7/04<br>B29C48/00<br>C08J7/048<br>C08J11/06<br>C08L23/06<br>D06P1/90<br>C23C14/00<br>C23C16/22 |
| Y | FEI FEI ET AL: "The Application of Nano-SiOCoatings as Migration Resistance Layer by Plasma Enhanced Chemical Vapor Deposition",<br>PLASMA CHEMISTRY AND PLASMA PROCESSING, KLUWER ACADEMIC PUBLISHERS-PLENUM PUBLISHERS, NE,<br>vol. 32, no. 4, 11 April 2012 (2012-04-11), pages 755-766, XP035076797,<br>ISSN: 1572-8986, DOI: 10.1007/S11090-012-9370-3<br>* abstract *<br>* Conclusion;<br>page 764 - page 765 *<br>-----<br>-/-- | 1-33 | TECHNICAL FIELDS SEARCHED (IPC)<br>C08J<br>C09J<br>D06Q<br>B29C<br>C08L<br>D06P<br>C23C<br>B05D |

The present search report has been drawn up for all claims

1

| Place of search | Date of completion of the search | Examiner |
|---|---|---|
| Munich | 21 March 2022 | Schlembach, Sandra |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

page 1 of 2

Europäisches Patentamt
European Patent Office
Office européen des brevets

# EUROPEAN SEARCH REPORT

Application Number
EP 21 20 1355

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | Grüner Punkt Der: "Design 4 Recycling-Designing plastic packaging so it can be recycled", , 1 September 2019 (2019-09-01), pages 1-13, XP055903348, Retrieved from the Internet: URL:https://www.gruener-punkt.de/fileadmin/Dateien/Downloads/PDFs/1909_D4R_Guide_EN.pdf [retrieved on 2022-03-21] * page 7 * * page 9 * ----- | 1-33 | |
| A | US 3 663 262 A (COGAN JERRY A JR) 16 May 1972 (1972-05-16) * the whole document * ----- | 1-33 | |

TECHNICAL FIELDS SEARCHED (IPC)

The present search report has been drawn up for all claims

1

| Place of search | Date of completion of the search | Examiner |
|---|---|---|
| Munich | 21 March 2022 | Schlembach, Sandra |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
.......................................................................................................
& : member of the same patent family, corresponding document

EPO FORM 1503 03.82 (P04C01)

# ANNEX TO THE EUROPEAN SEARCH REPORT ON EUROPEAN PATENT APPLICATION NO. EP 21 20 1355

This annex lists the patent family members relating to the patent documents cited in the above-mentioned European search report.
The members are as contained in the European Patent Office EDP file on
The European Patent Office is in no way liable for these particulars which are merely given for the purpose of information.

21-03-2022

| Patent document cited in search report | Publication date | Patent family member(s) | Publication date |
|---|---|---|---|
| WO 2021013842 A1 | 28-01-2021 | WO 2021013842 A1 | 28-01-2021 |
| | | WO 2021013849 A1 | 28-01-2021 |
| US 3663262 A | 16-05-1972 | NONE | |

EPO FORM P0459

For more details about this annex : see Official Journal of the European Patent Office, No. 12/82